# EUROPÄISCHE PATENTSCHRIFT

(11) **EP 3 100 467 B1**
(45) Veröffentlichungstag und Bekanntmachung des Hinweises auf die Patenterteilung: **18.09.2019**
(21) Anmeldenummer: 15759755.0
(22) Anmeldetag: 03.09.2015
(51) Int. Cl.: H04R 17/00, H04R 29/00, H04R 3/00

(54) **MEMS MIT MIKROMECHANISCHEN PIEZOELEKTRISCHEN AKTUATOREN ZUR REALISIERUNG HOHER KRÄFTE UND AUSLENKUNGEN**
MEMS HAVING MICROMECHANICAL PIEZOELECTRIC ACTUATORS FOR REALIZING HIGH FORCES AND DEFLECTIONS
MEMS COMPRENANT DES ACTIONNEURS PIÉZOÉLECTRIQUES MICROMÉCANIQUES POUR OBTENIR DES FORCES ET DES DÉFLEXIONS ÉLEVÉES

(30) Priorität: 05.09.2014 DE 102014217798
(43) Veröffentlichungstag der Anmeldung: 07.12.2016
(73) Patentinhaber: Fraunhofer-Gesellschaft zur Förderung der angewandten Forschung e.V., 80686 München (DE)
(72) Erfinder: STOPPEL, Fabian, 25524 Itzehoe (DE); WAGNER, Bernhard, 25582 Looft (DE)
(74) Vertreter: Zimmermann, Tankred Klaus
(86) Internationale Anmeldenummer: PCT/EP2015/070124
(87) Internationale Veröffentlichungsnummer: WO 2016/034665

(56) Entgegenhaltungen:
- JP-A- S59 139 799
- US-A1- 2011 051 985
- US-A1- 2014 177 881

## Beschreibung

Ausführungsbeispiele der vorliegenden Erfindung beziehen sich auf ein MEMS (microelektromechanical system, dt Mikrosystem). Manche Ausführungsbeispiele beziehen sich auf mikromechanische piezoelektrische Aktuatoren zur Realisierung hoher Kräfte und Auslenkungen. Weitere Ausführungsbeispielen betreffen einen MEMS-Lautsprecher zum Erzeugen von Schallwellen im hörbaren Wellenlängenspektrum. Weitere Ausführungsbeispiele beziehen sich auf ein System oder eine Regelungseinheit zum geregelten Betreiben eines MEMS-Lautsprechers.

In den vergangenen Jahren haben miniaturisierte Aktuatoren stetig an Bedeutung gewonnen und sind aus vielen Anwendungsfeldern nicht mehr wegzudenken. Durch die Verwendung von geeigneten Designs sowie Antriebsprinzipien (elektrostatisch, elektromagnetisch, thermoelektrisch, piezoelektrisch), lassen sich Aktuatoren mit sehr unterschiedlichen Eigenschaften realisieren, die eine breite Palette an Anwendungen abdecken.

Ein grundlegendes Problem besteht jedoch in der Generierung von hohen Kräften bei hohen Auslenkungen, einer Eigenschaft die insbesondere im Bereich der Fluidverdrängung und MEMS-Lautsprechern essenziell ist. Die Ursache hierfür ist, dass Aktuatoren mit großen Auslenkungen niedrige Federsteifigkeiten erfordern, während für die Übertragung von hohen Kräften eher hohe Federsteifigkeiten notwendig sind. Eine Ausnahme bilden lediglich elektrodynamische Antriebe, welche bedingt durch die Tatsache, dass die Kraft über das magnetische Feld generiert wird, auch bei geringen Federkonstanten vergleichsweise hohe Kräfte und Hübe generieren können.

Insbesondere in der Akustik basiert der Großteil aller Bauelemente daher auf elektrodynamischen Antrieben. Ein klassisches Beispiel stellen in Feinwerktechnik gefertigte Lautsprecher für Mobiltelefone dar, bei denen mittels einer sich in einem permanenten Magnetfeld bewegenden Tauchspule ausreichend hohe Hübe und Kräfte zur Luftverdrängung erzeugt werden.

Nachteile dieser konventionellen elektrodynamischen Lautsprecher sind der hohe Leistungsverbrauch von ca. 1 Watt aufgrund der geringen Effizienz sowie hohe akustische Verzerrungen. Ein weiterer Nachteil ist die relativ große Bauhöhe von 3-4 mm.

Mit MEMS-Technologie könnten diese Nachteile (geringe Effizienz, große Bauhöhe) überwunden werden. Allerdings gibt es keine MEMS-Lautsprecher auf dem Markt, sondern nur eine Reihe von Publikationen aus Forschungslaboren. In der US 2013/0156253 A1 und in der Literatur [Shahosseini et al., Optimization and Microfabrication of High Performance Silicon-Based MEMS Microspeaker, IEEE Sensors journal, 13 (2013)273-284] wird ein elektrodynamischer MEMS-Lautsprecher beschrieben, der allerdings die hybride Integration eines Permanentmagnetrings erfordert. Das Konzept von piezoelektrischen MEMS-Lautsprechern wurde in der US 7,003,125, der US 8,280,079, der US 2013/0294636 A1 und in der Literatur [Yi et al., Performance of packaged piezoelectric microspeakers depending on the material properties, Proc. MEMS 2009, 765-768] und [Dejaeger et al., Development and Characterization of a Piezoelectrically Actuated MEMS Digital Loudspeaker, Procedia Engineering 47 (2012) 184 - 187] dargestellt. Dabei wurden allerdings die piezoelektrische Materialien wie PZT, AIN oder ZnO direkt auf die Lautsprechermembran aufgebracht, so dass die Eigenschaften des Antriebs und der Membran gekoppelt sind. Ein weiterer piezoelektrischer MEMS-Lautsprecher mit einem plattenförmigen Körper, der über eine Membran oder mehrere Aktuatoren kolbenförmig aus der Ebene ausgelenkt wird, ist in der US 2011/0051985 A1 dargestellt. Digitale MEMS-Lautsprecher auf Basis von Arrays mit elektrostatisch angetriebenen Membranen, die allerdings nur bei hohen Frequenzen ausreichend hohe Schalldrücke erzeugen können, werden in der US 7,089,069, der US 2010/0316242 A1 und in der Literatur [Glacer et al., Reversible acoustical transducers in MEMS technology, Proc. DTIP 2013] beschrieben.

Die US 2011/051985 A1 offenbart einen piezoelektrischen Mikrolautsprecher mit einer Kolbenmembran. Der piezoelektrische Mikrolautsprecher enthält ein Substrat mit einem darin ausgebildeten Hohlraum, eine vibrierende Membran, die auf dem Substrat angeordnet ist und mindestens einen zentralen Teil des Hohlraums bedeckt, ein piezoelektrisches Stellglied, das auf der vibrierenden Membran angeordnet ist, um die vibrierende Membran in Schwingung zu versetzen, und eine Kolbenmembran, die in dem Hohlraum angeordnet ist und eine Kolbenbewegung durch Vibration der vibrierenden Membran ausführt.

Die JP S59 139799 A offenbart einen piezoelektrischen Mikrolautsprecher mit einer quadratischen Membran, und vier Aktuatoren, die jeweils über ein Verbindungselement mit der quadratischen Membran verbunden sind.

Die US 2014/177881 A1 offenbart eine Membranvorrichtung mit einem Träger, einer Membran, die an dem Träger aufgehängt ist, einem mit der Membran in Kontakt stehenden ersten Aktuator zum Aufbringen einer Kraft auf die Membran, einem mit der Membran in Kontakt stehenden zweiten Aktuator zum Aufbringen einer Kraft auf die Membran, Mittel zum Bestimmen der Position der Membran bezüglich dem Träger und Steuerungsmitteln für den ersten und zweiten Aktuator.

Der vorliegenden Erfindung liegt die Aufgabe zugrunde, ein Konzept zu schaffen, welches gleichzeitig die Realisierung hoher Kräfte und Auslenkungen in MEMS ermöglicht.

Diese Aufgabe wird durch die unabhängigen Patentansprüche gelöst.

Vorteilhafte Weiterbildungen finden sich in den abhängigen Patentansprüchen.

Ausführungsbeispiele der vorliegenden Erfindung schaffen ein MEMS mit einer Membran, einer Hubstruktur, die mit der Membran gekoppelt ist, und zumindest zwei piezoelektrischen Aktuatoren, die über eine Mehrzahl von voneinander beabstandeten Verbindungselementen mit einer Mehrzahl von voneinander beabstandeten Kontaktpunkten der Hubstruktur verbunden sind, wobei die zumindest zwei piezoelektrischen Aktuatoren ausgebildet sind, um eine Hubbewegung der Hubstruktur hervorzurufen, um die Membran auszulenken.

Gemäß dem Konzept der vorliegenden Erfindung weist das MEMS (Mikrosystem) zur Anregung einer Membran einen Hubkörper und zumindest zwei piezoelektrische Aktuatoren auf, wobei die zumindest zwei Aktuatoren über eine Mehrzahl voneinander beabstandeten Verbindungselementen mit einer Mehrzahl von voneinander beabstandeten Kontaktpunkten der Hubstruktur verbunden sind. Dadurch, dass das MEMS zumindest zwei piezoelektrische Aktuatoren aufweist, die über eine Mehrzahl von Verbindungselementen mit der Hubstruktur verbunden sind, ist es möglich, gleichzeitig hohe Kräfte und Auslenkungen über die Hubstruktur auf die Membran zu übertragen. Dadurch, dass die Mehrzahl von Verbindungselementen und damit auch die Mehrzahl von Kontaktpunkten voneinander beabstandet sind, kann sichergestellt bzw. gewährleitstet werden, dass die Hubstruktur die Hubbewegung reproduzierbar und gleichmäßig ausübt und beispielsweise nicht von einer gewünschten Richtung der Hubbewegung abweicht, wie dies beispielsweise bei einem Auftreten von Kippmoden der Fall wäre.

Weitere Ausführungsbeispiele beziehen sich auf einen MEMS-Lautsprecher mit einer Membran, einer Hubstruktur, die mit der Membran gekoppelt ist, und zumindest zwei piezoelektrischen Aktuatoren, die über eine Mehrzahl von voneinander beabstandeten Verbindungselementen mit einer Mehrzahl von voneinander beabstandeten Kontaktpunkten der Hubstruktur verbunden sind, wobei die zumindest zwei piezoelektrischen Aktuatoren ausgebildet sind, um eine Hubbewegung der Hubstruktur hervorzurufen, um die Membran auszulenken. Die Verbindungselemente sind flexibel ausgebildet. Sie können sich somit reversibel verformen.

Gemäß der vorangegangenen Beschreibung weist die Hubstruktur somit mehrere Kontaktpunkte auf. Diese sind voneinander, insbesondere in Quer- und/oder Längsrichtung des Aktuators, beabstandet. In diesen Kontaktpunkten ist jeweils ein Verbindungselement befestigt, das den jeweils zugeordneten Aktuator flexibel bzw. elastisch mit der Hubstruktur verbindet.

Gemäß dem Konzept der vorliegenden Erfindung weist der MEMS-Lautsprecher (Mikrosystem) zur Anregung einer Membran einen Hubkörper und zumindest zwei piezoelektrische Aktuatoren auf, wobei die zumindest zwei Aktuatoren über eine Mehrzahl voneinander beabstandeten Verbindungselementen mit einer Mehrzahl von voneinander beabstandeten Kontaktpunkten der Hubstruktur verbunden sind. Dadurch, dass der MEMS-Lautsprecher zumindest zwei piezoelektrische Aktuatoren aufweist, die über eine Mehrzahl von Verbindungselementen mit der Hubstruktur verbunden sind, ist es möglich, gleichzeitig hohe Kräfte und Auslenkungen über die Hubstruktur auf die Membran zu übertragen. Dadurch, dass die Mehrzahl von Verbindungselementen und damit auch die Mehrzahl von Kontaktpunkten voneinander beabstandet sind, kann sichergestellt bzw. gewährleitstet werden, dass die Hubstruktur die Hubbewegung reproduzierbar und gleichmäßig ausübt und beispielsweise nicht von einer gewünschten Richtung der Hubbewegung abweicht, wie dies beispielsweise bei einem Auftreten von Kippmoden der Fall wäre.

Vorgeschlagen wird demnach ein MEMS-Lautsprecher zum Erzeugen von Schallwellen im hörbaren Wellenlängenspektrum mit einer Membran, einer Hubstruktur, die mit der Membran gekoppelt ist, und zumindest zwei piezoelektrischen Aktuatoren, mittels denen zum Auslenken der Membran eine Hubbewegung der Hubstruktur hervorrufbar ist. Die piezoelektrischen Aktuatoren sind über eine Mehrzahl von voneinander beabstandeten und flexiblen Verbindungselementen mit einer Mehrzahl von voneinander beabstandeten Kontaktpunkten der Hubstruktur verbunden.

Vorteilhaft ist es, wenn die einem der beiden Aktuatoren zugeordneten Verbindungselemente voneinander in Querrichtung des Aktuators und/oder des MEMS-Schallwandlers voneinander beabstandet sind.

Vorteilhaft ist es, wenn die Membran an einer Stirnseite der Hubstruktur unmittelbar und/oder die piezoelektrischen Aktuatoren an zumindest einer Seitenfläche der Hubstruktur, insbesondere an zwei gegenüberliegenden Seitenflächen, mittelbar, nämlich über die Verbindungselemente, mit der Hubstruktur verbunden sind. In einer Querschnittsansicht des MEMS-Lautsprechers ist demnach die Stirnseite der Hubstruktur in z-Richtung, d.h. in Hubrichtung, orientiert. Die Seitenflächen der Hubstruktur sind im Gegensatz dazu in Querrichtung, d.h. lotrecht zur Hubachse, ausgerichtet.

In einer vorteilhaften Weiterbildung der Erfindung sind mehrere voneinander beabstandete Verbindungselemente mit mehreren voneinander beabstandeten Kontaktpunkten der zumindest zwei piezoelektrischen Aktuatoren verbunden.

Auch ist es vorteilhaft, wenn jeder der zumindest zwei piezoelektrischen Aktuatoren über zumindest zwei voneinander beabstandete Verbindungselemente mit zumindest zwei voneinander beabstandeten Kontaktpunkten der Hubstruktur verbunden ist.

Ferner ist es vorteilhaft, wenn die Hubstruktur mit der Membran über eine Mehrzahl von Bereichen - d.h. in mehreren Bereichen - gekoppelt ist. Diese sind vorzugsweise entlang von zumindest zwei zumindest teilweise voneinander beabstandeten Geraden oder Kurven mit der Membran angeordnet.

Vorteilhaft ist es, wenn die Hubstruktur mit der Membran über eine Mehrzahl von verteilt und/oder voneinander beabstandet angeordneten Bereichen gekoppelt ist.

Ebenso ist es vorteilhaft, wenn die Hubstruktur eine Mehrzahl von miteinander verbundenen Balken aufweist, die jeweils zumindest teilweise an einer Stirnseite mit der Membran gekoppelt sind. Die Hubstruktur umfasst demnach mehrere balkenförmige Teile. Diese sind vorzugsweise in einer Draufsicht lotrecht zueinander ausgerichtet. Ferner ist die Hubstruktur vorzugsweise einteilig ausgebildet.

Vorteilhaft ist es, wenn die zumindest zwei piezoelektrischen Aktuatoren als Biegebalken ausgebildet sind. Sie sind demnach vorzugsweise geradlinig ausgebildet.

Ferner weisen die Aktuatoren vorzugsweise ein festgelegtes Ende, das insbesondere unmittelbar mit dem Trägersubstrat verbunden ist, und ein bewegliches Ende, das vorzugsweise mittelbar mit der Hubstruktur - nämlich über das zumindest eine flexible bzw. elastische Verbindungselement - verbunden ist, auf.

Vorteilhaft ist es, wenn der Aktuator eine größere Breite als Länge ausweist.

Des Weiteren ist es vorteilhaft, wenn in einer Querschnittsansicht des MEMS-Lautsprechers die zumindest zwei piezoelektrischen Aktuatoren in einer Ruheposition bzw. Nulllage in einer ersten Ebene angeordnet sind, dass die Membran in einer zu diesen in Hubrichtung beabstandeten zweiten Ebene angeordnet ist und/oder dass sich die Hubstruktur in Hubrichtung von der Membran ausgehend in Richtung der zweiten Ebene, insbesondere bis zu dieser hin oder über dies hinaus, erstreckt.

Vorteilhaft ist es, wenn zumindest eines der Verbindungselemente ein Federelement aufweist bzw. zumindest teilweise als solches ausgebildet ist. Das Verbindungselement kann sich somit flexibel bzw. elastisch verformen. Hierdurch kann der maximale Hub der Membran im Vergleich zum maximalen Aktuatorhub vergrößert werden, da die Membran aufgrund des Federelementes flexibel über den Aktuatorhub hinausschwingen kann.

Um ein Verkippen der Membran vermeiden zu können, ist es vorteilhaft, wenn das Federelement, insbesondere jedes, zumindest ein Biegefederelement, zumindest ein Torsionsfederelement und/oder eine Kombination aus zumindest einem Biegefederelement und zumindest einem Torsionsfederelement umfasst bzw. derart ausgebildet ist.

Vorteilhaft ist es, wenn die piezoelektrischen Aktuatoren in einer Querschnittsansicht des MEMS-Lautsprechers entlang ihrer Längsachse jeweils ein fest eingespanntes erstes Ende und ein bewegliches zweites Ende aufweisen.

Ferner ist es vorteilhaft, wenn sich das Biegefederelement in Längsrichtung und/oder das Torsionsfederelement in Querrichtung des piezoelektrischen Aktuators erstreckt.

Des Weiteren ist es vorteilhaft, wenn das Biegefederelement und das Torsionsfederelement eines Verbindungselementes in einer Draufsicht des MEMS-Lautsprechers zueinander um 90° verdreht sind.

Auch ist es vorteilhaft, wenn das Biegefederelement unmittelbar mit dem Aktuator verbunden ist und/oder mit diesem einteilig ausgebildet ist. Ferner ist es vorteilhaft, wenn das Torsionsfederelement in Kraftflussrichtung zwischen dem Biegefederelement und der Hubstruktur angeordnet ist.

Vorteilhaft ist es, wenn die Membran einen starren Bereich und einen flexiblen Bereich aufweist. Vorzugsweise ist die Hubstruktur mit dem starren Bereich der Membran gekoppelt, wobei insbesondere der starre Bereich der Membran durch eine erweiterte Hubstruktur gebildet ist.

In einer vorteilhaften Weiterbildung der Erfindung weist der MEMS-Lautsprecher zumindest einen piezoelektrischen Positionssensor auf. Dieser ist vorzugsweise ausgebildet, um ein von der Auslenkung der Membran abhängiges Sensorsignal bereitzustellen.

Vorteilhaft ist es ferner, wenn zumindest einer der piezoelektrischen Aktuatoren als piezoelektrischer Positionssensor ausgebildet ist.

Ebenso ist es vorteilhaft, wenn der MEMS-Lautsprecher zumindest vier piezoelektrische Aktuatoren aufweist, wobei zwei der zumindest vier piezoelektrischen Aktuatoren als piezoelektrische Positionssensoren ausgebildet sind. Ferner sind diese zumindest vier piezoelektrische Aktuatoren vorzugsweise derart symmetrisch zu einem Schwerpunkt des MEMS-Lautsprechers angeordnet, dass die zwei als piezoelektrische Positionssensoren ausgebil-deten piezoelektrischen Aktuatoren und die übrigen piezoelektrischen Aktuatoren jeweils symmetrisch zu dem Schwerpunkt der Hubstruktur angeordnet sind.

Vorteilhaft ist es, wenn der MEMS-Lautsprecher zumindest einen Stapel von zwei voneinander isolierten piezoelektrischen Schichten aufweist, wobei eine der zwei Schichten den zumindest einen piezoelektrischen Sensor bildet, und wobei eine andere der zwei Schichten einen der zumindest zwei piezoelektrischen Aktuatoren bildet.

Ferner ist es vorteilhaft, wenn die zwei voneinander isolierten piezoelektrischen Schichten unterschiedliche Materialien aufweisen.

Vorteilhafterweise sind der piezoelektrische Positionssensor und ein piezoelektrischer Aktuator der zumindest zwei piezoelektrischen Aktuatoren durch eine gemeinsame piezoelektrische Schicht gebildet.

Des Weiteren ist es vorteilhaft, wenn der MEMS-Lautsprecher zumindest einen piezoresistiven oder einen kapazitiven Positionssensor aufweist, der ausgebildet ist, um ein von der Auslenkung der Membran abhängiges Sensorsignal bereitzustellen.

Auch ist es vorteilhaft, wenn die Hubstruktur eine Mehrzahl von Hubkörpern aufweist und/oder wenn zumindest zwei Hubkörper der Mehrzahl von Hubkörpern über einen erweiterten Hubkörper miteinander verbunden sind.

Vorteilhaft ist es, wenn der MEMS-Lautsprecher eine Kavität aufweist. Diese ist vorzugsweise zumindest teilweise durch ein, insbesondere rahmenförmiges, Trägersubstrat des MEMS-Lautsprechers ausgebildet. Ferner ist die Kavität vorzugsweise auf der den Aktuatoren und/oder der Hubstruktur zugewandten Seite der Membran angeordnet.

Vorteilhaft ist es, wenn das Trägersubstrat und die Hubstruktur aus dem gleichen Material und/oder aus dem gleichen Grundkörper ausgebildet sind.

Vorzugsweise ist die Hubstruktur unmittelbar mit der Membran verbunden. Zusätzlich ist es vorteilhaft, wenn die Hubstruktur mittelbar mit dem zumindest einem Aktuator verbunden ist. Die mittelbare Verbindung zwischen Hubstruktur und Aktuator ist vorzugsweise mittels des flexiblen und/oder elastischen Verbindungselementes ausgebildet.

Vorteilhaft ist es, wenn die Aktuatoren in Hubrichtung bzw. z-Richtung von der Membran beabstandet sind.

Auch ist es vorteilhaft, wenn die Aktuatoren und die Membran in ihrer Neutralstellung zueinander parallel ausgerichtet sind.

Weitere Ausführungsbeispiele beziehen sich auf einen MEMS-Lautsprecher zum Erzeugen von Schallwellen im hörbaren Wellenlängenspektrum mit einer Membran. Die Membran ist vorzugsweise in ihrem Randbereich und/oder in z-Richtung schwingbar an einem Substratrahmen befestigt. Der Substratrahmen ist vorzugsweise aus Silizium hergestellt. Des Weiteren umfasst der MEMS-Lautsprecher vorzugsweise eine Kavität. Auch umfasst der MEMS-Lautsprecher eine Hubstruktur, die mit der Membran gekoppelt ist. Die Hubstruktur ist somit mit der Membran vorzugsweise unmittelbar und fest, insbesondere an einer der Kavität zugewandten Seite der Membran, befestigt. Die Hubstruktur ist vorzugsweise nur in einem Teilbereich der Membran flächig mit dieser verbunden. Der MEMS-Lautsprecher umfasst zumindest einen piezoelektrischen Aktuator, mittels dem zum Auslenken der Membran eine Hubbewegung der Hubstruktur hervorrufbar ist. Der Aktuator ist somit unmittelbar oder mittelbar, insbesondere über zumindest ein elastisches und/oder flexibles Verbindungselement, mit der Hubstruktur verbunden. Des Weiteren ist der Aktuator mittelbar, nämlich über die Hubstruktur, mit der Membran gekoppelt. Die Kavität des MEMS-Lautsprechers ist vorzugsweise auf der Hubstrukturseite der Membran angeordnet. Die Kavität ist vorzugsweise zumindest teilweise durch einen Hohlraum des Substratrahmens ausgebildet. Die Membran erstreckt sich ferner vorzugsweise über eine der beiden Öffnungen des Substratrahmens.

Der MEMS-Lautsprecher weist zumindest einen Positionssensor auf, der ausgebildet ist, um ein von der Auslenkung der Membran abhängiges Sensorsignal bereitzustellen. Mittels des Positionssensors ist somit unmittelbar und/oder mittelbar, d.h. insbesondere mittelbar über die Hubstrukturposition, die Position bzw. die Auslenkung der Membran erfassbar.

Der Positionssensor und/oder der Aktuator sind vorzugsweise in z-Richtung im Inneren des Hohlraums und/oder an der der Membran abgewandten zweiten Öffnung des Hohlraums angeordnet. Die Hubstruktur erstreckt sich vorzugsweise in z-Richtung von der Membran ausgehend zumindest bis zu dem Aktuator und/oder dem Positionssensor.

Ausführungsbeispiele der vorliegenden Erfindung schaffen einen MEMS-Lautsprecher mit zumindest zwei piezoelektrische Aktuatoren umfasst, die über eine Mehrzahl von voneinander beabstandeten Verbindungselementen mit einer Mehrzahl von voneinander beabstandeten Kontaktpunkten der Hubstruktur verbunden sind, wobei die zumindest zwei piezoelektrischen Aktuatoren ausgebildet sind, um eine Hubbewegung der Hubstruktur hervorzurufen, um die Membran auszulenken. Die Verbindungselemente sind vorzugsweise flexibel ausgebildet. Sie können sich somit reversibel verformen.

Vorteilhaft ist es, wenn der Aktuator mittels einer dafür vorgesehenen Steuereinrichtung in Abhängigkeit von dem Sensorsignal geregelt betreibbar ist. Hierfür wird die Membran über den Aktuator ausgelenkt und/oder deren Position bzw. Auslenkung in z-Richtung mittels des Positionssensors erfasst. Das von dem Positionssensor erfasste elektronische Eingangssignal wird an die Steuereinrichtung übermittelt. Die Steuereinrichtung bestimmt anhand dieses Eingangssignals die Ist-Position bzw. Ist-Auslenkung der Membran. Hierfür berücksichtigt sie insbesondere die elastischen Schwingungseigenschaften eines Verbindungselementes, das vorzugsweise ein freies Ende des insbesondere balkenförmigen Positionssensors mit der Hubstruktur verbindet. In Abhängigkeit dieser erfassten Ist-Position der Membran bestimmt die Steuereinrichtung eine gewünschte Soll-Position der Membran und/oder ein davon abhängiges elektronisches Ausgangssignal. Das Ausgangssignal wird an den Aktuator übermittelt, der die Membran entsprechend auslenkt. Während und/oder am Ende der Auslenkbewegung wird über den Positionssensor erneut die tatsächliche Ist-Position der Membran erfasst und gegebenenfalls gemäß der vorangegangenen Beschreibung erneut und/oder iterativ nachgeregelt bzw. eingeregelt.

In einer vorteilhaften Weiterbildung der Erfindung weist der MEMS-Lautsprecher zumindest einen piezoelektrischen und/oder kapazitiven Positionssensor auf.

Vorteilhaft ist es, wenn der Positionssensor in dem Aktuator integriert ist. Der Aktuator und der Positionssensor bilden somit eine Einheit und/oder ein Aktuator-/Sensorelement. Über den Positionssensor kann somit unmittelbar die Auslenkung des Aktuators erfasst werden.

Auch ist es vorteilhaft, wenn die Sensorelektroden des integrierten Positionssensors als flächige oder interdigitale Elektroden ausgebildet sind und/oder von den Aktuatorelektroden elektrisch isoliert sind.

Diesbezüglich ist es vorteilhaft, wenn der piezoelektrische Positionssensor und der piezoelektrische Aktuator durch eine gemeinsame piezoelektrische Schicht ausgebildet sind.

Auch ist es vorteilhaft, wenn die gemeinsamen piezoelektrische Schicht einen den Positionssensor bildenden Sensorbereich und einen, insbesondere von diesem elektrisch isolierten, den Aktuator bildenden Aktuatorbereich aufweist, wobei vorzugsweise der Sensorbereich im Vergleich zum Aktuatorbereich eine kleinere Fläche einnimmt.

Alternativ dazu ist es auch vorteilhaft, wenn der piezoelektrische Positionssensor und der piezoelektrische Aktuator jeweils durch eine separate piezoelektrische Schicht ausgebildet sind. Diesbezüglich weist der Aktuator somit vorzugsweise einen Stapel von zumindest zwei voneinander isolierten piezoelektrischen Schichten auf, von denen zumindest ein Teil der einen Schicht den zumindest einen piezoelektrischen Positionssensor und zumindest ein Teil der anderen Schicht den zumindest einen piezoelektrischen Aktuator ausbildet.

Auch ist es vorteilhaft, wenn der Stapel in Richtung der Hubachse orientiert ist, so dass die piezoelektrischen Schichten übereinander angeordnet sind. Alternativ ist es vorteilhaft, wenn der Stapel quer zur Hubachse orientiert ist, so dass die piezoelektrischen Schichten nebeneinander angeordnet sind.

Des Weiteren ist es vorteilhaft, wenn die zwei voneinander isolierten piezoelektrischen Schichten unterschiedliche Materialien aufweisen, wobei vorzugsweise die den Aktuator bildende Schicht aus PZT und die den Positionssensor bildende Schicht aus AIN besteht.

Alternativ zur integrativen Lösung ist es ferner vorteilhaft, wenn der Positionssensor und der zumindest eine Aktuator voneinander separiert sind. Der Positionssensor und der dazugehörige Aktuator sind somit durch zwei voneinander getrennte und/oder einzelne Bauteile und/oder Piezoelemente, insbesondere Biegebalken, ausgebildet.

Auch ist es vorteilhaft, wenn der MEMS-Lautsprecher mehrere Aktuatoren aufweist, von denen zumindest einer als Positionssensor verwendbar ist. Der Positionssensor weist somit im Vergleich zum Aktuator im Wesentlichen die gleichen körperlichen Merkmale auf. Als körperliches Unterscheidungsmerkmal sind diese vorzugsweise lediglich zueinander spiegelverkehrt ausgebildet. Der als Aktuator verwendete Aktuator und der als Positionssensor verwendete Positionssensor unterscheiden sich voneinander somit lediglich durch ein funktionelles Merkmal, da der Aktuator durch Anlegen einer Spannung aktiv auslenkbar ist und der Positionssensor im Gegensatz dazu durch das passive Auslenken eine Spannung zu erzeugen vermag. Hierbei ist vorzugsweise die über den direkten piezoelektrischen Effekt generierte Spannung, welche näherungsweise proportional zur Auslenkung der Hubstruktur ist, über eine Aktuatorelektrode abgreifbar und/oder von der dafür vorgesehenen Steuereinrichtung auswertbar.

Ebenso ist es vorteilhaft, wenn mehrere Aktuatoren und/oder Positionssensoren paarweise gegenüberliegend angeordnet sind, wobei der MEMS-Lautsprecher vorzugsweise zumindest vier symmetrisch zum Schwerpunkt der Hubstruktur angeordnete piezoelektrische Aktuatoren aufweist und/oder zwei der zumindest vier piezoelektrische Aktuatoren als piezoelektrische Positionssensoren ausgebildet sind.

Vorteilhaft ist es, wenn der zumindest eine Aktuator und/oder Positionssensor über zumindest ein, insbesondere flexibles, Verbindungselement mit der Hubstruktur verbunden ist. Der Aktuator und/oder der Positionssensor ist somit mittelbar über das zumindest eine zwischengeschaltete Verbindungselement und über die zwischengeschaltete Hubstruktur mit der Membran verbunden.

Ebenso ist es vorteilhaft, wenn der MEMS-Lautsprecher vorzugsweise zumindest zwei piezoelektrische Aktuatoren aufweist, die über eine Mehrzahl von voneinander beabstandeten Verbindungselementen mit einer Mehrzahl von voneinander beabstandeten Kontaktpunkten der Hubstruktur verbunden sind.

Auch ist es vorteilhaft, wenn die Membran an einer Stirnseite der Hubstruktur unmittelbar und/oder die piezoelektrischen Aktuatoren und/oder Positionssensoren an zumindest einer Seitenfläche der Hubstruktur, insbesondere an zwei gegenüberliegenden Seitenflächen, über die Verbindungselemente mittelbar mit der Hubstruktur verbunden sind.

Vorteilhaft ist es, wenn die Mehrzahl von voneinander, insbesondere in Querrichtung des MEMS-Lautsprechers, beabstandeten Verbindungselementen mit einer Mehrzahl von voneinander beabstandeten Kontaktpunkten der zumindest zwei piezoelektrischen Aktuatoren und/oder Positionssensoren verbunden sind.

Auch ist es vorteilhaft, wenn jeder der zumindest zwei piezoelektrischen Aktuatoren und/oder Positionssensoren über zumindest zwei voneinander beabstandete Verbindungselemente mit zumindest zwei voneinander beabstandeten Kontaktpunkten der Hubstruktur verbunden sind.

Vorteilhaft ist es, wenn die Hubstruktur mit der Membran über eine Mehrzahl von Bereichen gekoppelt ist, die entlang von zumindest zwei zumindest teilweise voneinander beabstandeten Geraden oder Kurven mit der Membran angeordnet sind.

Auch ist es vorteilhaft, wenn die Hubstruktur senkrecht zu einer Richtung der Hubbewegung eine Fläche aufspannt, die zumindest 30 % einer Fläche der Membran entspricht.

Vorteilhaft ist es, wenn die Hubstruktur mit der Membran über eine Mehrzahl von verteilt angeordneten Bereichen gekoppelt ist.

Ebenso ist es vorteilhaft, wenn die Hubstruktur in einer Schnittebene, die senkrecht zu einer Richtung der Hubbewegung verläuft, eine I- Struktur, eine L-Struktur, eine H-Struktur, eine X-Struktur, eine O-Struktur oder eine kreuzförmige Struktur aufweist.

Vorteilhaft ist es, wenn ein Hebelarm zwischen einem der Kraftangriffspunkte der Hubstruktur auf die Membran und einem nächstliegenden Aufnahmepunkt einer Membranaufhängung höchstens halb so groß ist wie ein Hebelarm der zumindest zwei piezoelektrischen Aktuatoren.

Auch ist es vorteilhaft, wenn eine Querschnittsfläche der Hubstruktur senkrecht zu einer Richtung der Hubbewegung (z-Richtung) der Hubstruktur kleiner ist als eine Summe von piezoelektrisch aktiven Aktuatorflächen und/oder Positionssensoren der zumindest zwei piezoelektrischen Aktuatoren.

Vorteilhaft ist es, wenn die Hubstruktur eine Mehrzahl von miteinander verbundenen Balken aufweist, die jeweils zumindest teilweise an einer Stirnseite mit der Membran gekoppelt sind.

Ebenso ist es vorteilhaft, wenn der Aktuator und/oder der Positionssensor als Biegebalken ausgebildet sind. Auch ist es vorteilhaft, wenn die zumindest zwei piezoelektrischen Aktuatoren und/oder Positionssensoren als Biegebalken ausgebildet sind.

Auch ist es vorteilhaft, wenn die Hubstruktur symmetrisch ist und/oder die zumindest zwei piezoelektrischen Aktuatoren und/oder Positionssensoren symmetrisch zu einem Schwerpunkt der Hubstruktur angeordnet sind.

Vorteilhaft ist es, wenn die Mehrzahl von voneinander beabstandeten Kontaktpunkten der Hubstruktur symmetrisch zu dem Schwerpunkt der Hubstruktur angeordnet sind.

Auch ist es vorteilhaft, wenn die zumindest zwei piezoelektrischen Aktuatoren und/oder Positionssensoren in einer Ruheposition in einer ersten Ebene angeordnet sind, dass die Membran in einer zu dieser in Hubrichtung beabstandeten zweiten Ebene angeordnet ist und/oder dass sich die Hubstruktur in Hubrichtung von der Membran ausgehend in Richtung der zweiten Ebene, insbesondere bis zu dieser hin oder über diese hinaus, erstreckt.

Vorteilhaft ist es, wenn zumindest eines der Verbindungselemente ein Federelement aufweist und/oder als ein solches ausgebildet ist. Auch ist es vorteilhaft, wenn das Federelement, insbesondere jedes, zumindest ein Biegefederelement und/oder zumindest ein Torsionsfederelement umfasst.

Auch ist es vorteilhaft, wenn die piezoelektrischen Aktuatoren und/oder Positionssensoren in einer Querschnittsansicht des MEMS-Lautsprechers entlang ihrer Längsachse jeweils ein fest eingespanntes erstes Ende und ein bewegliches zweites Ende aufweisen und/oder dass sich das Biegefederelement in Längsrichtung und/oder das Torsionsfederelement in Querrichtung des piezoelektrischen Aktuators und/oder Positionssensors erstreckt. Vorteilhafterweise ist das Biegefederelement derart ausgebildet, dass es um seine Querachse biegbar ist. Vorteilhafterweise ist das Torsionsfederelement derart ausgebildet, dass es um seine Längsachse biegbar ist.

Vorteilhaft ist es, wenn das Biegefederelement und das Torsionsfederelement eines Verbindungselementes in einer Draufsicht des MEMS-Lautsprechers zueinander um 90° verdreht sind.

Ebenso ist es vorteilhaft, wenn die Membran parallel zu einer ersten Oberfläche und einer zweiten Oberfläche des MEMS-Lautsprechers verläuft, wobei die Membran ausgebildet ist, um bei einer bestimmungsgemäßen Verwendung des MEMS-Lautsprechers die erste Oberfläche und die zweite Oberfläche des MEMS-Lautsprechers fluidisch und/oder gasförmig voneinander zu trennen.

Vorteilhaft ist es, wenn die Membran einen starren Bereich und einen flexiblen Bereich aufweist, wobei die Hubstruktur mit dem starren Bereich der Membran gekoppelt ist, wobei vorzugsweise der starre Bereich der Membran durch eine erweiterte Hubstruktur gebildet ist.

Ebenso ist es vorteilhaft, wenn die Hubstruktur Silizium aufweist und/oder mit dem Substratrahmen aus demselben Grundkörper hergestellt ist.

Auch ist es vorteilhaft, wenn die Hubstruktur zumindest drei Abschnitte aufweist, die angeordnet sind, um eine H-förmige Hubstruktur zu bilden, so dass die Hubstruktur in der Schnittebene, die senkrecht zu der Richtung der Hubbewegung der Hubstruktur verläuft, H-förmig ist.

Vorteilhaft ist es, wenn ein erster piezoelektrischer Aktuator der zumindest zwei piezoelektrischen Aktuatoren außerhalb der H-förmigen Hubstruktur entlang eines ersten Abschnitts der drei Abschnitte der Hubstruktur angeordnet ist und ein zweiter piezoelektrischer Aktuator der zumindest zwei piezoelektrischen Aktuatoren außerhalb der H-förmigen Hubstruktur entlang eines zweiten Abschnitts der drei Abschnitte der Hubstruktur angeordnet ist, wobei der erste Abschnitt und der zweite Abschnitt der Hubstruktur parallel zueinander verlaufen.

Vorteilhaft ist es, wenn ein dritter piezoelektrischer Aktuator der zumindest zwei piezoelektrischen Aktuatoren zumindest teilweise innerhalb der H-förmigen Hubstruktur entlang einer ersten Seite eines dritten Abschnitts der drei Abschnitte der Hubstruktur angeordnet ist. Auch ist es vorteilhaft, wenn ein vierter piezoelektrischer Aktuator der zumindest zwei piezoelektrischen Aktuatoren zumindest teilweise innerhalb der H-förmigen Hubstruktur entlang einer der ersten Seite gegenüberliegenden zweiten Seite des dritten Abschnitts der Hubstruktur angeordnet ist, wobei der dritte Abschnitt senkrecht zu dem ersten Abschnitt und dem zweiten Abschnitt verläuft.

Auch ist es vorteilhaft, wenn sich der erste piezoelektrische Aktuator zumindest über den gesamten ersten Abschnitt der Hubstruktur erstreckt und über zumindest zwei der voneinander beabstandeten Verbindungselemente mit zumindest zwei der voneinander beabstandeten Kontaktpunkte des ersten Abschnitts der Hubstruktur verbunden ist, wobei sich der zweite piezoelektrische Aktuator zumindest über den gesamten zweiten Abschnitt der Hubstruktur erstreckt und über zumindest zwei der voneinander beabstandeten Verbindungselemente mit zumindest zwei der voneinander beabstandeten Kontaktpunkte des zweiten Abschnitts der Hubstruktur verbunden ist.

Ebenso ist es vorteilhaft, wenn der erste piezoelektrische Aktuator und ein fünfter piezoelektrischer Aktuator der zumindest zwei piezoelektrischen Aktuatoren außerhalb der Hubstruktur entlang des ersten Abschnitts der Hubstruktur angeordnet sind, wobei der zweite piezoelektrische Aktuator und ein sechster piezoelektrischer Aktuator der zumindest zwei piezoelektrischen Aktuatoren außerhalb der Hubstruktur entlang des zweiten Abschnitts der Hubstruktur angeordnet sind.

Vorteilhaft ist es, wenn der erste piezoelektrische Aktuator und der fünfte piezoelektrische Aktuator jeweils über zumindest eines der voneinander beabstandeten Verbindungselemente mit zumindest einem der voneinander beabstandeten Kontaktpunkte des ersten Abschnitts der Hubstruktur verbunden ist, wobei der zweite piezoelektrische Aktuator und der sechste piezoelektrische Aktuator jeweils über zumindest eines der voneinander beabstandeten Verbindungselemente mit zumindest einem der voneinander beabstandeten Kontaktpunkte des zweiten Abschnitts der Hubstruktur verbunden ist.

Auch ist es vorteilhaft, wenn der erste Abschnitt in einen ersten Teilabschnitt und einen zweiten Teilabschnitt unterteilt ist, wobei der erste piezoelektrische Aktuator entlang des ersten Teilabschnitts des ersten Abschnitts angeordnet ist und mit dem ersten Teilabschnitt des ersten Abschnitts über das jeweilige Verbindungselement verbunden ist, wobei der fünfte piezoelektrische Aktuator entlang des zweiten Teilabschnitts des ersten Abschnitts angeordnet ist und mit dem zweiten Teilabschnitt des ersten Abschnitts über das jeweilige Verbindungselement verbunden ist; und wobei der zweite Abschnitt in einen ersten Teilabschnitt und einen zweiten Teilabschnitt unterteilt ist, wobei der zweite piezoelektrische Aktuator entlang des ersten Teilabschnitts des zweiten Abschnitts angeordnet ist und mit dem ersten Teilabschnitt des zweiten Abschnitts über das jeweilige Verbindungselement verbunden ist, wobei der sechste piezoelektrische Aktuator entlang des zweiten Teilabschnitts des zweiten Abschnitts angeordnet ist und mit dem zweiten Teilabschnitt des zweiten Abschnitts über das jeweilige Verbindungselement verbunden ist.

Vorteilhaft ist es, wenn der dritte piezoelektrische Aktuator und ein siebter piezoelektrischer Aktuator der zumindest zwei piezoelektrischen Aktuatoren zumindest teilweise innerhalb der Hubstruktur entlang der ersten Seite des dritten Abschnitts der Hubstruktur angeordnet sind, wobei der vierte piezoelektrische Aktuator und ein achter piezoelektrische Aktuator der zumindest zwei piezoelektrischen Aktuatoren zumindest teilweise innerhalb der Hubstruktur entlang der zweiten Seite des dritten Abschnitts der Hubstruktur angeordnet sind.

Ebenso ist es vorteilhaft, wenn der dritte Abschnitt in einen ersten Teilabschnitt und einen zweiten Teilabschnitt unterteilt ist, wobei der dritte piezoelektrische Aktuator entlang einer ersten Seite des ersten Teilabschnitts des dritten Abschnitts angeordnet ist, wobei der vierte piezoelektrische Aktuator entlang einer der ersten Seite gegenüberliegenden zweiten Seite des ersten Teilabschnitts des dritten Abschnitts angeordnet ist, wobei der siebte piezoelektrische Aktuator entlang einer ersten Seite des zweiten Teilabschnitts des dritten Abschnitts angeordnet ist, wobei der achte piezoelektrische Aktuator entlang einer der ersten Seite gegenüberliegenden zweiten Seite des zweiten Teilabschnitts des dritten Abschnitts angeordnet ist.

Vorteilhaft ist es, wenn die Hubstruktur mehrere Hubkörper aufweist und/oder dass zumindest zwei Hubkörper über einen erweiterten Hubkörper miteinander verbunden sind.

Vorgeschlagen wird ferner eine Regelungseinheit zum geregelten Betreiben eines MEMS-Lautsprechers. Die Regelungseinheit umfasst einen MEMS-Lautsprecher gemäß der vorangegangenen Beschreibung, wobei die genannten Merkmale einzeln oder in beliebiger Kombination vorhanden sein können. Des Weiteren umfasst die Regelungseinheit eine Steuereinrichtung, die ausgebildet ist, um einen piezoelektrischen Aktuator des MEMS-Lautsprechers anzusteuern. Der MEMS-Lautsprecher weist zumindest einen piezoelektrischen Positionssensor auf, der ausgebildet ist, um der Steuereinrichtung ein von der Auslenkung einer Membran des MEMS-Lautsprechers abhängiges Sensorsignal bereitzustellen, und dass die Ansteuereinrichtung ausgebildet ist, um den zumindest einen piezoelektrischen Aktuator des MEMS-Lautsprechers basierend auf dem Sensorsignal geregelt anzusteuern.

Vorteilhaft ist es, wenn mittels des Positionssensors die tatsächliche Position der Hubstruktur im Betrieb kontinuierlich bestimmbar und mittels der Steuereinrichtung durch Ansteuerung des zumindest einen piezoelektrischen Aktuator regelbar ist.

Vorteilhaft ist es, wenn die Hubstruktur mehrere Kontaktpunkte aufweist. Diese sind voneinander, insbesondere in Quer- und/oder Längsrichtung des Aktuators, beabstandet. In diesen Kontaktpunkten ist jeweils ein Verbindungselement befestigt, das den jeweils zugeordneten Aktuator flexibel bzw. elastisch mit der Hubstruktur verbindet.

Vorteilhaft ist es, wenn der MEMS-Lautsprecher zur Anregung einer Membran einen Hubkörper und zumindest zwei piezoelektrische Aktuatoren aufweist, wobei die zumindest zwei Aktuatoren über eine Mehrzahl voneinander beabstandeten Verbindungselementen mit einer Mehrzahl von voneinander beabstandeten Kontaktpunkten der Hubstruktur verbunden sind. Dadurch, dass der MEMS-Lautsprecher zumindest zwei piezoelektrische Aktuatoren aufweist, die über eine Mehrzahl von Verbindungselementen mit der Hubstruktur verbunden sind, ist es möglich, gleichzeitig hohe Kräfte und Auslenkungen über die Hubstruktur auf die Membran zu übertragen. Dadurch, dass die Mehrzahl von Verbindungselementen und damit auch die Mehrzahl von Kontaktpunkten voneinander beabstandet sind, kann sichergestellt bzw. gewährleitstet werden, dass die Hubstruktur die Hubbewegung reproduzierbar und gleichmäßig ausübt und beispielsweise nicht von einer gewünschten Richtung der Hubbewegung abweicht, wie dies beispielsweise bei einem Auftreten von Kippmoden der Fall wäre.

Vorteilhaft ist es, wenn die piezoelektrischen Aktuatoren über eine Mehrzahl von voneinander beabstandeten und flexiblen Verbindungselementen mit einer Mehrzahl von voneinander beabstandeten Kontaktpunkten der Hubstruktur verbunden sind.

Vorteilhaft ist es, wenn die einem der beiden Aktuatoren zugeordneten Verbindungselemente voneinander in Querrichtung des Aktuators und/oder des MEMS-Schallwandlers voneinander beabstandet sind.

Vorteilhaft ist es, wenn die Membran an einer Stirnseite der Hubstruktur unmittelbar und/oder die piezoelektrischen Aktuatoren an zumindest einer Seitenfläche der Hubstruktur, insbesondere an zwei gegenüberliegenden Seitenflächen, mittelbar, nämlich über die Verbindungselemente, mit der Hubstruktur verbunden sind. In einer Querschnittsansicht des MEMS-Lautsprechers ist demnach die Stirnseite der Hubstruktur in z-Richtung, d.h. in Hubrichtung, orientiert. Die Seitenflächen der Hubstruktur sind im Gegensatz dazu in Querrichtung, d.h. lotrecht zur Hubachse, ausgerichtet.

In einer vorteilhaften Weiterbildung der Erfindung sind mehrere voneinander beabstandete Verbindungselemente mit mehreren voneinander beabstandeten Kontaktpunkten der zumindest zwei piezoelektrischen Aktuatoren verbunden.

Auch ist es vorteilhaft, wenn jeder der zumindest zwei piezoelektrischen Aktuatoren über zumindest zwei voneinander beabstandete Verbindungselemente mit zumindest zwei voneinander beabstandeten Kontaktpunkten der Hubstruktur verbunden ist.

Ferner ist es vorteilhaft, wenn die Hubstruktur mit der Membran über eine Mehrzahl von Bereichen - d.h. in mehreren Bereichen - gekoppelt ist. Diese sind vorzugsweise entlang von zumindest zwei zumindest teilweise voneinander beabstandeten Geraden oder Kurven mit der Membran angeordnet.

Vorteilhaft ist es, wenn die Hubstruktur mit der Membran über eine Mehrzahl von verteilt und/oder voneinander beabstandet angeordneten Bereichen gekoppelt ist.

Ebenso ist es vorteilhaft, wenn die Hubstruktur eine Mehrzahl von miteinander verbundenen Balken aufweist, die jeweils zumindest teilweise an einer Stirnseite mit der Membran gekoppelt sind. Die Hubstruktur umfasst demnach mehrere balkenförmige Teile. Diese sind vorzugsweise in einer Draufsicht lotrecht zueinander ausgerichtet. Ferner ist die Hubstruktur vorzugsweise einteilig ausgebildet.

Vorteilhaft ist es, wenn die zumindest zwei piezoelektrischen Aktuatoren als Biegebalken ausgebildet sind. Sie sind demnach vorzugsweise geradlinig ausgebildet.

Vorteilhaft ist es, wenn der zumindest eine Aktuator und/oder Positionssensor ein festgelegtes Ende, das insbesondere unmittelbar mit dem Trägersubstrat verbunden ist, und ein bewegliches Ende, das vorzugsweise mittelbar mit der Hubstruktur - nämlich über das zumindest eine flexible bzw. elastische Verbindungselement - verbunden ist, aufweist.

Vorteilhaft ist es, wenn der Aktuator eine größere Breite als Länge aufweist.

Des Weiteren ist es vorteilhaft, wenn in einer Querschnittsansicht des MEMS-Lautsprechers die zumindest zwei piezoelektrischen Aktuatoren in einer Ruheposition bzw. Nulllage in einer ersten Ebene angeordnet sind, dass die Membran in einer zu diesen in Hubrichtung beabstandeten zweiten Ebene angeordnet ist und/oder dass sich die Hubstruktur in Hubrichtung von der Membran ausgehend in Richtung der zweiten Ebene, insbesondere bis zu dieser hin oder über dies hinaus, erstreckt.

Vorteilhaft ist es, wenn zumindest eines der Verbindungselemente ein Federelement aufweist bzw. zumindest teilweise als solches ausgebildet ist. Das Verbindungselement kann sich somit flexibel bzw. elastisch verformen. Hierdurch kann der maximale Hub der Membran im Vergleich zum maximalen Aktuatorhub vergrößert werden, da die Membran aufgrund des Federelementes flexibel über den Aktuatorhub hinausschwingen kann.

Um ein Verkippen der Membran vermeiden zu können, ist es vorteilhaft, wenn das Federelement, insbesondere jedes, zumindest ein Biegefederelement, zumindest ein Torsionsfederelement und/oder eine Kombination aus zumindest einem Biegefederelement und zumindest einem Torsionsfederelement umfasst bzw. derart ausgebildet ist.

Vorteilhaft ist es, wenn die piezoelektrischen Aktuatoren in einer Querschnittsansicht des MEMS-Lautsprechers entlang ihrer Längsachse jeweils ein fest eingespanntes erstes Ende und ein bewegliches zweites Ende aufweisen.

Ferner ist es vorteilhaft, wenn sich das Biegefederelement in Längsrichtung und/oder das Torsionsfederelement in Querrichtung des piezoelektrischen Aktuators erstreckt.

Auch ist es vorteilhaft, wenn das Biegefederelement unmittelbar mit dem Aktuator verbunden ist und/oder mit diesem einteilig ausgebildet ist. Ferner ist es vorteilhaft, wenn das Torsionsfederelement in Kraftflussrichtung zwischen dem Biegefederelement und der Hubstruktur angeordnet ist.

Vorteilhaft ist es, wenn die Membran einen starren Bereich und einen flexiblen Bereich aufweist. Vorzugsweise ist die Hubstruktur mit dem starren Bereich der Membran gekoppelt, wobei insbesondere der starre Bereich der Membran durch eine erweiterte Hubstruktur gebildet ist.

In einer vorteilhaften Weiterbildung der Erfindung weist der MEMS-Lautsprecher zumindest einen piezoelektrischen Positionssensor auf. Dieser ist vorzugsweise ausgebildet, um ein von der Auslenkung der Membran abhängiges Sensorsignal bereitzustellen.

Vorteilhaft ist es ferner, wenn zumindest einer der piezoelektrischen Aktuatoren als piezoelektrischer Positionssensor ausgebildet ist.

Ebenso ist es vorteilhaft, wenn der MEMS-Lautsprecher zumindest vier piezoelektrische Aktuatoren aufweist, wobei zwei der zumindest vier piezoelektrischen Aktuatoren als piezoelektrische Positionssensoren ausgebildet sind. Ferner sind diese zumindest vier piezoelektrischen Aktuatoren vorzugsweise derart symmetrisch zu einem Schwerpunkt des MEMS-Lautsprechers angeordnet, dass die zwei als piezoelektrische Positionssensoren ausgebildeten piezoelektrischen Aktuatoren und die übrigen piezoelektrischen Aktuatoren jeweils symmetrisch zu dem Schwerpunkt der Hubstruktur angeordnet sind.

Vorteilhaft ist es, wenn der MEMS-Lautsprecher zumindest einen Stapel von zwei voneinander isolierten piezoelektrischen Schichten aufweist, wobei eine der zwei Schichten den zumindest einen piezoelektrischen Sensor bildet, und wobei eine andere der zwei Schichten einen der zumindest zwei piezoelektrischen Aktuatoren bildet.

Ferner ist es vorteilhaft, wenn die zwei voneinander isolierten piezoelektrischen Schichten unterschiedliche Materialien aufweisen.

Vorteilhafterweise sind der piezoelektrische Positionssensor und ein piezoelektrischer Aktuator der zumindest zwei piezoelektrischen Aktuatoren durch eine gemeinsame piezoelektrische Schicht gebildet.

Des Weiteren ist es vorteilhaft, wenn der MEMS-Lautsprecher zumindest einen piezoresistiven oder einen kapazitiven Positionssensor aufweist, der ausgebildet ist, um ein von der Auslenkung der Membran abhängiges Sensorsignal bereitzustellen.

Auch ist es vorteilhaft, wenn die Hubstruktur eine Mehrzahl von Hubkörpern aufweist und/oder wenn zumindest zwei Hubkörper der Mehrzahl von Hubkörpern über einen erweiterten Hubkörper miteinander verbunden sind.

Vorteilhaft ist es, wenn der MEMS-Lautsprecher eine Kavität aufweist. Diese ist vorzugsweise zumindest teilweise durch ein, insbesondere rahmenförmiges, Trägersubstrat des MEMS-Lautsprechers ausgebildet. Ferner ist die Kavität vorzugsweise auf der den Aktuatoren und/oder der Hubstruktur zugewandten Seite der Membran angeordnet.

Vorteilhaft ist es, wenn das Trägersubstrat und die Hubstruktur aus dem gleichen Material und/oder aus dem gleichen Grundkörper ausgebildet sind.

Vorzugsweise ist die Hubstruktur unmittelbar mit der Membran verbunden. Zusätzlich ist es vorteilhaft, wenn die Hubstruktur mittelbar mit dem zumindest einem Aktuator verbunden ist. Die mittelbare Verbindung zwischen Hubstruktur und Aktuator ist vorzugsweise mittels des flexiblen und/oder elastischen Verbindungselementes ausgebildet.

Vorteilhaft ist es, wenn die Aktuatoren in Hubrichtung bzw. z-Richtung von der Membran beabstandet sind.

Auch ist es vorteilhaft, wenn die Aktuatoren und die Membran in ihrer Neutralstellung zueinander parallel ausgerichtet sind.

Ausführungsbeispiele der vorliegenden Erfindung werden bezugnehmend auf die beiliegenden Zeichnungen näher erläutert. Es zeigen:
- Fig. 1a: eine schematische Querschnittsansicht eines MEMS, gemäß einem Ausführungsbeispiel der vorliegenden Erfindung;
- Fig. 1b: eine schematische Draufsicht des in Fig. 1a gezeigten MEMS, gemäß einem Ausführungsbeispiel der vorliegenden Erfindung;
- Fig. 2a: eine schematische Querschnittsansicht eines MEMS im aktivierten Zustand, gemäß einem Ausführungsbeispiel der vorliegenden Erfindung;
- Fig. 2b: eine schematische Querschnittsansicht des MEMS im Ruhezustand, gemäß einem Ausführungsbeispiel der vorliegenden Erfindung;
- Fig. 3a-d: schematische Querschnittsansichten vier verschiedener Ausführungsbeispiele der piezoelektrischen Aktuatoren des MEMS;
- Fig. 4a-f: schematische Draufsichten sechs verschiedener Ausführungsbeispiele der Hubstruktur des MEMS;
- Fig. 5a-h: schematische Draufsichten acht verschiedener Ausführungsbeispiele von Anordnungen der piezoelektrischen Aktuatoren bezüglich der Hubstruktur des MEMS;
- Fig. 6a-f: schematische Draufsichten sechs verschiedener Ausführungsbeispiele der Verbindungselemente des MEMS;
- Fig. 7a,b: schematische Draufsichten zweier Ausführungsbeispiele eines piezoelektrischen Aktuators mit integriertem Positionssensor;
- Fig. 8: eine schematische Querschnittsansicht eines MEMS, gemäß einem Ausführungsbeispiel der vorliegenden Erfindung;
- Fig. 9a: eine schematische Querschnittsansicht eines MEMS mit einer Membran mit erweitertem Hubkörper, gemäß einem Ausführungsbeispiel der vorliegenden Erfindung;
- Fig. 9b: eine schematische Draufsicht des in Fig. 9a gezeigten MEMS mit der Membran und dem erweiterten Hubkörper, gemäß einem Ausführungsbeispiel der vorliegenden Erfindung;
- Fig. 10a: eine schematische Querschnittsansicht eines MEMS mit einer flexiblen Membran, gemäß einem Ausführungsbeispiel der vorliegenden Erfindung;
- Fig. 10b: eine schematische Draufsicht des in Fig. 10a gezeigten MEMS mit der flexiblen Membran, gemäß einem Ausführungsbeispiel der vorliegenden Erfindung;
- Fig. 11a: eine schematische Querschnittsansicht eines MEMS mit einer flexiblen Membran, gemäß einem Ausführungsbeispiel der vorliegenden Erfindung;
- Fig. 11b: eine schematische Draufsicht des in Fig. 11a gezeigten MEMS mit der flexiblen Membran, gemäß einem Ausführungsbeispiel der vorliegenden Erfindung;
- Fig. 12a: eine Draufsicht eines CAD-Modells des MEMS, gemäß einem Ausführungsbeispiel der vorliegenden Erfindung;
- Fig. 12b: eine perspektivische Ansicht einer FEM-Simulation des in Fig. 12a gezeigten MEMS, gemäß einem Ausführungsbeispiel der vorliegenden Erfindung;
- Fig. 13a: eine Draufsicht eines CAD-Modells des MEMS, gemäß einem Ausführungsbeispiel der vorliegenden Erfindung;
- Fig. 13b: eine perspektivische Ansicht einer FEM-Simulation des in Fig. 13a gezeigten MEMS, gemäß einem Ausführungsbeispiel der vorliegenden Erfindung;
- Fig. 14a: eine Draufsicht eines CAD-Modells des MEMS, gemäß einem Ausführungsbeispiel der vorliegenden Erfindung;
- Fig. 14b: eine perspektivische Ansicht einer FEM-Simulation des in Fig. 14a gezeigten MEMS, gemäß einem Ausführungsbeispiel der vorliegenden Erfindung;
- Fig. 15a: eine Draufsicht eines CAD-Modells des MEMS, gemäß einem Ausführungsbeispiel der vorliegenden Erfindung;
- Fig. 15b: eine perspektivische Ansicht einer FEM-Simulation des in Fig. 15a gezeigten MEMS, gemäß einem Ausführungsbeispiel der vorliegenden Erfindung;
- Fig. 16a: eine Draufsicht eines CAD-Modells des MEMS, gemäß einem Ausführungsbeispiel der vorliegenden Erfindung;
- Fig. 16b: eine perspektivische Ansicht einer FEM-Simulation des in Fig. 16a gezeigten MEMS, gemäß einem Ausführungsbeispiel der vorliegenden Erfindung;
- Fig. 17a-c: schematische Querschnitte des MEMS nach verschiedenen Prozessschritten eines Verfahrens zur Herstellung des MEMS; und
- Fig. 18: eine schematische Ansicht eines Systems mit einem MEMS und einer Ansteuereinrichtung zum Ansteuern der zumindest zwei piezoelektrischen Aktuatoren des MEMS, gemäß einem Ausführungsbeispiel.

In der nachfolgenden Beschreibung der Ausführungsbeispiele der Erfindung werden in den Figuren gleiche oder gleichwirkende Elemente mit dem gleichen Bezugszeichen versehen, so dass deren Beschreibung in den unterschiedlichen Ausführungsbeispielen untereinander austauschbar ist.

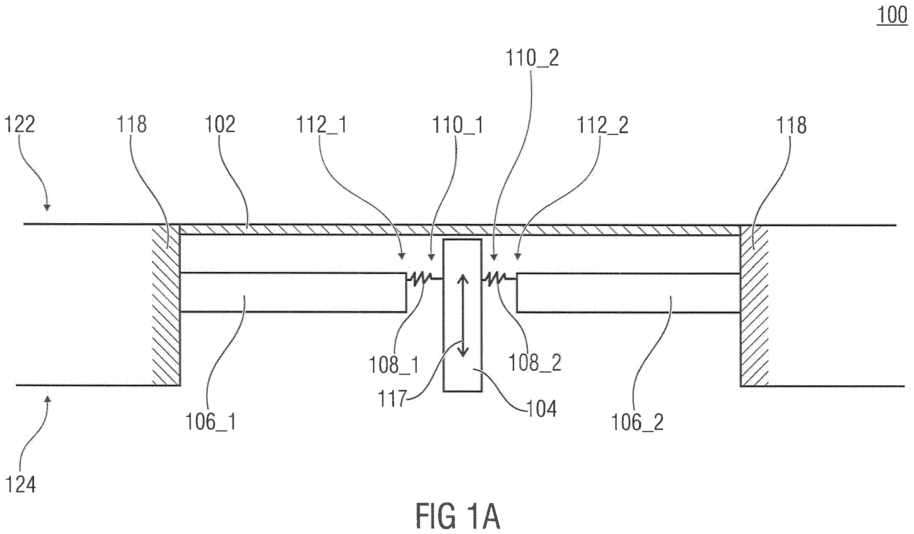

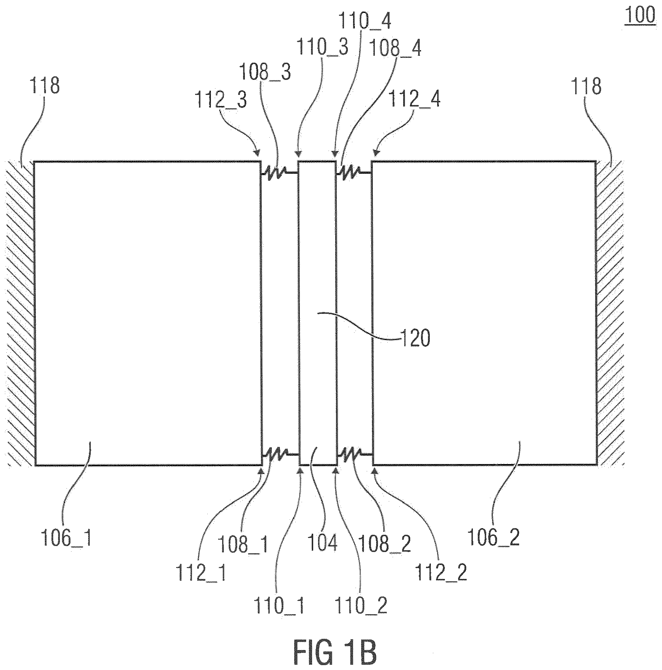

Fig. 1a zeigt eine schematische Querschnittsansicht eines MEMS 100 gemäß einem Ausführungsbeispiel der vorliegenden Erfindung, während Fig. 1b eine schematische Draufsicht des in Fig. 1a gezeigten MEMS 100 zeigt. Das MEMS 100 weist eine Membran 102, eine Hubstruktur 104, die mit der Membran 102 gekoppelt ist, und zumindest zwei piezoelektrische Aktuatoren 106_1 bis 106_n (n = 2) auf, die über eine Mehrzahl von voneinander beabstandeten Verbindungselementen 108_1 bis 108_m (m = 4) mit einer Mehrzahl von voneinander beabstandeten Kontaktpunkten 110_1 bis 110_m (m = 4) der Hubstruktur 104 verbunden sind, wobei die zumindest zwei piezoelektrischen Aktuatoren 106_1 bis 106_n (n = 2) ausgebildet sind, um eine (uni- oder bidirektionale) Hubbewegung der Hubstruktur 104 hervorzurufen, um die Membran 102 auszulenken.

Bei Ausführungsbeispielen können die zumindest zwei piezoelektrischen Aktuatoren 106_1 bis 106_n (n = 2) in einer Ruheposition in einer Ebene angeordnet sein, wobei die zumindest zwei piezoelektrischen Aktuatoren 106_1 bis 106_n (n = 2) ausgebildet sein können, um eine Hubbewegung der Hubstruktur 104 derart hervorzurufen, dass eine Richtung der Hubbewegung senkrecht zu der Ebene der piezoelektrischen Aktuatoren 106_1 bis 106_n (n = 2) verläuft. In Fig. 1a ist die Richtung der Hubbewegung durch den Pfeil 114 exemplarisch angedeutet.

Die zumindest zwei piezoelektrischen Aktuatoren 106_1 bis 106_n (n = 2) können beispielsweise als Biegebalken implementiert sein. Ferner können die zumindest zwei piezoelektrischen Aktuatoren106_1 bis 106_n (n = 2) in einer Einspannung 118, beispielsweise einem Halbleitersubstrat, wie z.B. einem Silizium-Halbleitersubstrat, eingespannt sein.

Das in Fig. 1a und 1b gezeigte MEMS 100 weist beispielhaft zwei piezoelektrische Aktuatoren 106_1 bis 106_n (n = 2) auf. Die Erfindung ist jedoch nicht auf solche Ausführungsbeispiele beschränkt. Vielmehr kann das MEMS 100 bis zu n piezoelektrische Aktuatoren 106_1 bis 106_n aufweisen, wobei n eine natürliche Zahl größer gleich zwei ist, n ≥ 2.

Bei Ausführungsbeispielen können die zumindest zwei piezoelektrischen Aktuatoren 106_1 bis 106_n (n = 2) über eine Mehrzahl von voneinander beabstandeten Verbindungselementen 108_1 bis 108_m (m = 4) mit einer Mehrzahl von voneinander beabstandeten Kontaktpunkten 110_1 bis 110_m (m = 4) der Hubstruktur 104 verbunden sein.

Wie in Fig. 1b beispielhaft zu erkennen ist, kann jeder der zumindest zwei piezoelektrischen Aktuatoren 106_1 bis 106_n (n = 2) über zumindest zwei voneinander beabstandete Verbindungselemente 108_1 bis 108_m (m = 4) mit zumindest zwei voneinander beabstandeten Kontaktpunkten 110_1 bis 110_m (m = 4) der Hubstruktur 104 verbunden sein.

Beispielsweise kann ein erster piezoelektrischer Aktuator 106_1 der zumindest zwei piezoelektrischen Aktuatoren 106_1 bis 106_n (n = 2) über ein erstes Verbindungselement 110_1 der Mehrzahl von Verbindungselementen 110_1 bis 110_m (m = 4) mit einem ersten Kontaktpunkt 110_1 der Mehrzahl von voneinander beabstandeten Kontaktpunkten 110_1 bis 110_m (m = 4) der Hubstruktur 104 verbunden sein, und über ein zweites Verbindungselement 108_2 der Mehrzahl von Verbindungselementen 108_1 bis 108_m (m = 4) mit einem zweiten Kontaktpunkt 110_2 der Mehrzahl von voneinander beabstandeten Kontaktpunkten 110_1 bis 110_m (m = 4) der Hubstruktur 104 verbunden sein.

Genauso kann ein zweiter piezoelektrischer Aktuator 106_2 der zumindest zwei piezoelektrischen Aktuatoren 106_1 bis 106_n (n = 2) über ein drittes Verbindungselement 108_3 der Mehrzahl von voneinander beabstandeten Verbindungselementen 108_1 bis 108_m (m = 4) mit einem dritten Kontaktpunkt der Mehrzahl von voneinander beabstandeten Kontaktpunkten 110_1 bis 110_m (m = 4) der Hubstruktur 104 verbunden sein, und über ein viertes Verbindungselement 108_4 der Mehrzahl von voneinander beabstandeten Verbindungselementen 108_1 bis 108_m (m = 4) mit einem vierten Kontaktpunkt 110_4 der Mehrzahl von voneinander beabstandeten Kontaktpunkten 110_1 bis 110_m (m = 4) der Hubstruktur 104 verbunden sein.

Bei Ausführungsbeispielen kann ein Abstand zwischen der Mehrzahl von voneinander beabstandeten Kontaktpunkten 110_1 bis 110_4 der Hubstruktur maximiert sein, wodurch auch ein Abstand zwischen der Mehrzahl von voneinander beabstandeten Verbindungselementen 108_1 bis 108_m (m = 4) maximiert wird.

Beispielsweise kann hierzu der erste Kontaktpunkt 110_1 in einem ersten äußeren Bereich der Hubstruktur 104 angeordnet sein, während der zweite Kontaktpunkt 110_2 in einem dem ersten äußeren Bereich gegenüberliegenden zweiten äußeren Bereich der Hubstruktur angeordnet sein kann. Genauso kann der dritte Kontaktpunkt 110_3 in dem ersten äußeren Bereich der Hubstruktur 104 angeordnet sein, während der vierte Kontaktpunkt 110_4 in dem zweiten äußeren Bereich der Hubstruktur 104 angeordnet sein kann.

Wie in Fig. 1b zu erkennen ist, kann die Mehrzahl von voneinander beabstandeten Verbindungselementen 108_1 bis 108_m (m = 4) mit einer Mehrzahl von voneinander beabstandeten Kontaktpunkten 112_1 bis 112_m (m = 4) der zumindest zwei piezoelektrischen Aktuatoren 106_1 bis 106_n (n = 2) verbunden sein. Abstände zwischen der Mehrzahl von voneinander beabstandeten Kontaktpunkten 112_1 bis 112_m der Hubstruktur können dabei ebenfalls maximiert sein, wie in Fig. 1b zu erkennen ist.

Beispielsweise kann ein erster Kontaktpunkt 112_1 der Mehrzahl von voneinander beabstandeten Kontaktpunkten 112_1 bis 112_m (m = 4) des ersten piezoelektrischen Aktuators 106_1 in einem ersten äußeren Bereich des ersten piezoelektrischen Aktuators 106_1 angeordnet sein, während ein zweiter Kontaktpunkt 112_2 der Mehrzahl von voneinander beabstandeten Kontaktpunkten 112_1 bis 112_m (m = 4) in einem dem ersten äußeren Bereich gegenüberliegenden zweiten äußeren Bereich des ersten piezoelektrischen Aktuators 106_1 angeordnet sein kann. Ein dritter Kontaktpunkt 112_3 der Mehrzahl von voneinander beabstandeten Kontaktpunkten 112_1 bis 112_m (m = 4) des zweiten piezoelektrischen Aktuators 106_2 kann in einem ersten äußeren Bereich des zweiten piezoelektrischen Aktuators 106_2 angeordnet sein, während ein vierter Kontaktpunkt 112_4 der Mehrzahl von voneinander beabstandeten Kontaktpunkten 112_1 bis 112_m (m = 4) in einem dem ersten äußeren Bereich gegenüberliegenden zweiten äußeren Bereich des zweiten piezoelektrischen Aktuators 106_2 angeordnet sein kann.

Das in den Fig. 1a und 1b gezeigte MEMS 100 weist beispielhaft vier voneinander beabstandete Verbindungselemente 108_1 bis 108_m (m = 4) auf, die mit vier voneinander beabstandeten Kontaktpunkten 110_1 bis 110_m (m = 4) der Hubstruktur 104 verbunden sind. Die Erfindung ist jedoch nicht auf solche Ausführungsbeispiele beschränkt. Vielmehr kann das MEMS 100 bis zu m voneinander beabstandete Verbindungselemente 108_1 bis 108_m aufweisen, die mit bis zu m voneinander beabstandeten Kontaktpunkten 110_1 bis 110_m der Hubstruktur 104 verbunden sind, wobei m eine natürliche Zahl größer gleich vier ist, m ≥ 4. Hieraus folgt jedoch nicht, dass jeder der zumindest zwei piezoelektrischen Aktuatoren 106_1 bis 106_n über zumindest zwei Verbindungselemente mit der Hubstruktur 104 verbunden sein muss. Beispielsweise kann das MEMS 100 auch vier piezoelektrische Aktuatoren 106_1 bis 106_n (n = 4) aufweisen, wobei jeder der vier piezoelektrischen Aktuatoren 106_1 bis 106_n (n = 4) über jeweils ein (einziges) Verbindungselement mit der Hubstruktur 104 verbunden ist.

Wie in Fig. 1a und 1b zu erkennen ist, kann die Hubstruktur 104 symmetrisch sein, wobei die zumindest zwei piezoelektrischen Aktuatoren 106_1 bis 106_n (n = 2) symmetrisch zu einem Schwerpunkt 120 der Hubstruktur 104 angeordnet sein können. Dabei können die Mehrzahl von voneinander beabstandeten Kontaktpunkten 110_1 bis 110_m (m = 4) ebenfalls symmetrisch zu dem Schwerpunkt 120 der Hubstruktur 104 angeordnet sein. Genauso können die Mehrzahl von voneinander beabstandeten Kontaktpunkten 112_1 bis 112_m (m = 4) der zumindest zwei piezoelektrischen Aktuatoren 106_1 bis 106_n (n = 2) symmetrisch zu dem Schwerpunkt 120 der Hubstruktur 104 angeordnet sein.

Wie bereits erwähnt, ist die Membran 102 bei Ausführungsbeispielen mit der Hubstruktur 104 gekoppelt. Die Membran 102 kann ferner in einem äußeren Bereich 118, z.B. in einem Halbleitersubstrat, wie z.B. einem Siliziumhalbleitersubstrat, eingespannt sein. Die Membran 102 kann parallel zu einer ersten Oberfläche 122 und/oder einer zweiten Oberfläche 124 des MEMS 100 verlaufen, wobei die Membran 102 ausgebildet sein kann, um bei einer bestimmungsgemäßen Verwendung des MEMS 100 die erste Oberfläche 122 und die zweite Oberfläche 124 des MEMS 100, insbesondere fluidisch oder gasförmig, voneinander zu trennen.

Die Ebene, in der die zumindest zwei piezoelektrischen Aktuatoren 106_1 und 106_n (n = 2) in einer Ruheposition angeordnet sind, könnten dabei parallel zu der ersten und/oder zweiten Oberfläche 122 und 124 des MEMS 100 verlaufen.

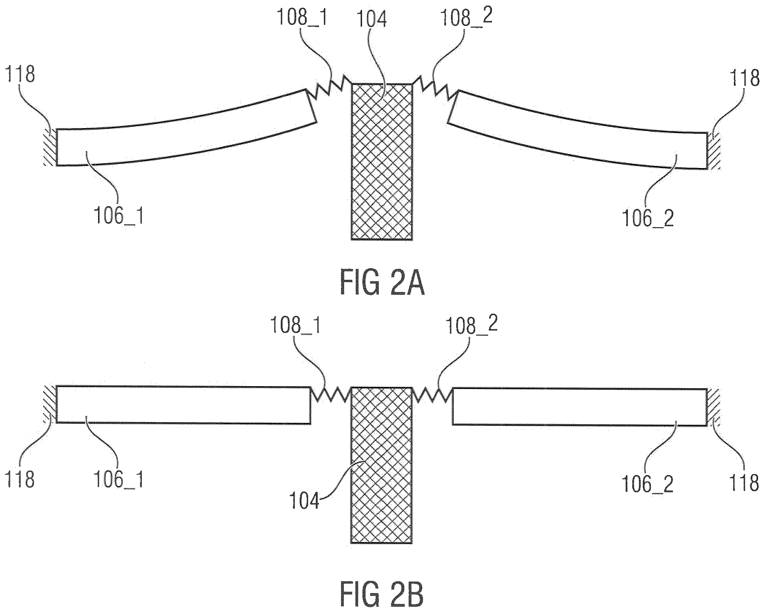

Im Folgenden werden Ausführungsbeispiele des MEMS 100 anhand der Fig. 2 bis 16 näher erläutert. Die nachfolgende Beschreibung ist jedoch genauso auf das in Fig. 1a und 1b gezeigte MEMS 100 anwendbar. Genauso sind Merkmale, die in Bezug auf das in den Fig. 1a und 1b gezeigte MEMS 100 beschrieben wurden, auf die nachfolgenden Ausführungsbeispiele anwendbar.

Die nachfolgenden Ausführungsbeispiele beschreiben dabei ein Konzept und einen Aufbau eines Mikroaktuators für große Hübe und Kräfte, der eine hohe Effizienz aufweist und mit Verfahren der Silizium-Mikrosystemtechnik gefertigt werden kann. Der Aktuator kann beispielsweise für einen Lautsprecher verwendet werden. Der entscheidende Vorteil von Chip-basierten Lautsprechern gegenüber konventionellen Lautsprechern ist die Möglichkeit, komplexe und hochpräzise Geometrien herzustellen und damit neue Schallerzeugungskonzepte zu realisieren. Die MEMS-Aktuatoren können zudem durch Integration einer Positionssensorik geregelt betrieben werden.

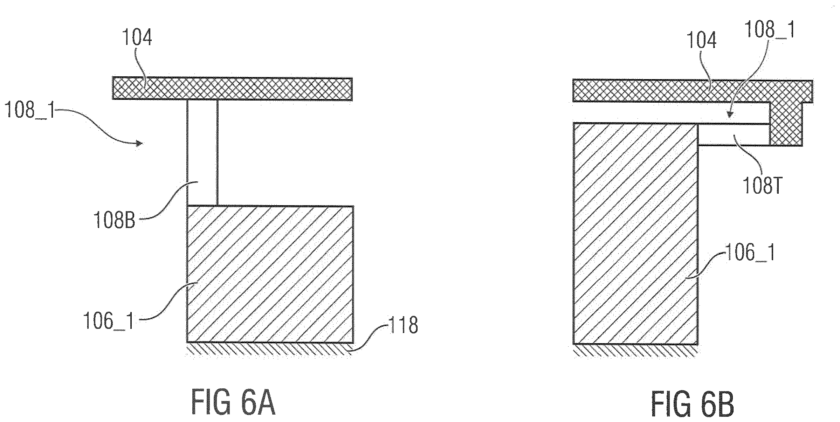

Für die Realisierung von hohen Kräften und Hüben schaffen Ausführungsbeispiele ein MEMS 100, welches auf effizient angeordneten Aktuatorelementen basiert, die über geeignete Verbindungselemente (siehe Fig. 6a bis 6f) mit einem als starr angenommenen Hubkörper 104, der als Rahmenstruktur ausgebildet sein kann, verbunden sind (siehe Fig. 2a und 2b). Die Aktuatorelemente 106_1 bis 106_n können gleichzeitig angesteuert werden, so dass der Rahmen 104 parallel (zu einer Richtung der Hubbewegung, die senkrecht auf einer Ebene der Aktuatorelemente 106_1 bis 106_n steht), d.h. möglichst ohne Verkippung aus der Ebene bewegt wird.

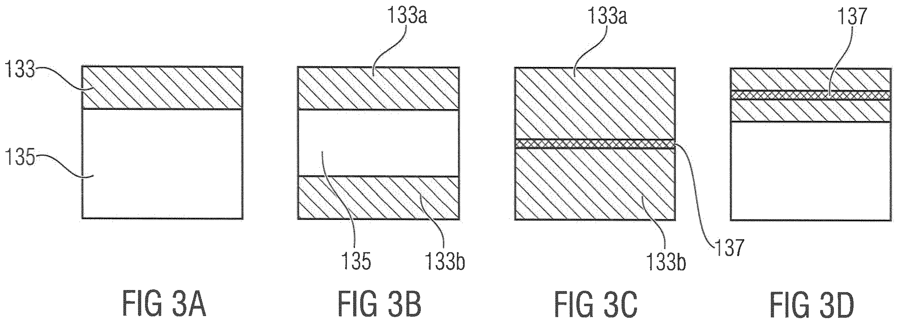

Fig. 2a zeigt eine schematische Querschnittsansicht des MEMS 100 im aktivierten Zustand, während Fig. 1b eine schematische Querschnittsansicht des in Fig. 2a gezeigten MEMS 100 (Aktuatoranordnung) im Ruhezustand zeigt. Bei den Aktuatoren 106_1 und 106_n (n = 2) handelt es sich um einseitig eingespannte Biegebalken (welche z.B. in einem äußeren Bereich in einer Einspannung 118, z.B. einem Rahmen, wie z.B. eine Siliziumrahmen, eingespannt sein können), und welche gemäß Fig. 3a bis 3d mindestens zwei Schichten aufweisen, von denen wenigstens eine piezoelektrisch ist. Fig. 3a bis 3d zeigen dabei schematische Querschnitte möglicher Aktuatorelemente. Im Detail, Unimorph mit einer piezoelektrischen Funktionsschicht 133 (und einer passiven Schicht 135) in Fig. 3a, symmetrisch und Bimorph mit zwei piezoelektrischen Schichten 133a und 133b (und einer dazwischen angeordneten passiven Schicht 135) in Fig. 3b, symmetrisch Bimorph mit einer dünnen leitfähigen Trennschicht 137 zwischen zwei piezoelektrischen Schichten 133a und 133b in Fig. 3c, und asymmetrisch Bimorph mit zwei mittels einer Trennschicht 137 separierter piezoelektrischer Schichten 133a und 133b (auf einer passiven Schicht 135) in Fig. 3d.

Zur Kontaktierung können die piezoelektrischen Schichten mit entsprechenden Elektroden versehen werden, welche entweder als flächige oder interdigitale Elektroden oder einer Kombination aus flächigen und interdigitalen Elektroden ausgeführt sein können. Neben piezoelektrisch aktiven Schichten können die Aktuatorelemente eine oder mehrere passive oder piezoelektrisch inaktive Funktionsschichten aufweisen.

Durch Anlegen einer elektrischen Spannung verformt sich das piezoelektrische Material und ruft eine Verbiegung der einzelnen Aktuatorelemente 106_1 bis 106_n hervor, über die der Hubkörper bzw. die Hubstruktur 104 nach oben oder unten aus der Ebene bewegt wird. Während sich hohe Auslenkungen prinzipiell nur über möglichst lange und dünnschichtige Aktuatoren realisieren lassen, erfordern Aktuatoren für hohe Kräfte eher kurze Längen. Letzteres ist darauf zurückzuführen, dass lange Aktuatoren zu geringe Federsteifigkeiten aufweisen um hohe Kräfte zu generieren. Zur Überwindung dieser gegensätzlichen Anforderungen basieren die vorgeschlagenen Designkonzepte auf mehreren Aktuatoren 106_1 bis 106_n, welche aufgrund ihrer Längen hohe Auslenkungen erzielen, bedingt durch ihre Anzahl in Summe aber ebenfalls hohe Kräfte bereitstellen können. Somit lässt sich der mögliche Hub des Hubkörpers 104 primär über die Länge der Aktuatoren 106_1 bis 106_n definieren, während sich die erzielbare Kraft über die Breite und Anzahl der Aktuatoren 106_1 bis 106_n skalieren lässt.

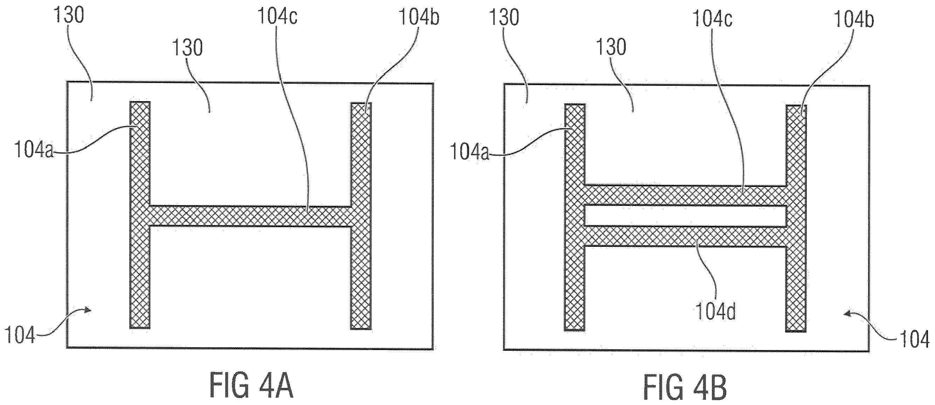

Fig. 4a bis 4f zeigen schematische Draufsichten sechs verschiedener Ausführungsbeispiele der Hubstruktur 104 des MEMS 100.

Fig. 4a zeigt dabei eine Hubstruktur 104, die in einer Ebene, die senkrecht zu der Richtung der Hubbewegung der Hubstruktur 104 verläuft, H-förmig ist. Beispielsweise kann die Hubstruktur 104 zumindest drei Abschnitte 104a bis 104c aufweisen, die H-förmig angeordnet sind, so dass die Hubstruktur 104 in der Schnittebene, die senkrecht zu der Hubbewegungsrichtung der Hubstruktur verläuft, H-förmig ist. Die drei Abschnitte 104a bis 104c können dabei, wie in Fig. 4a zu erkennen ist, einen (zusammenhängenden) Hubkörper bilden.

Die Hubstruktur 104, oder mit anderen Worten, die Abschnitte 104a bis 104c können dabei eine Fläche aufspannen, die zumindest 30% (oder 80%, 70%, 60%, 50% oder 40%) einer Fläche der Membran 102 entspricht.

Dabei kann die Hubstruktur 104 derart ausgebildet sein, dass die Hubstruktur 104 zumindest über den ersten Abschnitt 104a und den zweiten Abschnitt 104b (und optional über den dritten Abschnitt 104c) mit der Membran gekoppelt ist. Die Stirnseiten des ersten Abschnitts 104a und des zweiten Abschnitts 104b bilden somit eine Mehrzahl von verteilt angeordneten Bereichen, über die die Hubstruktur 104 mit der Membran 102 gekoppelt ist.

Natürlich kann die Hubstruktur 104 auch derart ausgebildet sein, dass die Hubstruktur 104 (punktförmig) über eine Mehrzahl von verteilt angeordneten Bereichen mit der Membran 102 gekoppelt ist. Die Mehrzahl von verteilt angeordneten Bereichen können beispielsweise Bereiche des ersten Abschnitts 104a und des zweiten Abschnitts 104b (und optional des dritten Abschnitts 104c) sein.

Ferner ist es auch möglich, dass zumindest der erste Abschnitt 104a und der zweite Abschnitt 104b (und optional der dritte Abschnitt 104c) jeweils über einen Abstandshalter, der querschnittsflächenmäßig kleiner oder größer sein kann als der jeweilige Abschnitt 104a und 104b, mit der Membran gekoppelt ist. In diesem Fall bilden die Abstandshalter eine Mehrzahl von verteilt angeordneten Bereichen, über die die Hubstruktur 104 mit der Membran 102 gekoppelt ist.

Die Mehrzahl von verteilt angeordneten Bereichen (z.B. Stirnseiten oder punktförmige Bereiche der Abschnitte 104a und 104b) können dabei entlang von Geraden angeordnet sein, entlang derer die Hubstruktur 104 mit der Membran 102 gekoppelt ist. In Fig. 4a sind diese zwei Geraden (definiert durch die Abschnitte 104a und 104b) parallel zueinander angeordnet. Jedoch ist es natürlich auch denkbar, dass diese zwei Geraden sich in zumindest einem Punkt schneiden, d.h. nur teilweise voneinander beabstandet sind, was beispielsweise durch eine V- oder L-förmige Struktur erreicht werden kann, oder durch eine Zusammensetzung mehrerer Strukturen, z.B. I-förmiger und L-förmiger Strukturen zu einer H-Struktur.

Da insbesondere die Kraft stark von der Aktuatorfläche abhängt, verfügen die in den Fig. 4a bis 4f gezeigten Designs über einen Hubkörper 104, der so ausgelegt ist, dass er eine möglichst geringe Fläche einnimmt, gleichzeitig aber über eine ausreichende Steifigkeit verfügt, die eine nennenswerte Verformung des Hubkörpers unterbindet. Der Hubkörper 104 kann als verzweigte, zu den Seiten hin offene Rahmenstruktur ausgebildet sein, so dass die Aktuatorelemente zwischen oder neben den Balken des Rahmens angeordnet werden können und den Rahmen dort angreifen können. Durch die reduzierte Fläche steht der Großteil der aktiven Fläche 130 (vorzugsweise rechteckige Fläche, die die beweglichen Elemente Aktuator, Hubkörper u. Verbindungselemente einnimmt) für die Aktuatoren 106_1 bis 106_n zur Verfügung. Im Hinblick auf eine möglichst effiziente Aktuatoranordnung kann der Hubkörper 104 darüber hinaus so ausgelegt sein, dass die Verbindungselemente 108_1 bis 108_m zwischen Aktuator und Hubkörper 104 einen möglichst großen Abstand zum Schwerpunkt des Hubkörpers 104 aufweisen. Hierdurch lassen sich ungewollte Kippmoden relativ zur gewollten Hubmode im Frequenzbereich nach oben verschieben, wodurch parasitäre Schwingungen im Betrieb reduziert werden können.

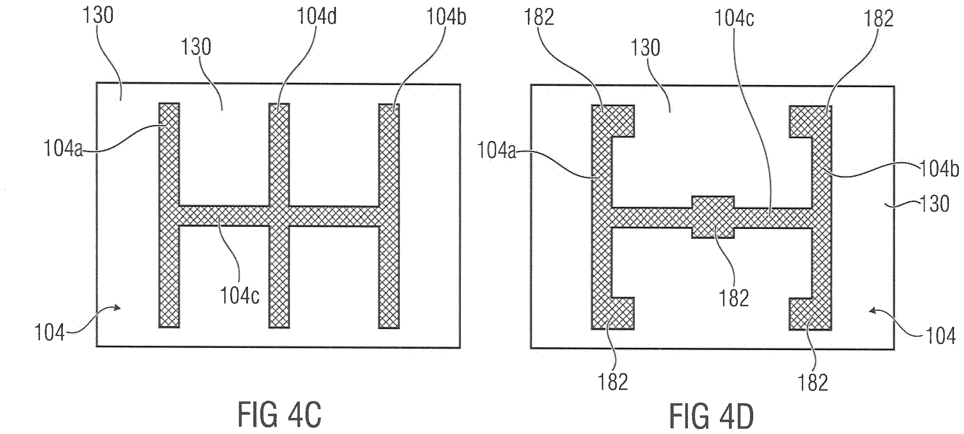

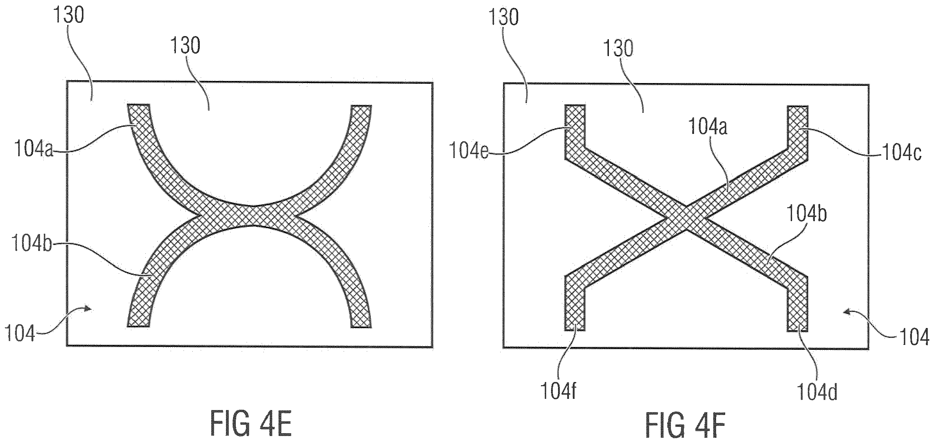

Fig. 4a bis 4f zeigen dabei schematische Draufsichten von Beispielen unterschiedlicher Formen des verzweigten starren Hubkörpers 104. Im Detail, ein Hubkörper mit drei miteinander verbundenen Balkenelementen 104a bis 104c in Fig. 4a, ein Hubkörper mit zusätzlichen Streben (oder Balken) 104d in Fig. 4b und 4c, ein Hubkörper mit lokalen Verbreitungen 182 in Fig. 4d, ein Hubkörper 104 mit Rundungen in Fig. 4e und ein Hubkörper 104 mit diagonalen Elementen 104c bis 104f in Fig. 4f.

Wie in den Fig. 4a bis 4f zu erkennen ist, kann der Hubkörper 104 beispielhaft aus starren Balkenelementen zusammengesetzt sein.

Beispielsweise kann der Hubkörper 104 mindestens zwei Balkenelemente 104a und 104b aufweisen, welche direkt oder über ein drittes Balkenelement 104c miteinander verbunden sind (siehe Fig. 4a). Ferner kann der Hubkörper 104 zusätzliche horizontal angeordnete Balkenelemente 104d aufweisen (siehe Fig. 4b), welche unterschiedliche Längen aufweisen können und durch Streben untereinander verbunden sein können. Des Weiteren kann der Hubkörper 104 zusätzliche senkrecht angeordnete Balkenelemente 104d aufweisen (siehe Fig. 4c), deren Länge identisch oder verschieden zu anderen horizontalen Elementen sein kann. Ferner kann der Hubkörper 104 lokale Verbreiterungen 182 oder Platten (z.B. zur Bereitstellung von Montageflächen oder Positionierung von Verbindungselementen) aufweisen (siehe Fig. 4d). Darüber hinaus kann der Hubkörper 104 diagonal angeordnete Balkenelemente und/oder abgerundete Konturen aufweisen. Der Hubkörper 104 kann ein quadratisches, rechteckiges oder trapezförmiges Querschnittsprofil aufweisen. Ferner kann der Hubkörper eine zentrierte Ausrichtung innerhalb der aktiven Fläche 130 aufweisen.

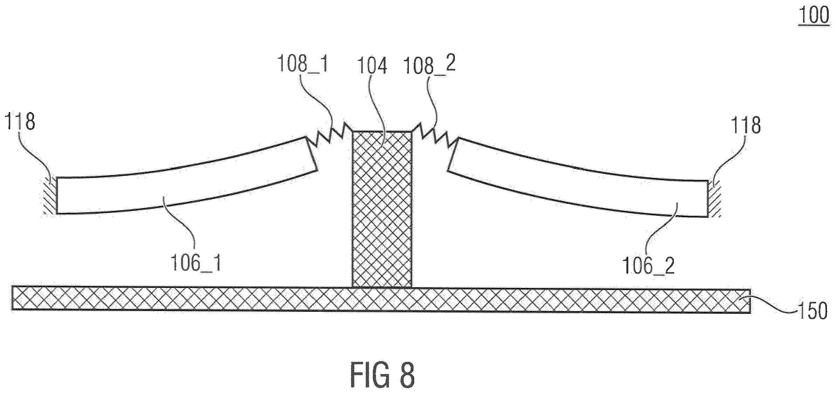

Die in Fig. 4a bis 4f gezeigten Hubstrukturen 104 weisen jeweils einen (zusammenhängen) Hubkörper auf. Die Erfindung ist jedoch nicht auf solche Ausführungsbeispiele beschränkt. Vielmehr kann die Hubstruktur 104 bei Ausführungsbeispielen auch zwei oder mehr Hubkörper aufweisen. Die Hubkörper können dabei beispielsweise über einen Streifen oder einen erweiterten Hubkörper (vgl. Fig. 8) miteinander gekoppelt oder verbunden sein.

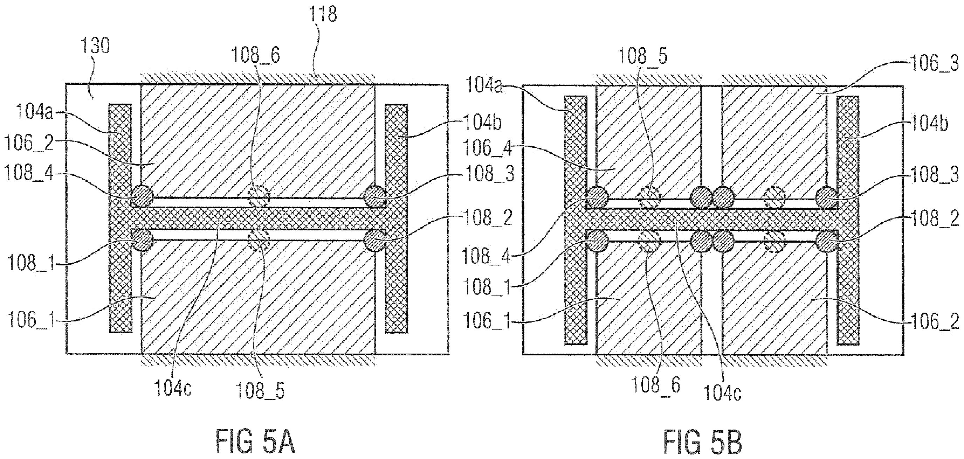

Fig. 5a bis 5h zeigen schematische Draufsichten acht verschiedener Ausführungsbeispiele von Anordnungen der piezoelektrischen Aktuatoren 106_1 bis 106_n bezüglich der Hubstruktur 104 des MEMS, wobei in den Fig. 5a bis 5h die Membran 102 jeweils nicht dargestellt ist, um die Sicht auf die Hubstruktur 104 und die zumindest zwei piezoelektrische Aktuatoren 106_1 bis 106_n nicht zu beeinträchtigen.

In den in Fig. 5a bis 5h gezeigten Ausführungsbeispielen weist die Hubstruktur 104 zumindest drei Abschnitte 104a bis 104c auf, die angeordnet sind, um eine H-förmige Hubstruktur 104 zu bilden, so dass die Hubstruktur 104 in einer Schnittebene, die senkrecht zu der Richtung 114 der Hubbewegung der Hubstruktur 104 verläuft, H-förmig ist (analog zu Fig. 4a).

Dabei sind der erste Abschnitt 104a und der zweite Abschnitt 104b parallel zueinander angeordnet, während der dritte Abschnitt 104c senkrecht zu dem ersten Abschnitt 104a und dem zweiten Abschnitt 104b angeordnet ist, um die H-förmige Hubstruktur zu bilden.

Wie in Fig. 5a zu erkennen ist, kann das MEMS 100 zwei piezoelektrische Aktuatoren 106_1 und 106_n (n = 2) aufweisen, die zumindest teilweise innerhalb der H-förmigen Hubstruktur 104 entlang des dritten Abschnitts 104c der Hubstruktur 104 angeordnet sind und jeweils über zumindest zwei voneinander beabstandete Verbindungselemente 108_1 bis 108_m mit der Hubstruktur 104 verbunden sind.

Im Detail ist in Fig. 5a der erste piezoelektrische Aktuator 106_1 über zwei Verbindungselemente 108_1 und 108_2 der Mehrzahl von voneinander beabstandeten Verbindungselementen 108_1 bis 108_m (m = 4, optional m = 6) mit der Hubstruktur 104 verbunden, wobei der zweite piezoelektrische Aktuator 106_2 über zwei Verbindungselemente 108_3 und 108_4 der Mehrzahl von voneinander beabstandeten Verbindungselementen 108_1 bis 108_m (m = 4, optional m = 6) mit der Hubstruktur 104 verbunden ist.

Ein erster Kontaktpunkt 112_1 der Mehrzahl von voneinander beabstandeten Kontaktpunkten 112_1 bis 112_m (m = 4) des ersten piezoelektrischen Aktuators 106_1 kann in einem ersten äußeren Bereich des ersten piezoelektrischen Aktuators 106_1 angeordnet sein, so dass das erste Verbindungselement 108_1 benachbart zu dem ersten äußeren Bereich angeordnet ist, während ein zweiter Kontaktpunkt 112_2 der Mehrzahl von voneinander beabstandeten Kontaktpunkten 112_1 bis 112_m (m = 4) in einem dem ersten äußeren Bereich gegenüberliegenden zweiten äußeren Bereich des ersten piezoelektrischen Aktuators 106_1 angeordnet sein kann, so dass das zweite Verbindungselement 108_2 benachbart zu dem zweiten äußeren Bereich angeordnet ist. Genauso kann ein dritter Kontaktpunkt 112_3 der Mehrzahl von voneinander beabstandeten Kontaktpunkten 112_1 bis 112_m (m = 4) des zweiten piezoelektrischen Aktuators 106_2 in einem ersten äußeren Bereich des zweiten piezoelektrischen Aktuators 106_2 angeordnet sein, so dass das dritte Verbindungselement 108_1 benachbart zu dem ersten äußeren Bereich angeordnet ist, während ein vierter Kontaktpunkt 112_4 der Mehrzahl von voneinander beabstandeten Kontaktpunkten 112_1 bis 112_m (m = 4) in einem dem ersten äußeren Bereich gegenüberliegenden zweiten äußeren Bereich des zweiten piezoelektrischen Aktuators 106_2 angeordnet sein kann, so dass das vierte Verbindungselement 108_4 benachbart zu dem zweiten äußeren Bereich angeordnet ist. Solche Verbindungselemente werden im Folgenden als äußere Verbindungselemente bzw. außen liegende Verbindungselemente bezeichnet.

Optional kann der erste piezoelektrische Aktuator 106_1 ferner über ein fünftes Verbindungselement 108_5 mit der Hubstruktur verbunden sein, wobei ein fünfter Kontaktpunkt 112_5 der Mehrzahl von voneinander beabstandeten Kontaktpunkten 112_1 bis 112_m (m = 6) des ersten piezoelektrischen Aktuators 106_1 in einem mittigen bzw. zentralen Bereich angeordnet sein kann, so dass das fünfte Verbindungselement 108_5 benachbart zu dem mittigen Bereich angeordnet ist. Genauso kann der zweite piezoelektrische Aktuator 106_2 ferner über ein sechstes Verbindungselement 108_6 mit der Hubstruktur 104 verbunden sein, wobei ein sechster Kontaktpunkt 112_6 der Mehrzahl von voneinander beabstandeten Kontaktpunkten 112_1 bis 112_m (m = 6) des zweiten piezoelektrischen Aktuators 106_2 in einem mittigen bzw. zentralen Bereich angeordnet sein kann, so dass das sechste Verbindungselement 108_6 benachbart zu dem mittigen Bereich angeordnet ist. Solche Verbindungselemente werden im Folgenden als mittige Verbindungselemente bzw. mittig liegende Verbindungselemente bezeichnet.

Fig. 5b zeigt eine schematische Draufsicht eines MEMS 100 mit vier piezoelektrischen Aktuatoren 106_1 bis 106_n (n = 4), die zumindest teilweise innerhalb der H-förmigen Hubstruktur 104 angeordnet sind, wobei zwei piezoelektrische Aktuatoren 106_1 und 106_2 der vier piezoelektrischen Aktuatoren 106_1 bis 106_n (n = 4) entlang einer ersten Seite des dritten Abschnitts 104c angeordnet sind, wobei zwei weitere piezoelektrische Aktuatoren 106_3 und 106_4 der vier piezoelektrischen Aktuatoren 106_1 bis 106_n (n =4) entlang einer der ersten Seite gegenüberliegenden zweiten Seite des dritten Abschnitts 104c angeordnet sind. Die vier piezoelektrischen Aktuatoren 106_1 bis 106_n (n = 4) sind dabei jeweils über zwei außen liegende Verbindungselemente 108_1 bis 108_4 und optional über jeweils ein mittig liegendes Verbindungselement 108_5 und 108_6 mit dem dritten Abschnitt 104c der Hubstruktur 104 verbunden.

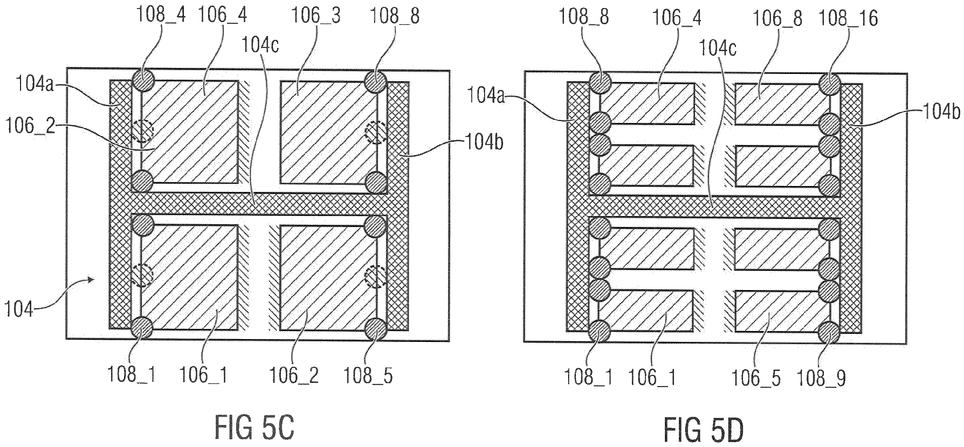

Fig. 5c zeigt ebenfalls eine schematische Draufsicht eines MEMS 100 mit vier piezoelektrischen Aktuatoren 106_1 bis 106_n (n = 4), wobei zwei piezoelektrische Aktuatoren 106_1 und 106_4 der vier piezoelektrischen Aktuatoren 106_1 bis 106_n (n = 4) mit dem ersten Abschnitt 104a über jeweils zwei außen liegende Verbindungselemente 108_1 bis 108_4 (und optional über ein weiteres mittig liegendes Verbindungselement) mit der Hubstruktur 104 verbunden sind, wobei zwei weitere piezoelektrische Aktuatoren 106_2 und 106_3 der vier piezoelektrischen Aktuatoren 106_1 bis 106_n (n = 4) über jeweils zwei außen liegende Verbindungselemente 108_5 bis 108_8 (und optional über ein weiteres mittig liegendes Verbindungselement) mit dem zweiten Abschnitt 104b der Hubstruktur 104 verbunden ist.

Fig. 5d zeigt eine schematische Draufsicht eines MEMS 100 mit acht piezoelektrischen Aktuatoren 106_1 bis 106_n (n = 8), die zumindest teilweise innerhalb der H-förmigen Hubstruktur 104 angeordnet sind, so dass vier piezoelektrische Aktuatoren 106_1 bis 106_4 der acht piezoelektrischen Aktuatoren 106_1 bis 106_n (n = 8) über jeweils zwei außen liegende Verbindungselemente 108_1 bis 108_8 mit dem ersten Abschnitt 104a der Hubstruktur 104 verbunden sind, wobei vier weitere piezoelektrischen Aktuatoren 106_5 bis 106_8 der acht piezoelektrischen Aktuatoren 106_1 bis 106_n (n = 8) über jeweils zwei außen liegende Verbindungselemente 108_9 bis 108_ 16mit dem zweiten Abschnitt 104b der Hubstruktur 104 verbunden sind.

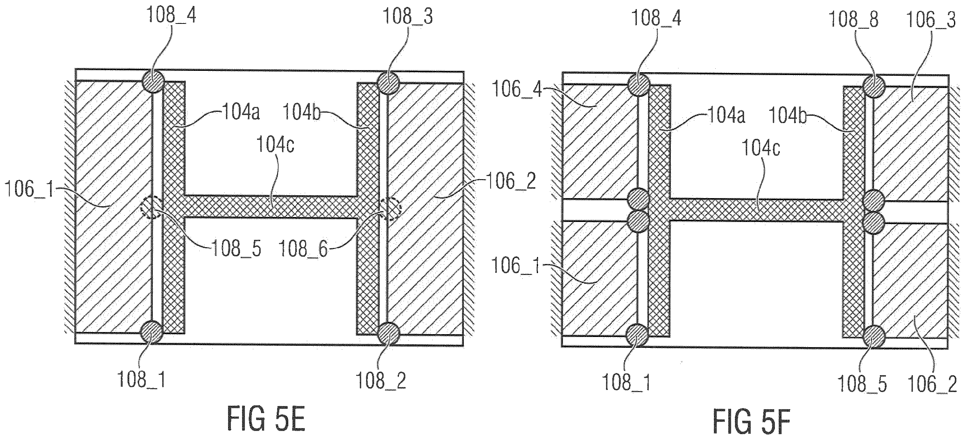

Fig. 5e zeigt eine schematische Draufsicht eines MEMS 100 mit zwei piezoelektrischen Aktuatoren 106_1 und 106_n (n = 2), die außerhalb der H-förmigen Hubstruktur 104 angeordnet sind. Dabei ist der erste piezoelektrische Aktuator 106_1 entlang des ersten Abschnitts 104a der Hubstruktur 104 angeordnet, wobei der zweite piezoelektrische Aktuator 106_2 entlang des zweiten Abschnitts 104b der Hubstruktur 104 angeordnet ist. Der erste piezoelektrische Aktuator 106_1 ist über zwei außen liegende Verbindungselemente 108_1 und 108_4 mit dem ersten Abschnitt 104a der Hubstruktur 104 verbunden, während der zweite piezoelektrische Aktuator 106_2 über zwei außen liegende Verbindungselemente 108_2 und 108_3 mit dem zweiten Abschnitt 104b der Hubstruktur 104 verbunden ist. Optional können der erste piezoelektrische Aktuator 106_1 und der zweite piezoelektrische Aktuator 106_2 jeweils über ein mittig liegendes Verbindungselement 108_5 und 108_6 mit dem jeweiligen Abschnitt 104a und 104b der Hubstruktur 104 verbunden sein.

Fig. 5f zeigt eine schematische Draufsicht eines MEMS 100 mit vier piezoelektrischen Aktuatoren 106_1 bis 106_n (n = 4), die außerhalb der H-förmigen Hubstruktur 104 angeordnet sind. Der erste und vierte piezoelektrische Aktuator 106_1 und 106_4 sind entlang des ersten Abschnitts 104a der Hubstruktur 104 angeordnet und mit diesem über jeweils zwei außen liegende Verbindungselemente 108_1 bis 108_4 verbunden. Der zweite piezoelektrische Aktuator 106_2 und der dritte piezoelektrische Aktuator 106_3 sind dabei entlang des zweiten Abschnitts 104b der Hubstruktur 104 angeordnet und mit diesem über jeweils zwei außen liegende Verbindungselemente 108_5 bis 108_8 verbunden.

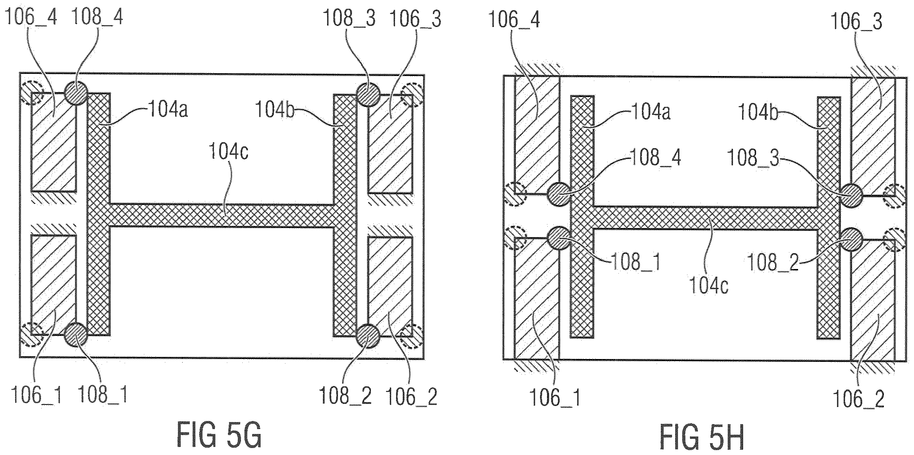

Fig. 5g und 5h zeigen jeweils ein MEMS 100 mit vier piezoelektrischen Aktuatoren 106_1 bis 106_n (n = 4), die außerhalb der H-förmigen Hubstruktur 104 angeordnet sind. Die vier piezoelektrischen Aktuatoren 106_1 bis 106_4 sind jeweils über ein Verbindungselement 108_1 bis 108_4 mit dem jeweiligen Abschnitt 104a oder 104b der Hubstruktur 104 verbunden. Der Unterschied zwischen den Fig. 5g und 5h liegt darin, dass die vier piezoelektrischen Aktuatoren 106_1 bis 106_4 in der Fig. 5g so angeordnet sind, dass die Kontaktpunkte zwischen der Hubstruktur 104 und den Verbindungselementen 108_1 bis 108_4 an äußeren Enden der Abschnitte 104a und 104b angeordnet sind, während in Fig. 5h die vier piezoelektrischen Aktuatoren 106_1 bis 106_4 so angeordnet sind, dass die Kontaktpunkte zwischen den Verbindungselementen 108_1 bis 108_4 und der Hubstruktur 104 benachbart zu einer projizierten Verlängerung des dritten Abschnitts 104c angeordnet sind.

Fig. 5a bis 5h veranschaulichen somit unterschiedliche Teil-Aktuatorkonfigurationen am Beispiel des Hubköpers aus Fig. 4a. Je nach Anordnung handelt es sich um einseitig eingespannte Aktuatoren, welche über mindestens ein, jedoch vorzugsweise zwei oder mehr Verbindungselemente 108_1 bis 108_m mit dem Hubkörper 104 verbunden sind und diesen aus der Ebene bewegen. Zur Erzielung möglichst hoher Kräfte sind die Aktuatoren 106_1 bis 106_n vorzugsweise breit ausgelegt, wodurch es aufgrund des in der Ebene wirkenden piezoelektrischen Effekts zu einer Querverwölbung kommt. Letzteres äußert sich darin, dass die äußeren Ecken am freien Ende des Aktuators die höchste Auslenkung aufweisen und somit die optimale Position für die Verbindungselemente darstellen. Insbesondere bei sehr breiten Aktuatoren kann das Einfügen weiterer Verbindungselemente (in Fig. 5a bis 5h als optionale Verbindungselemente bezeichnet) vorteilhaft sein um höhere Kräfte zu erzielen und die Hubmode im Frequenzbereich nach oben zu verschieben. Abhängig von der Geometrie des Hubkörpers 104 kann darüber hinaus auch eine Unterteilung einzelner Aktuatoren in mehrere, vorzugsweise parallel zueinander angeordnete, Aktuatoren sinnvoll sein (z. B. Fig. 4c in Kombination mit Fig. 5b). Im Hinblick auf eine möglichst gute Flächenausnutzung zur Realisierung hoher Kräfte lassen sich die in Fig. 5a bis 5h dargestellten Teil-Konfigurationen beliebig miteinander kombinieren.

Es sei darauf hingewiesen, dass es ich bei den in Fig. 5a-h gezeigten unterschiedlichen Aktuatorkonfigurationen am Beispiel des Hubkörpers 104 aus Fig. 4a um Teil-Aktuatorkonfigurationen handelt, die sich beliebig miteinander kombinieren lassen.

Bei Ausführungsbeispielen kann eine Querschnittsfläche der Hubstruktur 104 senkrecht zu einer Richtung 114 der Hubbewegung der Hubstruktur 104 kleiner sein (z.B. um den Faktor zwei (oder drei, vier, fünf oder sechs) kleiner sein) als eine Summe von piezoelektrisch aktiven Aktuatorflächen der zumindest zwei piezoelektrischen Aktuatoren 106_1 bis 106_n.

Die Aktuatorkonfigurationen können somit eine hohe Flächenausnutzung durch Aktuatoren von größer 40% (oder 50%, 60%, 70% oder 80%) der aktiven Fläche 130 aufweisen. Ferner können die Aktuatorkonfigurationen beliebig miteinander kombiniert werden. Ferner können die Aktuatorkonfigurationen zusätzliche Verbindungselemente am freien Ende der einzelnen Aktuatoren aufweisen. Des Weiteren können die Aktuatorkonfigurationen in mehrere schmale Aktuatoren unterteilte Aktuatoren mit zusätzlichen Verbindungselementen aufweisen (siehe Fig. 5b, 5d und 5f). Darüber hinaus können die Aktuatorkonfigurationen Aktuatoren mit trapezförmigen oder gerundeten Formen aufweisen.

Wie bereits in Bezug auf Fig. 4a bis 4f erwähnt wurde, kann die Hubstruktur 104 bei Ausführungsbeispielen auch zwei oder mehr Hubkörper aufweisen, wobei die Hubkörper z.B. über einen steifen erweiterten Hubkörper miteinander gekoppelt werden können. Beispielsweise könnte in Fig. 5e auf den mittleren Balken 104c verzichtet werden, sodass die Hubstruktur 104 zwei voneinander getrennte Hubkörper aufweist, die sich mittels eines erweiterten Hubkörpers (vgl. Fig. 8) miteinander koppeln ließen. Der frei gewordene Bereich ließe sich in diesem Fall effizienter durch andere Aktuatoren nutzen. Darüber hinaus wäre es denkbar mehrere Hubkörper einer Arrayanordnung über einen erweiterten Hubkörper in Verbindung mit Abstandhaltern zu koppeln.

Fig. 6a bis 6f zeigen schematische Draufsichten sechs verschiedener Ausführungsbeispiele der Verbindungselemente des MEMS 100. Im Detail ist in Fig. 6a bis 6f ist jeweils beispielhaft das erste Verbindungselement 108_1 gezeigt, welches den ersten piezoelektrischen Aktuator 106_1 mit der Hubstruktur 104 verbindet. Die nachfolgende Beschreibung ist jedoch genauso auf die anderen Verbindungselemente 108_2 bis 108_m übertragbar.

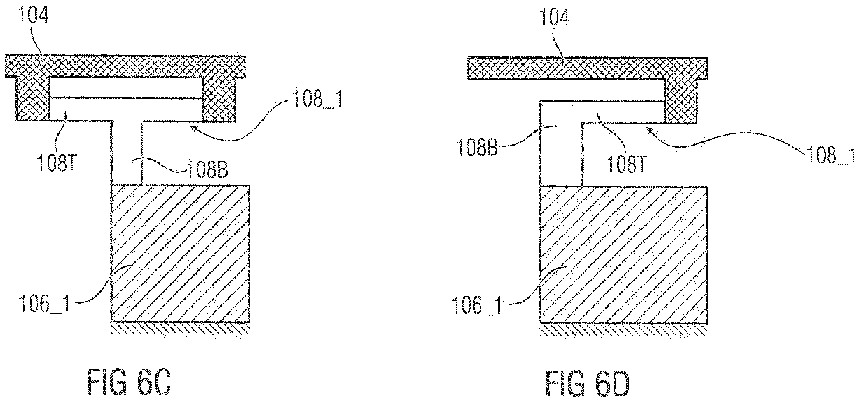

Bei Ausführungsbeispielen kann das Verbindungselemente 108_1 ein Federelement aufweisen. Wie in den Fig. 6a bis 6h zu erkennen ist, kann das Federelement zumindest ein Biegefederelement 108B (siehe Fig. 6a), zumindest ein Torsionsfederelement 108T (siehe Fig. 6b) oder eine Kombination aus zumindest einem Biegefederelement 108B und zumindest einem Torsionsfederelement 108T umfassen (siehe Fig. 6c bis 6f).

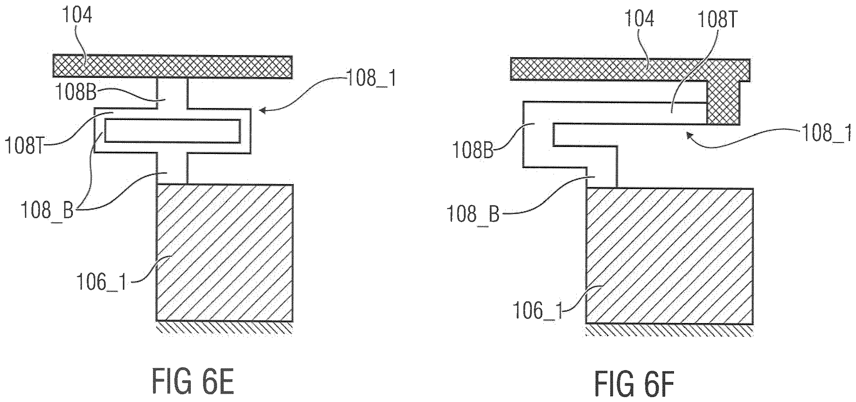

Um eine flexible und gleichzeitig robuste Verbindung zwischen Aktuatoren 106_1 bis 106_n und Hubkörper 104 sicherzustellen, können verschiedene Federgeometrien Verwendung finden. Fig. 6a bis 6f veranschaulichen einige Federanordnungen, welche bei angemessener Dimensionierung zum einen eine ausreichend hohe Flexibilität aufweisen um hohe Auslenkungen zu ermöglichen, zum anderen aber auch eine gute Kraftübertragung zwischen Aktuatoren 106_1 bis 106_n und Hubkörper 104 gewährleisten. Bedingt durch die Tatsache, dass sowohl Biegefedern 108B als auch Torsionsfedern 108T vergleichsweise große Abstände zwischen Aktuator und Hubkörper erfordern (Abstand ≥ Federlänge), empfiehlt sich der Einsatz von kombinierten Federgeometrien. Fig. 6c bis 6f veranschaulichen entsprechende Geometrien, bei denen die effektive Federlänge durch mehrere vorzugsweise senkrecht zueinander angeordnete Elemente deutlich über dem Abstand zwischen Aktuator und Hubkörper liegen kann. Während sich Anordnungen wie Fig. 6d oder Fig. 6f insbesondere für Verbindungselemente eignen, die an äußeren Aktuatorecken angeordnet sind, eignen sich Federn wie in Fig. 6c und Fig. 6e aufgrund ihrer Symmetrie vorwiegend für Verbindungspunkte zwischen den Ecken (siehe optionale Verbindungselemente in Fig. 5a bis 5h).

Es sei darauf hingewiesen, dass bei den in Fig. 6a bis 6f gezeigten schematischen Draufsicht unterschiedlicher Verbindungselemente, die als Hubkörper 104 und Aktuator 106_1 bezeichnete Elemente beispielhaft sind und lediglich Ausschnitte der tatsächlichen Funktionselemente darstellen.

Abgesehen von der Skalierung einzelner Elemente sind folgende Abweichungen von Fig. 6 denkbar. (1) Die in den Fig. 6a bis 6h als Biegefedern bezeichneten Abstandshalter zwischen Aktuator und Torsionsfedern können auch als starre Elemente oder piezoelektrisch aktive Verlängerungen des Aktuators ausgelegt sein. (2) Die in Fig. 6 als lokale Verbreiterungen des Hubkörpers 104 dargestellten Abstandshalter zwischen Federn und Hubkörper 104 können auch als flexible Elemente ausgelegt sein. (3) Alle oder einzelne Federelemente können Rundungen aufweisen. (4) Es können mehrere Federelemente miteinander kombiniert bzw. in mehrfacher Ausführung hintereinander angeordnet sein (Kaskadierung). (5) Die einzelnen Federelemente können Winkel ungleich 90° aufweisen, so dass die Federn sowohl einer Biege- als auch Torsionsbelastung ausgesetzt sind. (6) Alle Federn oder Abstandshalter können auch seitlich an den Aktuatoren befestigt sein (vgl. Fig. 6b). (7) Federn und Abstandshalter können aus denselben oder einzelnen passiven und/oder piezoelektrischen Funktionsschichten bestehen wie die Aktuatoren. Alternativ können auch andere Materialien verwendet werden.

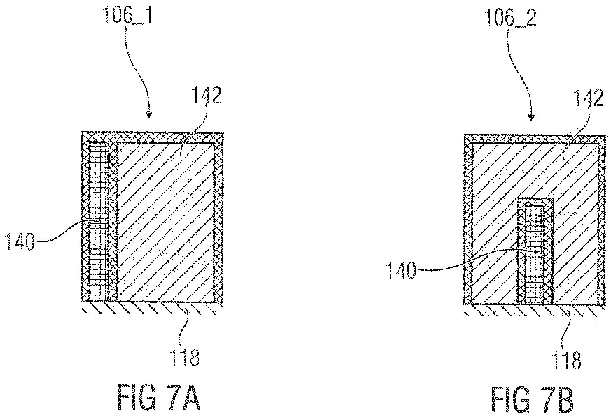

Zur Detektierung der Position der Hubstruktur bzw. des Hubkörpers 104 kann das MEMS 100 zusätzlich zumindest ein Sensorelement aufweisen, wie dies im Folgenden anhand von Fig. 7a und 7b erläutert wird.

Fig. 7a und 7b zeigen schematische Draufsichten zweier Ausführungsbeispiele eines piezoelektrischen Aktuators mit integriertem Positionssensor. Im Detail ist in Fig. 6a und 7b jeweils beispielhaft die Integration des Positionssensors mit dem ersten piezoelektrischen Aktuator 106_1 gezeigt. Die nachfolgende Beschreibung ist jedoch genauso auf die anderen piezoelektrischen Aktuatoren 106_2 bis 106_n anwendbar.

Wie in Fig. 7a zu erkennen ist, können der piezoelektrische Positionssensor und der piezoelektrische Aktuator 106_1 durch eine piezoelektrische Schicht gebildet werden, wobei ein Bereich als Sensor und ein anderer als Aktuator genutzt werden kann. Ferner ist es möglich, dass ein Stapel von zwei piezoelektrischen Schichten verwendet wird, wobei eine oder zwei Schichten zumindest teilweise den zumindest einen piezoelektrischen Sensor 140 bildet, wobei eine andere der zwei Schichten den piezoelektrischen Aktuator 106_1 bildet. Mit anderen Worten, Fig. 7a und 7b zeigen schematische Draufsichten einer (zusammenhängenden) Balkenstruktur mit voneinander getrennter Sensorbereiche 140 und Aktuatorbereiche 142. Natürlich muss nicht die gesamte Schicht für den Sensor genutzt werden. Es wäre auch denkbar, dass ein großer Teil für die Aktorik und nur ein kleiner Bereich für den Sensor verwendet wird.

Um die Verluste an Aktuator-Performance (Auslenkung, Kraft), welche aus dem zusätzlichen Platzbedarf von Sensor- und Verbindungselementen resultieren, möglichst gering zu halten, können die Sensorelektroden auch direkt auf den als Aktuatoren genutzten Balkenstrukturen realisiert werden. Fig. 7a und 7b veranschaulichen zwei Beispiele, bei denen jeweils eine Sensorelektrode (Sensor-Bereich) einen vergleichsweise kleinen Teil der Aktuatorfläche einnimmt. Die Sensorelektroden sind elektrisch von den Aktuatorelektroden isoliert und können sowohl als flächige als auch interdigitale Elektroden ausgeführt sein.

Eine weitere, noch effizientere Möglichkeit besteht in der Nutzung mehrerer piezoelektrischer Schichten (vgl. Fig. 3a bis 3d), wobei eine Schicht zumindest partiell für die Positionsdetektierung verwendet wird. Da sich die Anforderungen für Sensorik und Aktuatorik unterscheiden können, ist auch eine Kombination verschiedener piezoelektrischer Materialien mit unterschiedlichen Eigenschaften denkbar (z. B. PZT für Aktuatorik, AIN für Sensorik). Alternativ zu Anordnungen, bei denen mehrere piezoelektrische Schichten übereinander angeordnet sind (vgl. Fig. 3a bis 3d), können sich die Sensor- sowie Aktuator-Materialien analog zu Fig. 7a und 7b auch nebeneinander befinden.

Aufgrund der Bidirektionalität des piezoelektrischen Effekts können einzelne Aktuatoren auch als Sensorelement verwendet werden. In diesem Fall wird die über den direkten piezoelektrischen Effekt generierte Spannung, welche näherungsweise proportional zur Auslenkung des Hubkörpers 104 ist, über die Aktuator-Elektroden abgegriffen und entsprechend ausgewertet. Damit die Auslenkung möglichst wenig behindert wird, eignen sich insbesondere vergleichsweise lange und schmale Aktuatorelemente. Um einer ungewollten Verkippung des Hubkörpers 104 aufgrund eines asymmetrischen Antriebs vorzubeugen, sollten entsprechende Sensorelemente vorzugsweise jeweils paarweise gegenüber angeordnet sein.

Anstelle des oder zusätzlich zu dem zumindest einen piezoelektrischen Positionssensor kann das MEMS auch zumindest einen piezoresistiven oder einen kapazitiven Positionssensor aufweisen, der ausgebildet ist, um ein von der Auslenkung der Membran abhängiges Sensorsignal bereitzustellen.

Während in Fig. 1a bis 2 und 4a bis 5a ein Hubkörper bzw. eine Hubstruktur 104 mit möglichst geringer Fläche zur Maximierung von Auslenkung und Kraft angestrebt wurde, erfordern viele Anwendungen jedoch einen Hubkörper 104 mit möglichst großer, vorzugsweise durchgehender Fläche. Beispielweise wird dadurch bei fluidischen Anwendungen das verdrängte Gas- oder Flüssigkeitsvolumen vergrößert. Durch Bereitstellung von geeigneten Montageflächen kann der Hubkörper 104 daher so ausgelegt werden, dass ein weiterer, vorzugsweise starrer und großflächiger Körper 150 auf oder unter dem Hubkörper 104 befestigt werden kann, wie dies in Fig. 8 gezeigt ist. Der erweiterte Hubkörper 150 kann eine beliebige Geometrie aufweisen und über die aktive, aus Hubkörper und Federelementen aufgespannte Fläche 130 (vgl. Fig. 4a bis 4h) hinausragen. Fig. 8 veranschaulicht dies anhand einer dünnen Platte 150, die an entsprechenden Auflagepunkten mit dem Hubkörper 104 fest verbunden ist. Beispielsweise kann das MEMS 100 einen durch eine aufgeklebte Platte 150 erweiterten Hubkörper aufweisen.

Fig. 8 zeigt eine schematische Querschnittsansicht des MEMS 100, gemäß einem Ausführungsbeispiel der vorliegenden Erfindung. Das MEMS 100 kann einen erweiterten Hubkörper 150 aufweisen, der mit dem Hubkörper 104 gekoppelt ist. Der erweiterte Hubkörper 150 kann beispielsweise senkrecht zu der Hubbewegungsrichtung 114 des Hubkörpers angeordnet sein und mit einer Stirnseite des Hubkörpers gekoppelt oder verbunden sein.

Da sich Aktuatoren mit hohen Hüben und Kräften insbesondere für die Verdrängung von Gasen und Flüssigkeiten eignen (vgl. technische Anwendungsgebiete weiter unten), kann auch die Integration von flexiblen Membranen sinnvoll sein, wie dies im Folgenden erläutert wird.

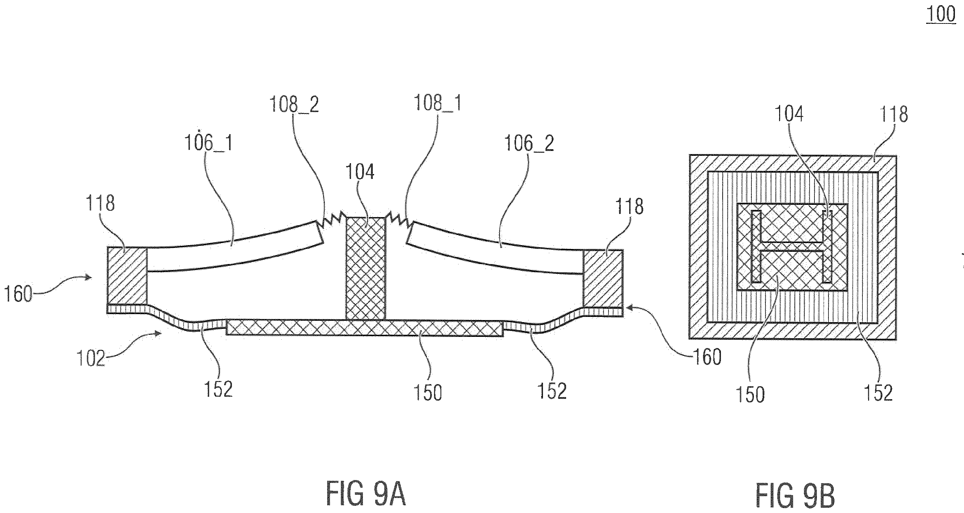

Fig. 9a zeigt eine schematische Querschnittsansicht eines Ausführungsbeispiels des MEMS 100, während Fig. 9b eine schematische Draufsicht des in Fig. 9a gezeigten MEMS 100 zeigt, wobei in Fig. 9b auf die Darstellung der piezoelektrischen Aktuatoren 106_1 und 106_2 und der Verbindungselemente 108_1 und 108_2 verzichtet wurde.

Wie in Fig. 9a und 9b zu erkennen ist, kann die Membran 102 einen starren Bereich 150 und einen flexiblen Bereich 152 aufweisen, wobei die Hubstruktur 104 mit dem starren Bereich 150 der Membran gekoppelt sein kann. Der starre Bereich der Membran 102 kann beispielsweise durch den erweiterten Hubkörper 150 (vgl. Fig. 8) implementiert werden. Die Membran 102 kann in einer Einspannung 118, z.B. ein Rahmen, eingespannt sein.

Fig. 9a und 9b veranschaulicht dabei beispielhaft einen möglichen Aufbau, bei dem Ober- und Unterseite des MEMS 100 mittels einer Membran 102 (abdichtende Membran) vollständig voneinander getrennt sind, sodass das verdrängte Fluid nicht durch Umfließen des Hubkörpers 104 auf die jeweils andere Seite gelangen kann. In der Akustik ist diese Trennung erforderlich um einen akustischen Kurzschluss zu verhindern. Auch bei Mikroventilen und Mikropumpen ist eine fluidische Trennung von Vorder- und Rückseite notwendig.

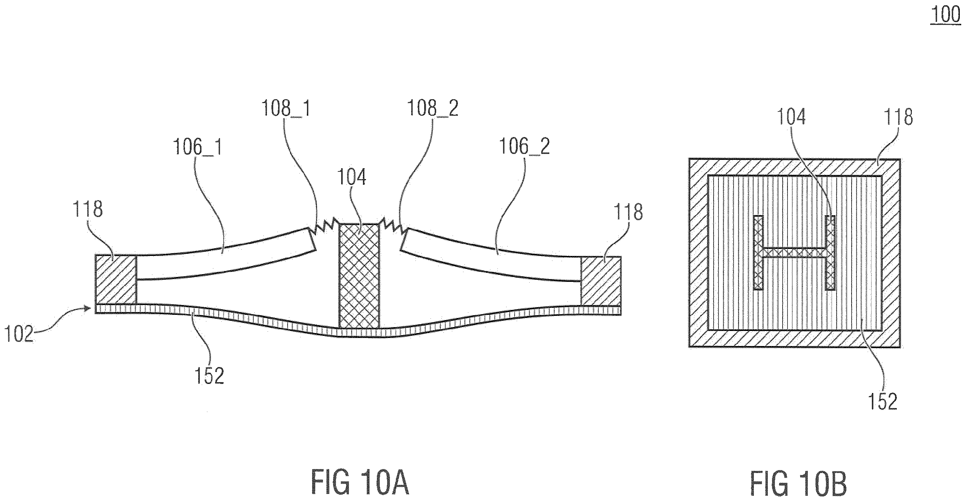

Fig. 10a zeigt eine schematische Querschnittsansicht eines Ausführungsbeispiels des MEMS 100, während Fig. 10b eine schematische Draufsicht des in Fig. 10a gezeigten MEMS 100 zeigt, wobei in Fig. 10b auf die Darstellung der piezoelektrischen Aktuatoren 106_1 und 106_2 und der Verbindungselemente 108_1 und 108_2 verzichtet wurde.

Gemäß Fig. 10a und 10b kann die Membran 102 (abdichtende Membran), die beispielsweise durch einen durchgehenden flexiblen Bereich 152 gebildet ist, auch den gesamten aktiven Bereich 130, welcher von einem starren Rahmen 118 umgeben ist, überspannen, sodass auf einen erweiterten Hubkörper 150 verzichtet werden kann. Unabhängig davon lassen sich die elastischen Membranen entweder durch hybride Integration oder Spin-On-Prozesse (Rotationsbeschichtungsprozess) bzw. Sprühprozesse auf Waferebene realisieren. Je nach Anwendungszweck kann die Membran 102 entweder gespannt oder locker mit wellenförmigem oder gefaltetem Profil ausgeführt sein. Letztere Variante eignet sich insbesondere für Anwendungen, bei denen die Auslenkung des Hubkörpers 104 möglichst wenig durch die Membran 102 beeinträchtigt werden soll.

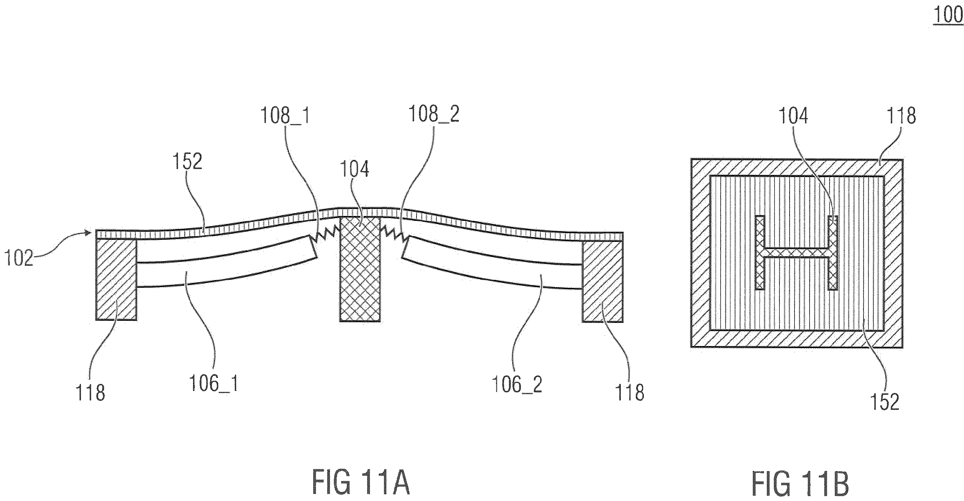

Fig. 11a zeigt eine schematische Querschnittsansicht eines Ausführungsbeispiels des MEMS 100, während Fig. 11b eine schematische Draufsicht des in Fig. 11a gezeigten MEMS 100 zeigt, wobei in Fig. 11b auf die Darstellung der piezoelektrischen Aktuatoren 106_1 und 106_2 und der Verbindungselemente 108_1 und 108_2 verzichtet wurde.

Im Gegensatz zu Fig. 10a und 10b veranschaulicht Fig. 11a und 11b ein Beispiel, bei dem die Membran 102 oberhalb der Aktuatoren 106_1 und 106_2 angeordnet ist. Um einen mechanischen Kontakt mit den Verbindungselementen 108_1 und 108_2 und Aktuatorelementen 106_1 und 106_2 zu vermeiden, ist die Membran 102 mittels Abstandhaltern 160 von der Aktuatorebene beabstandet. Die Aktuatorebene ist dabei die Ebene, die in der die piezoelektrischen Aktuatoren 106_1 und 106_2 in einer Ruheposition, d.h. nicht ausgelenkten Position, angeordnet sind bzw. die die piezoelektrischen Aktuatoren 106_1 bis 106_2 in der Ruheposition aufspannen.

Wie in den Fig. 9a bis 11b schematisch (nicht Maßstabsgetreu) angedeutet ist, kann ein Hebelarm zwischen einem der Kraftangriffspunkte der H-förmigen Hubstruktur 104 auf die Membran 102 und einem nächstliegenden Aufnahmepunkt einer Membranaufhängung 118 (z.B. Rahmen) höchstens halb so groß (d.h. mindestens um einen Faktor 2 (oder z.B. 3, 4 oder 5) kleiner) sein wie ein Hebelarm (z.B. kürzester Abstand zwischen Einspannung 118 und einem der Kontaktpunkte 112_1 bis 112_m des jeweiligen piezoelektrischen Aktuators) der zumindest zwei piezoelektrischen Aktuatoren 106_1 und 106_2.

Zur Veranschaulichung der obigen verallgemeinerten Darstellungen, werden nachfolgend einige konkrete Ausführungsbeispiele vorgestellt. Es handelt sich um Designs auf Basis von Aktuatoren aus piezoelektrischem PZT (Blei-Zirkonat-Titanat), entsprechenden Metall-Elektroden sowie Silizium als passivem Material. Die Designs wurden für MEMS-Lautsprecher konzipiert und mittels FEM-Simulationen optimiert.

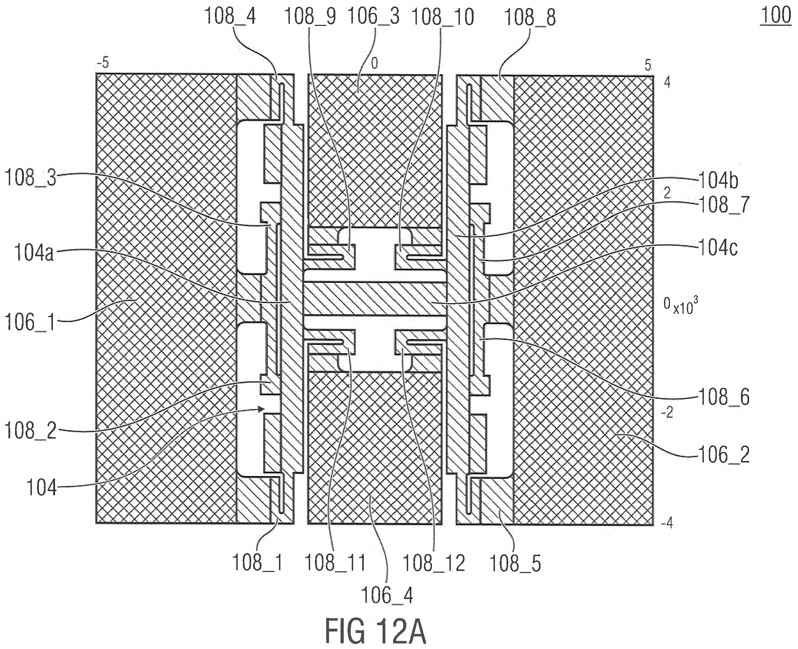

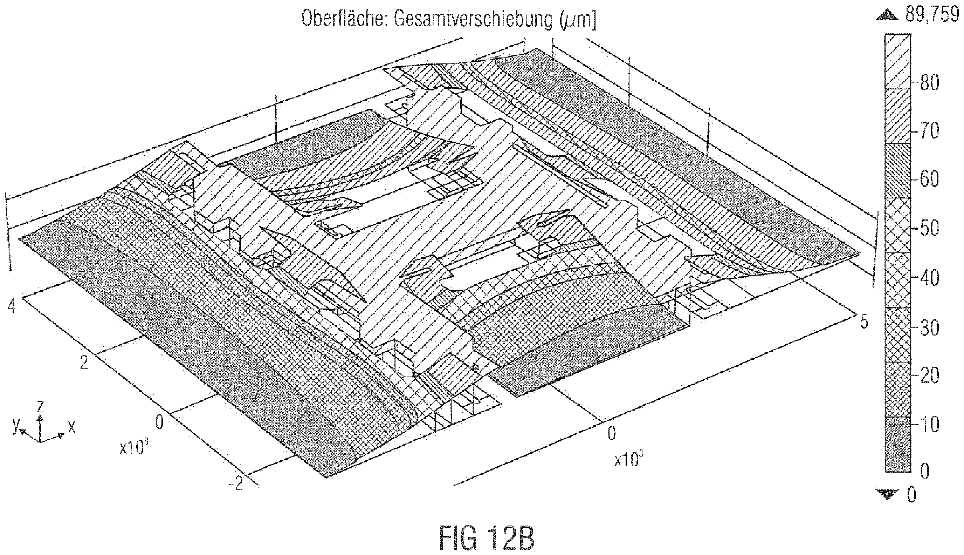

Fig. 12a zeigt eine Draufsicht eines CAD-Modells eines MEMS 100 gemäß einem Ausführungsbeispiel der vorliegenden Erfindung, während Fig. 12b eine perspektivische Ansicht einer FEM-Simulation einer Auslenkung des in Fig. 12a gezeigten CAD-Modells des MEMS 100 zeigt.

Das in Fig. 12a gezeigte CAD-Modell des MEMS 100 basiert auf einer Kombination der in den Fig. 4a, 4d, 5b, 5e, 6c, 6d und 6f gezeigten Ausführungsbeispiele.

Wie in Fig. 12a zu erkennen ist, weist das MEMS 100 eine H-förmige Hubstruktur 104 und vier piezoelektrische Aktuatoren 106_1 bis 106_n (n = 4) auf. Im Detail, weist die Hubstruktur 104 drei Abschnitte 104a bis 104c auf, die angeordnet sind, um eine H-förmige Hubstruktur 104 zu bilden, so dass die Hubstruktur 104 in einer Schnittebene, die senkrecht zu der Richtung 114 (siehe Fig. 1a) der Hubbewegung der Hubstruktur 104 verläuft, H-förmig ist.

Ein erster piezoelektrischer Aktuator 106_1 der vier piezoelektrischen Aktuatoren 106_1 bis 106_n (n = 4) ist außerhalb der H-förmigen Hubstruktur 104 entlang eines ersten Abschnitts 104a der drei Abschnitte 104a bis 104c der Hubstruktur 104 angeordnet, wobei ein zweiter piezoelektrischer Aktuator 106_2 der vier piezoelektrischen Aktuatoren 106_1 bis 106_n (n = 4) außerhalb der H-förmigen Hubstruktur 104 entlang eines zweiten Abschnitts 104b der drei Abschnitte 104a bis 104c der Hubstruktur 104 angeordnet ist, wobei der erste Abschnitt 104a und der zweite Abschnitt 104b der Hubstruktur 104 parallel zueinander verlaufen.

Der erste piezoelektrische Aktuator 106_1 erstreckt sich über zumindest den gesamten ersten Abschnitt 104a der Hubstruktur 104, und ist über zumindest zwei (gemäß Fig. 12a über vier) voneinander beabstandete Verbindungselemente 108_1 bis 108_4 der voneinander beabstandeten Verbindungselemente 108_1 bis 108_m (m = 12) mit zumindest zwei der voneinander beabstandeten Kontaktpunkte des ersten Abschnitts 104a der Hubstruktur 104 verbunden, wobei sich der zweite piezoelektrische Aktuator 106_2 über zumindest den gesamten zweiten Abschnitt 104b der Hubstruktur 104 erstreckt und über zumindest zwei (gemäß Fig. 12a über vier) voneinander beabstandete Verbindungselemente 108_5 bis 108_8 der voneinander beabstandeten Verbindungselemente 108_1 bis 108_m mit zumindest zwei der voneinander beabstandeten Kontaktpunkte des zweiten Abschnitts 104b der Hubstruktur 104 verbunden ist.

Ein dritter piezoelektrischer Aktuator 106_3 der vier piezoelektrischen Aktuatoren 106_1 bis 106_n (n = 4) ist zumindest teilweise innerhalb der H-förmigen Hubstruktur 104 entlang einer ersten Seite eines dritten Abschnitts 104c der drei Abschnitte 104a bis 104c der Hubstruktur 104 angeordnet, wobei ein vierter piezoelektrischer Aktuator 106_4 der vier piezoelektrischen Aktuatoren 106_1 bis 106_n (n = 4) innerhalb der H-förmigen Hubstruktur 104 entlang einer der ersten Seite gegenüberliegenden zweiten Seite des dritten Abschnitts 104c der Hubstruktur 104 angeordnet ist, wobei der dritte Abschnitt 104c senkrecht zu dem ersten Abschnitt 104a und dem zweiten Abschnitt 104b verläuft.

Der dritte piezoelektrische Aktuator 106_3 ist über zumindest zwei voneinander beabstandete Verbindungselemente 108_9 und 108_10 der voneinander beabstandeten Verbindungselemente 108_1 bis 108_m (m = 12) mit der Hubstruktur 104 (hier über ein Verbindungselement 108_9 mit dem ersten Abschnitt 104a der Hubstruktur 104 und über ein Verbindungselement 108_10 mit dem zweiten Abschnitt 104 der Hubstruktur 104) verbunden, wobei der vierte piezoelektrische Aktuator 106_4 über zumindest zwei voneinander beabstandete Verbindungselemente 108_11 und 108_12 der voneinander beabstandeten Verbindungselemente 108_1 bis 108_m (m = 12) mit der Hubstruktur 104 (hier über ein Verbindungselement 108_11 mit dem ersten Abschnitt 104a der Hubstruktur 104 und über ein Verbindungselement 108_12 mit dem zweiten Abschnitt 104 der Hubstruktur 104) verbunden ist.

Fig. 12a und 12b zeigen somit ein Design auf Basis von zwei äußeren Aktuatoren 106_1 und 106_2 und zwei inneren Aktuatoren 106_3 und 106_4, welche jeweils paarweise gegenübereinander bzw. gegenüberliegend angeordnet sind. Zur Erzielung hoher Kräfte und Auslenkungen weisen die Aktuatoren 106_1 bis 106_4 eine möglichst hohe Breite auf, wodurch im aktuierten Zustand o.g. Querverwölbung deutlich in Erscheinung tritt (siehe Fig. 12b). An den freien Aktuatorecken, den Punkten mit der höchsten Auslenkung, sind die Aktuatoren über flächeneffiziente Federn (vgl. Abb. 3.5d und Abb. 3.5f) mit dem Hubkörper 104 verbunden, an dessen Enden über lokale Verbreiterungen zusätzliche Montageflächen realisiert sind. Aufgrund des hohen Breite-zu-Länge-Verhältnis verfügen die beiden äußeren Aktuatoren 106_1 und 106_2 über ein zusätzliches Verbindungselement, mit dessen Hilfe sich die generierten Kräfte ohne große Einbußen bei der Auslenkung nochmals deutlich erhöhen lassen.

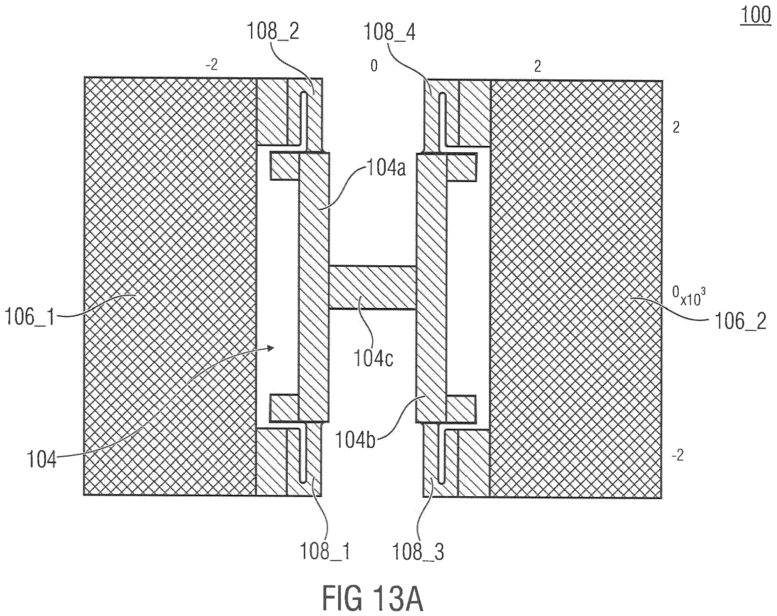

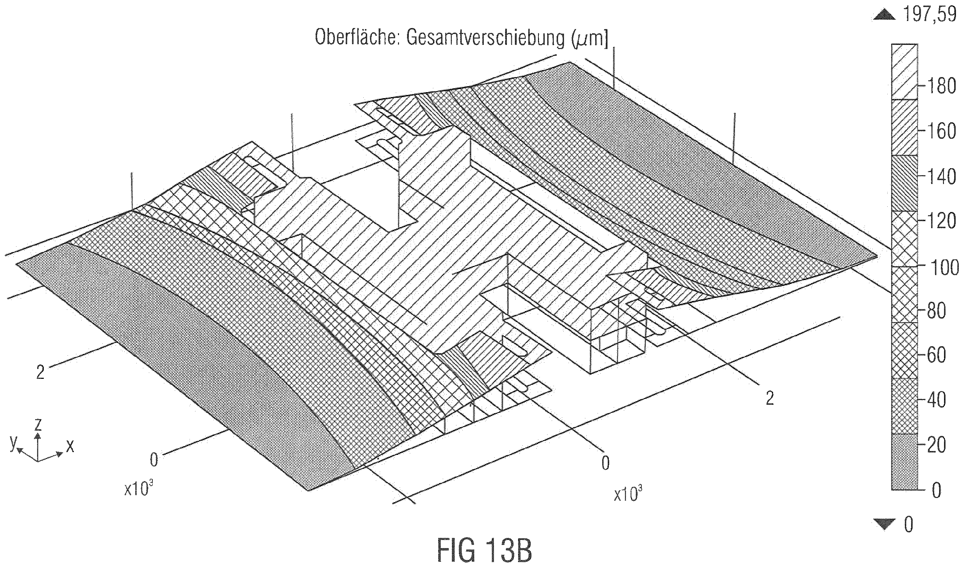

Fig. 13a zeigt eine Draufsicht eines CAD-Modells eines MEMS 100 gemäß einem Ausführungsbeispiel der vorliegenden Erfindung, während Fig. 13b eine perspektivische Ansicht einer FEM-Simulation einer Auslenkung des in Fig. 13a gezeigten CAD-Modells des MEMS 100 zeigt.

Das in Fig. 13a gezeigte CAD-Modell des MEMS 100 basiert auf einer Kombination der in den Fig. 4a, 4d, 5e und 6f gezeigten Ausführungsbeispiele.

Im Gegensatz zu Fig. 12a weist das in Fig. 13a gezeigte CAD-Modell des MEMS 100 (nur) zwei piezoelektrische Aktuatoren 106_1 und 106_n (n = 2) auf, wobei ein erster piezoelektrische Aktuator 106_1 der zwei piezoelektrischen Aktuatoren 106_1 und 106_2 über zwei voneinander beabstandete Verbindungselemente 108_1 und 108_2 mit dem ersten Abschnitt 104a der Hubstruktur verbunden ist, und wobei der zweite piezoelektrische Aktuator 106_2 der zwei piezoelektrischen Aktuatoren 106_1 und 106_2 über zwei voneinander beabstandete Verbindungselemente 108_3 und 108_4 mit dem zweiten Abschnitt 104b der Hubstruktur 104 verbunden ist.

Fig. 13a und 13b veranschaulicht somit eine verkleinerte Version von Fig. 12a und 12b, bei der auf die zwei mittleren Aktuatoren 106_3 und 106_4 verzichtet wurde, da die minimale Aktuatorlänge die verfügbare Länge überstiegen hätte. Aufgrund der deutlich schmaleren äußeren Aktuatoren 106_1 und 106_2 weisen die zwei seitlichen Aktuatoren 106_1 und 106_2 nur jeweils zwei Verbindungselemente 108_1 bis 108_4 auf, wobei es sich erneut um eine platzsparende Kombination aus Biege- und Torsionsfeder handelt.

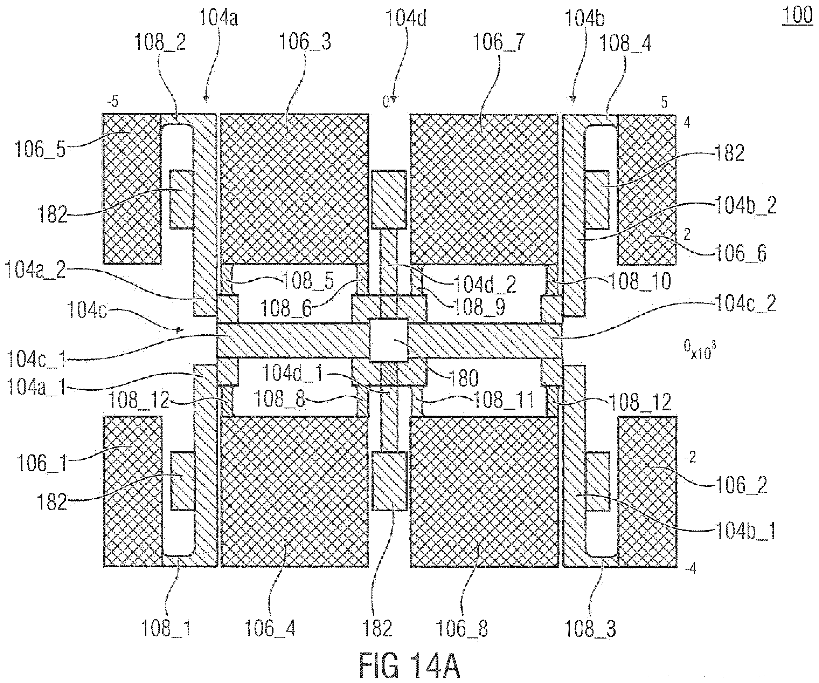

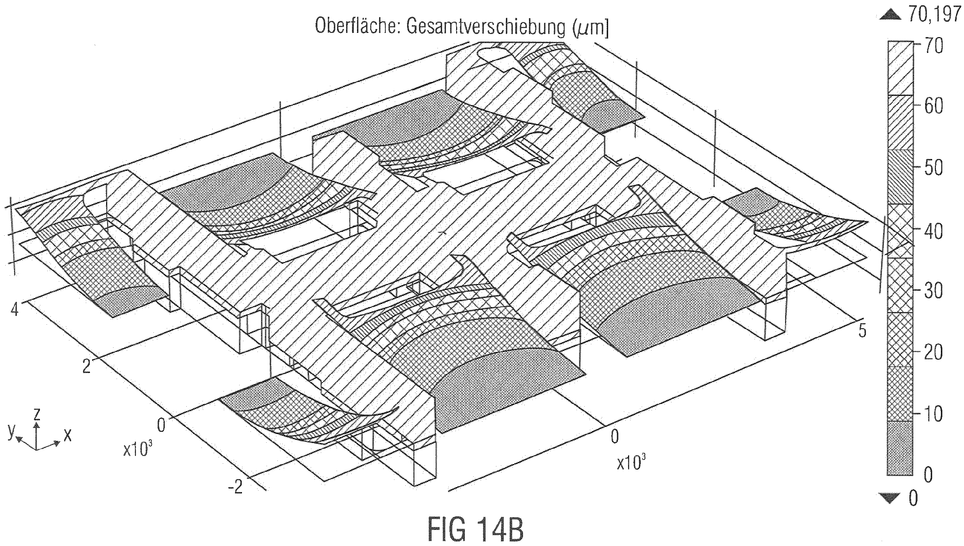

Fig. 14a zeigt eine Draufsicht eines CAD-Modells eines MEMS 100 gemäß einem Ausführungsbeispiel der vorliegenden Erfindung, während Fig. 14b eine perspektivische Ansicht einer FEM-Simulation einer Auslenkung des in Fig. 14a gezeigten CAD-Modells des MEMS 100 zeigt.

Wie in Fig. 14a zu erkennen ist, weist das MEMS 100 eine H-förmige Hubstruktur 104 und acht piezoelektrische Aktuatoren 106_1 bis 106_n (n = 8) auf. Im Detail, weist die Hubstruktur 104 drei Abschnitte 104a bis 104c auf, die angeordnet sind, um eine H-förmige Hubstruktur 104 zu bilden, so dass die Hubstruktur 104 in einer Schnittebene, die senkrecht zu der Richtung 114 der Hubbewegung der Hubstruktur 104 verläuft, H-förmig ist.

Ein erster piezoelektrische Aktuator 106_1 und ein fünfter piezoelektrischer Aktuator 106_5 der acht piezoelektrischen Aktuatoren 106_1 bis 106_n (n = 8) sind außerhalb der Hubstruktur 104 entlang des ersten Abschnitts 104a der Hubstruktur 104 angeordnet, wobei ein zweiter piezoelektrischer Aktuator 106_2 und ein sechster piezoelektrischer Aktuator 106_6 der acht piezoelektrischen Aktuatoren 106_1 bis 106_8 außerhalb der Hubstruktur 104 entlang des zweiten Abschnitts 104b der Hubstruktur 104 angeordnet sind.

Der erste piezoelektrische Aktuator 106_1 und der fünfte piezoelektrische Aktuator 106_5 sind dabei jeweils über zumindest ein Verbindungselement 108_1 bzw. 108_2 der voneinander beabstandeten Verbindungselemente 108_1 bis 108_m (m = 12) mit zumindest einem der voneinander beabstandeten Kontaktpunkte des ersten Abschnitts 104a der Hubstruktur 104 verbunden, wobei der zweite piezoelektrische Aktuator 106_2 und der sechste piezoelektrische Aktuator 106_6 jeweils über zumindest eine Verbindungselement 108_3 bzw. 108_4 der voneinander beabstandeten Verbindungselemente 108_1 bis 108_m (m = 12) mit zumindest einem der voneinander beabstandeten Kontaktpunkte des zweiten Abschnitts 104b der Hubstruktur 104 verbunden ist.

Wie in Fig. 14a zu erkennen ist, ist der erste Abschnitt 104a in einen ersten Teilabschnitt 104a_1 und einen zweiten Teilabschnitt 104a_2 unterteilt, wobei der erste piezoelektrische Aktuator 106_1 entlang des ersten Teilabschnitts 104a_1 des ersten Abschnitts 104a angeordnet ist und mit dem ersten Teilabschnitt 104a_1 des ersten Abschnitts 104a über das Verbindungselement 108_1 verbunden ist, wobei der fünfte piezoelektrische Aktuator 106_5 entlang des zweiten Teilabschnitts 104a_2 des ersten Abschnitts 104a angeordnet ist und mit dem zweiten Teilabschnitt 104a_2 des ersten Abschnitts 104a über das Verbindungselement 108_2 verbunden ist.

Ferner ist der zweite Abschnitt 104b in einen ersten Teilabschnitt 104b_1 und einen zweiten Teilabschnitt 104b_2 unterteilt, wobei der zweite piezoelektrische Aktuator 106_2 entlang des ersten Teilabschnitts 104b_1 des zweiten Abschnitts 104b angeordnet ist und mit dem ersten Teilabschnitt 104b_1 des zweiten Abschnitts 104b über das Verbindungselement 108_3 verbunden ist, wobei der sechste piezoelektrische Aktuator 106_6 entlang des zweiten Teilabschnitts 104b_2 des zweiten Abschnitts 104b angeordnet ist und mit dem zweiten Teilabschnitt 104b_2 des zweiten Abschnitts 104b über das Verbindungselement 108_4 verbunden ist.

Ein dritter piezoelektrische Aktuator 106_3 und ein siebter piezoelektrischer Aktuator 106_7 der acht piezoelektrischen Aktuatoren 106_1 bis 106_n (n = 8) ist zumindest teilweise innerhalb der Hubstruktur 104 entlang der ersten Seite des dritten Abschnitts 104c der Hubstruktur 104 angeordnet, wobei ein vierter piezoelektrischer Aktuator 106_4 und ein achter piezoelektrischer Aktuator 106_8 der acht piezoelektrischen Aktuatoren 106_1 bis 106_8 zumindest teilweise innerhalb der Hubstruktur 104 entlang der zweiten Seite des dritten Abschnitts 104c der Hubstruktur 104 angeordnet sind.

Wie in Fig. 14a zu erkennen ist, ist der dritte Abschnitt 104c in einen ersten Teilabschnitt 104c_1 und einen zweiten Teilabschnitt 104c_2 unterteilt, wobei der dritte piezoelektrische Aktuator 106_3 entlang einer ersten Seite des ersten Teilabschnitts 104c_1 des dritten Abschnitts 104c angeordnet ist, wobei der vierte piezoelektrische Aktuator 106_4 entlang einer der ersten Seite gegenüberliegenden zweiten Seite des ersten Teilabschnitts 104c_1 des dritten Abschnitts 104c angeordnet ist, wobei der siebte piezoelektrische Aktuator 106_7 entlang einer ersten Seite des zweiten Teilabschnitts 104c_2 des dritten Abschnitts 104c angeordnet ist, wobei der achte piezoelektrische Aktuator 106_8 entlang einer der ersten Seite gegenüberliegenden zweiten Seite des zweiten Teilabschnitts 104c_2 des dritten Abschnitts 104c angeordnet ist.

Der dritte piezoelektrische Aktuator 106_3 und der vierte piezoelektrische Aktuator 106_4 sind dabei jeweils über zwei voneinander beabstandete Verbindungselemente 108_5 bis 108_8 der voneinander beabstandeten Verbindungselemente mit der jeweiligen Seite des ersten Teilabschnitts 104c_1 des dritten Abschnitts 104c verbunden, wobei der siebte piezoelektrische Aktuator 106_7 und der achte piezoelektrische Aktuator 106_8 über jeweils zwei voneinander beabstandete Verbindungselemente 108_9 bis 108_12 mit der jeweiligen Seite des zweiten Teilabschnitts 104c_2 des dritten Abschnitts 104c verbunden sind.

Die Hubstruktur 104 kann ferner einen vierten Abschnitt 104d aufweisen, der mittig parallel zwischen dem ersten Abschnitt 104a und dem zweiten Abschnitt 104b angeordnet ist, wobei auch der vierte Abschnitt 104d in einen ersten Teilabschnitt 104d_1 und einen zweiten Teilabschnitt 104d_2 unterteilt sein kann.

Fig. 14a und 14b veranschaulicht somit ein Beispiel mit acht parallel zueinander angeordneten Aktuatoren 106_1 bis 106_n (n = 8), wobei die äußeren vier Aktuatoren entgegengesetzt ausgerichtet sind, sodass sie über Torsionsfedern möglichst weit außerhalb des Hubkörper-Schwerpunkts ihre Kraft übertragen (Verschiebung von parasitären Kippmoden im Frequenzbereich). Im Gegensatz zu den vorherigen Beispielen weist der zentrale Balken 104c des Hubkörpers 104 lokale Verbreiterungen sowie ein Loch 180 im Zentrum auf. Hierdurch werden die Angriffspunkte, an denen die inneren Aktuatoren über Biegefedern mit dem Hubkörper verbunden sind, bei möglichst geringem Massenzuwachs vom Schwerpunkt nach außen hin verlagert um parasitären Moden entgegenzuwirken. Die zusätzlichen vertikalen Ausleger 104d_1 und 104_d2 sowie die lokalen Verbreiterungen 182 an den vertikalen Hubkörper-Balken 104a, 104b, 104c dienen als Klebeflächen für die hybride Integration eines erweiterten Hubkörpers mit erhöhter Fläche. Aufgrund der vergleichsweise schmalen Aktuatorelemente sind Auslenkung und Kräfte geringer als im Beispiel von Fig. 12a. Im Gegenzug weist der Hubkörper 104 eine deutlich größere Spannweite und dichter beieinander liegende Klebeflächen auf, sodass die Anordnung das hybride Aufbringen besonders leichter und mechanisch weniger steifer Platten oder Membranen 102 ermöglicht.

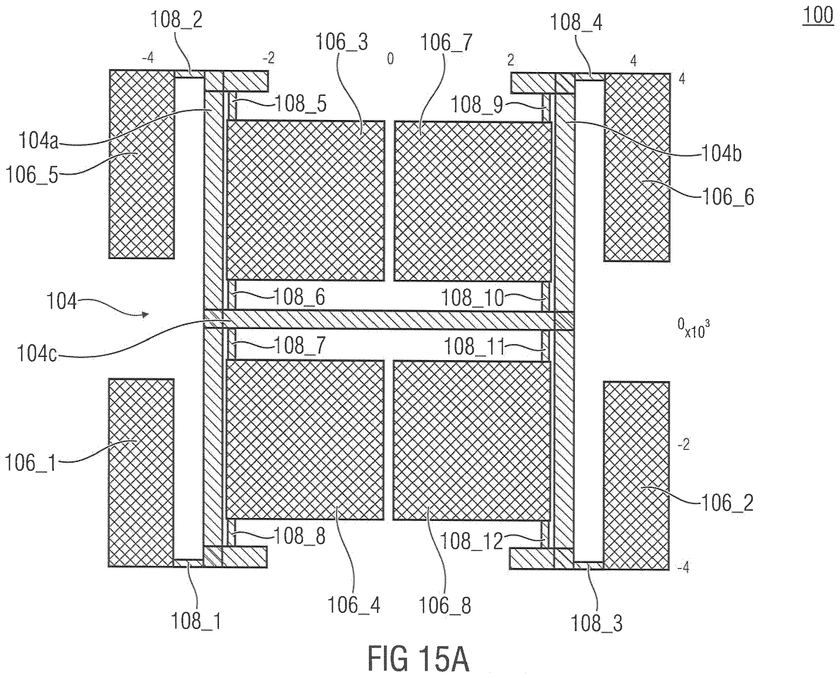

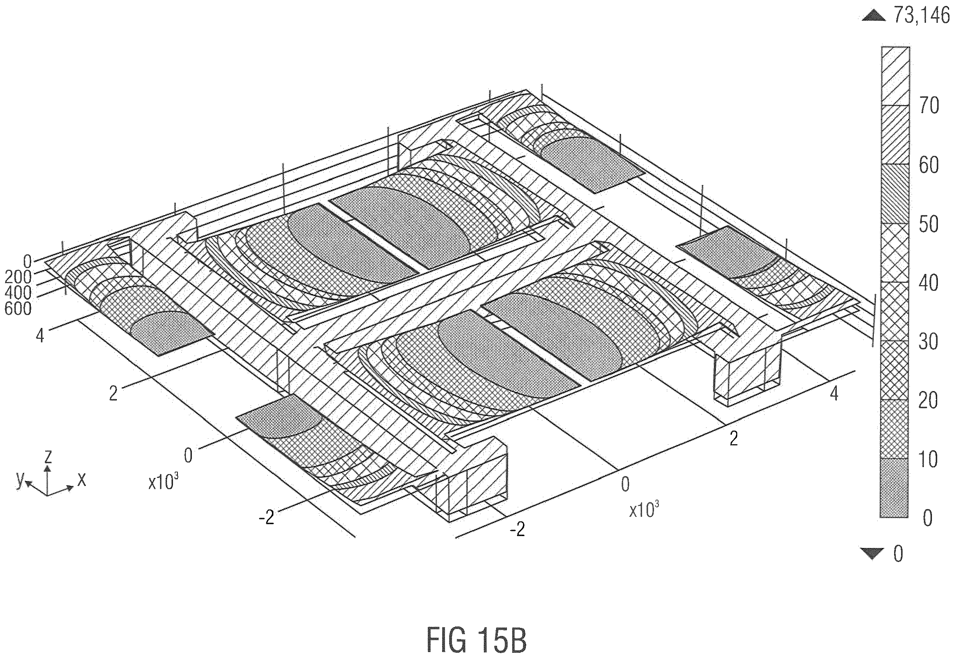

Fig. 15a zeigt eine Draufsicht eines CAD-Modells eines MEMS 100 gemäß einem Ausführungsbeispiel der vorliegenden Erfindung, während Fig. 15b eine perspektivische Ansicht einer FEM-Simulation einer Auslenkung des in Fig. 15a gezeigten CAD-Modells des MEMS 100 zeigt.

Das in Fig. 15a gezeigte CAD-Modell des MEMS 100 basiert auf einer Kombination der in den Fig. 4a, 4d, 5c, Abb. 5g und 6b gezeigten Ausführungsbeispiele.

Das MEMS 100 weist eine H-förmige Hubstruktur 104 und acht piezoelektrische Aktuatoren 106_1 bis 106_n (n = 8) auf. Im Detail, weist die Hubstruktur 104 drei Abschnitte 104a bis 104c auf, die angeordnet sind, um eine H-förmige Hubstruktur 104 zu bilden, so dass die Hubstruktur 104 in einer Schnittebene, die senkrecht zu der Richtung 114 der Hubbewegung der Hubstruktur 104 verläuft, H-förmig ist.

Ein erster piezoelektrische Aktuator 106_1 und ein fünfter piezoelektrischer Aktuator 106_5 der acht piezoelektrischen Aktuatoren 106_1 bis 106_n (n = 8) sind außerhalb der Hubstruktur 104 entlang des ersten Abschnitts 104a der Hubstruktur 104 angeordnet, wobei ein zweiter piezoelektrischer Aktuator 106_2 und ein sechster piezoelektrischer Aktuator 106_6 der acht piezoelektrischen Aktuatoren 106_1 bis 106_n (n = 8) außerhalb der Hubstruktur 104 entlang des zweiten Abschnitts 104b der Hubstruktur 104 angeordnet sind.

Der erste piezoelektrische Aktuator 106_1 und der fünfte piezoelektrische Aktuator 106_5 sind dabei jeweils über zumindest ein Verbindungselement 108_1 und 108_2 der voneinander beabstandeten Verbindungselemente 108_1 bis 108_m (m = 12) mit zumindest einem der voneinander beabstandeten Kontaktpunkte des ersten Abschnitts 104a der Hubstruktur 104 verbunden, wobei der zweite piezoelektrische Aktuator 106_2 und der sechste piezoelektrische Aktuator 106_6 jeweils über zumindest ein Verbindungselement 108_3 und 108_4 der voneinander beabstandeten Verbindungselemente 108_1 bis 108_m (m = 12) mit zumindest einem der voneinander beabstandeten Kontaktpunkte des zweiten Abschnitts 104b der Hubstruktur 104 verbunden ist.

Ein dritter piezoelektrische Aktuator 106_3 und ein siebter piezoelektrischer Aktuator 106_7 der acht piezoelektrischen Aktuatoren 106_1 bis 106_n (n = 8) ist zumindest teilweise innerhalb der Hubstruktur 104 entlang der ersten Seite des dritten Abschnitts 104c der Hubstruktur 104 angeordnet, wobei ein vierter piezoelektrische Aktuator 106_4 und ein achter piezoelektrische Aktuator 106_8 der acht piezoelektrischen Aktuatoren 106_1 bis 106_n (n = 8) zumindest teilweise innerhalb der Hubstruktur 104 entlang der zweiten Seite des dritten Abschnitts 104c der Hubstruktur 104 angeordnet sind.

Der dritte piezoelektrische Aktuator 106_3 und der vierte piezoelektrische Aktuator 106_4 sind dabei jeweils über zwei voneinander beabstandete Verbindungselemente 108_5 bis 108_8 der voneinander beabstandeten Verbindungselementen mit der Hubstruktur 104 verbunden, wobei der siebte piezoelektrische Aktuator 106_7 und der achte piezoelektrische Aktuator 106_8 über jeweils zwei voneinander beabstandete Verbindungselemente 108_9 bis 108_12 mit der Hubstruktur 104 verbunden sind.

Die Einspannung des dritten, vierten, siebten und achten piezoelektrischen Aktuators 106_3, 106_4, 106_7 und 106_8 verläuft dabei mittig parallel zwischen dem ersten und zweiten Abschnitt 104a und 104b.

Fig. 15a und 15b zeigt somit ein Design ähnlich wie in Fig. 14a und 14b, jedoch mit um 90° verdrehten inneren Aktuatoren 106_3, 106_4, 106_7 und 106_8 (vgl. Fig. 5c). Im Gegensatz zu den Biegefedern im vorherigen Beispiel sind die inneren vier Aktuatoren über jeweils zwei Torsionsfedern mit dem Hubkörper 104 verbunden.

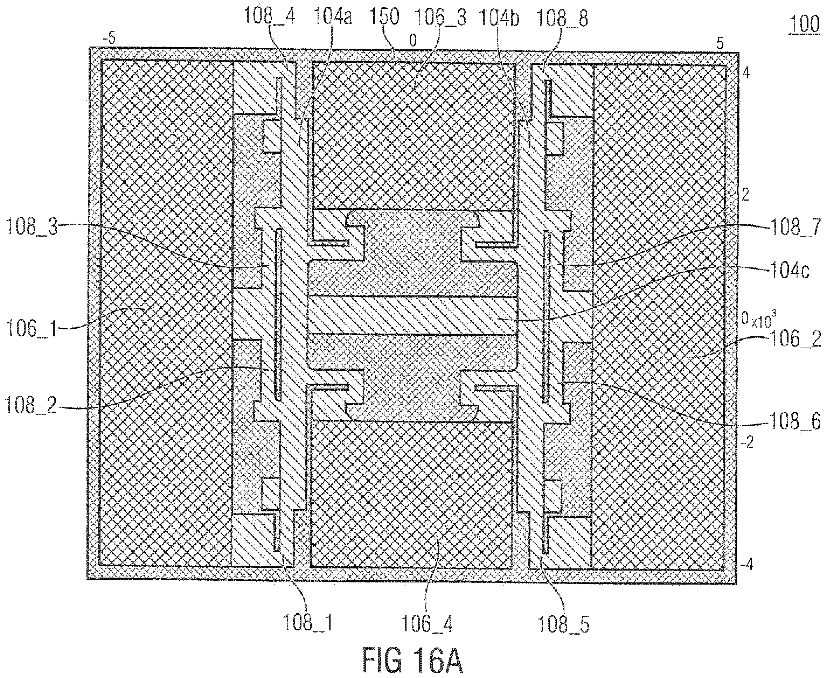

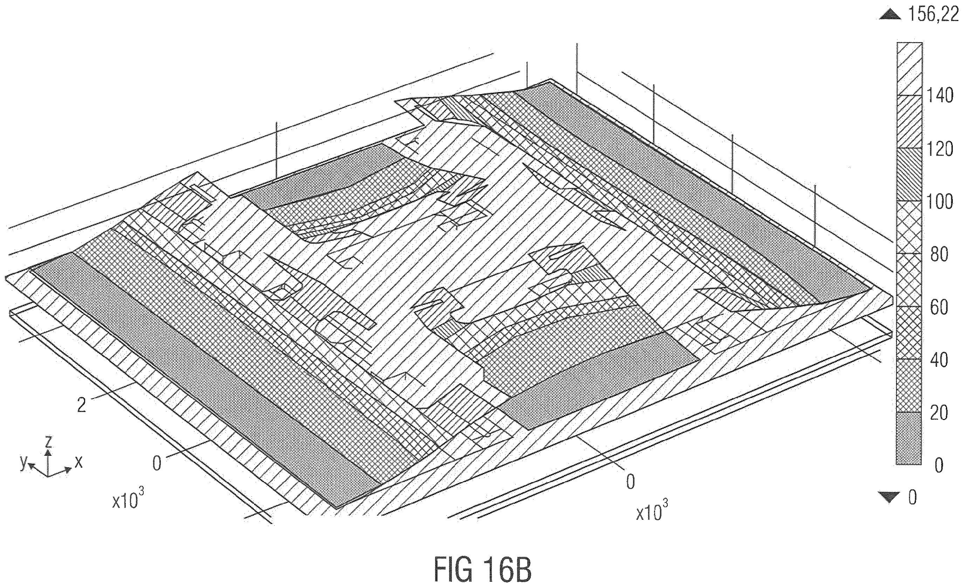

Fig. 16a zeigt eine Draufsicht eines CAD-Modells eines MEMS 100 gemäß einem Ausführungsbeispiel der vorliegenden Erfindung, während Fig. 16b eine perspektivische Ansicht einer FEM-Simulation einer Auslenkung des in Fig. 16a gezeigten CAD-Modells des MEMS 100 zeigt.

Im Gegensatz zu dem in Fig. 12a und 12b gezeigten CAD-Modell des MEMS 100 weist das in Fig. 16a und 16b gezeigte CAD-Modell des MEMS 100 zusätzlich einen erweiterten Hubkörper 150, im Detail einen unterseitig angebrachtem plattenförmigem Hubkörper 150, auf.

Fig. 15a und 15b veranschaulicht somit eine leicht modifizierte Version von Fig. 12a und 12b, bei der ein erweiterter plattenförmiger Hubkörper 150 an der Unterseite des eigentlichen Hubkörpers 104 befestigt ist. Der erweiterte Hubkörper 150 nimmt eine Fläche ein, die in etwa der aktiven Fläche (vgl. Fig. 4a bis 4f) entspricht. Natürlich kann der erweiterte Hubkörper 150 bei Ausführungsbeispielen auch größer sein als die aktive Fläche.

Nachfolgend werden allgemeine Eigenschaften und Randbedingungen von Ausführungsbeispielen der vorliegenden Erfindung näher erläutert.

In der folgenden Tabelle sind dabei typische minimale und maximale Werte wesentlicher Zielparameter tabellarisch aufgelistet:

| **Parameter** | **Typische Werte** | **Minimum / Maximum** |
|---|---|---|
| Resonanzfrequenz (Hubmode) | 500 Hz | 10 Hz - 10 kHz |
| Anregungsfrequenz | statisch - 20 kHz | statisch - 1 MHz |
| min. aktive Fläche | 10 x 10 mm² | 100 x 100 µm² - 3 x 3 cm² |
| Auslenkungsamplitude | 200 µm | 0.1 µm - 3 mm |
| Piezoelektrische Kraft | 20 mN | 1 µN - 2 N |

In der folgenden Tabelle sind beispielhaft verwendbare Materialien für die entsprechenden Funktionselemente tabellarisch aufgelistet:

| **Funktion** | **Materialien** |
|---|---|
| Piezoelektrische Schicht | PZT, PNZT, AIN, AIScN, ZnO, BCZT, KNN |
| Passive Schicht | Si, poly-Si, SiN, SiNO, SiO₂, AIN, Metalle |
| Hubkörper | Si, [piezoelektrische Schicht], [passive Schicht] |
| Erweiterter Hubkörper | Si, Metalle, Kunststoffe |
| Verbindungselemente | [passive Schicht], [piezoelektrische Schicht] |
| Membran | Silikone, Parylene, PDMS, PI, BCB, PMMA ... |

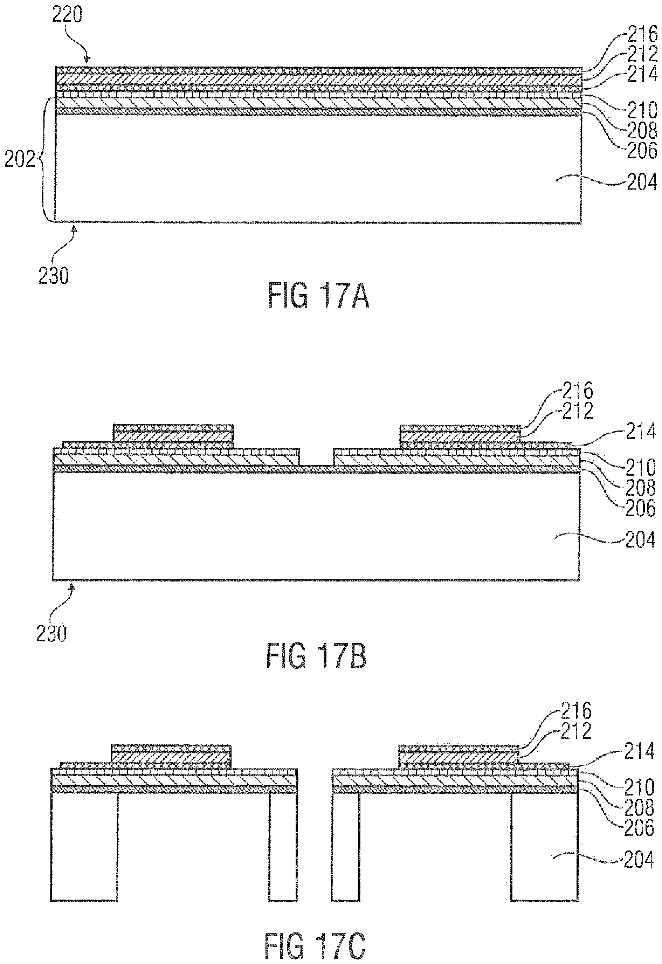

Im Folgenden wird Anhand von Fig. 17a bis 17c beispielhaft ein Verfahren zur Herstellung des MEMS 100 gegeben. Im Detail veranschaulicht Fig. 17a bis 17c einen vereinfacht dargestellten Prozessablauf für eine Unimorph-Konfiguration mit PZT als piezoelektrischem Material und Silizium als passivem Material. Fig. 17a zeigt dabei eine schematische Querschnittsansicht eines SOI-Wafers (SOI = Silicon On Insulator, dt. Silizium auf einem Isolator) vor der Vorderseitenstrukturierung, während Fig. 17b eine schematische Querschnittsansicht nach der Strukturierung der vorderseitigen Schichten zeigt, und während Fig. 17c eine schematische Querschnittsansicht nach rückseitiger Si- und SiO₂-Strukturierung zeigt.

Das Verfahren kann die im Folgenden aufgeführten Prozessschritte umfassen.

Einen Schritt des Bereitstellens eines SOI-Wafers 202 mit einem Si-Substrat 204, einer darauf aufgebrachten SiO₂-Schicht 206 und einer darauf aufgebrachten Si-Funktionsschicht 208.

Einen Schritt des Aufbringens oder Abscheidens einer Isolationsschicht (SiO₂) 210, einer piezoelektrischen Funktionsschicht (PZT) 212 und entsprechenden Metallelektroden (Pt, Au, Mo) 214 und 216.

Ein Schritt des Strukturierens der Elektroden 214 und 216, der piezoelektrischen Funktionsschicht 212 und der Isolationsschicht 210 mittels Nass- und/oder Trockenätzen ausgehend von der ersten Oberfläche 220 mit Stopp auf der vergrabenen SiO₂-Schicht 206.

Einen Schritt des rückseitigen Si-Ätzens mit Stopp auf der vergrabenen SiO₂-Schicht 206 mit anschließender Entfernung der freigelegten SiO₂-Bereiche.

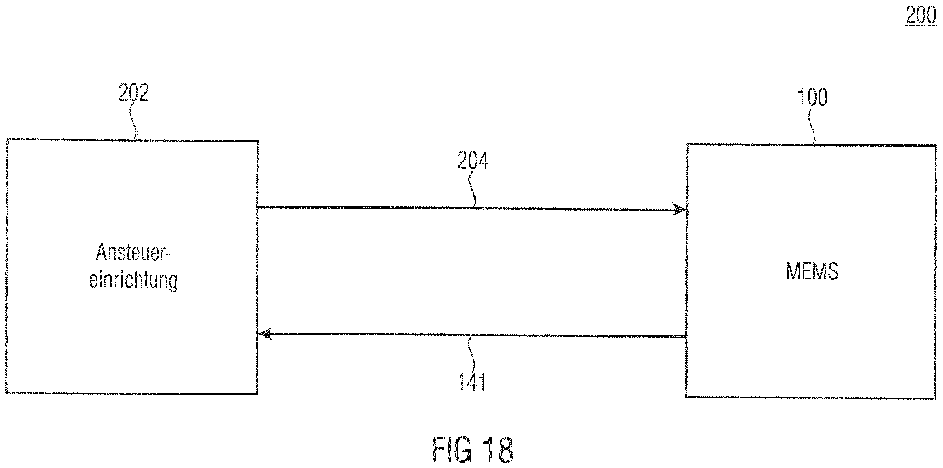

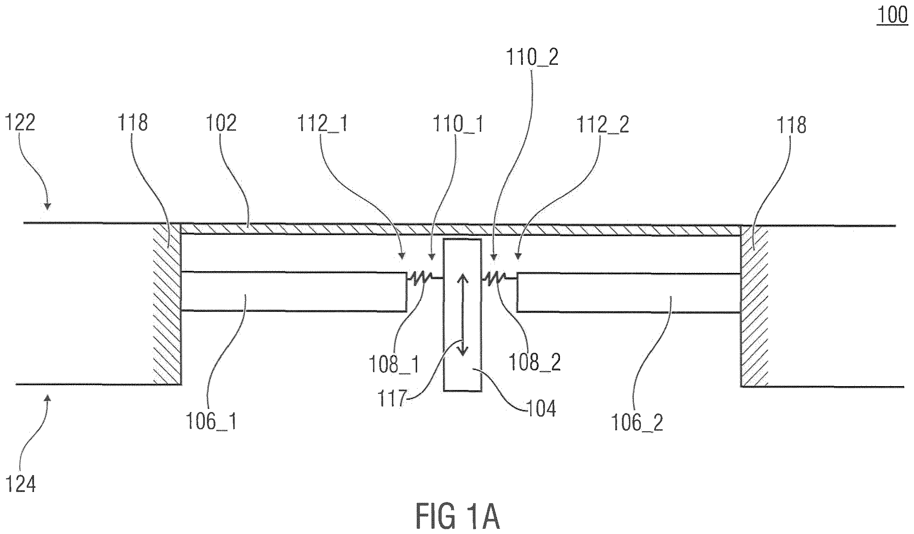

Fig. 18 zeigt eine schematische Ansicht eines Systems 200, gemäß einem Ausführungsbeispiel der vorliegenden Erfindung. Das System weist das oben beschriebene MEMS 100 und eine Ansteuereinrichtung 202 auf, wobei die Ansteuereinrichtung 202 ausgebildet sein kann, um die zumindest zwei piezoelektrischen Aktuatoren 106_1 bis 106_n des MEMS 100 anzusteuern.

Beispielsweise kann die Ansteuereinrichtung 202 ausgebildet sein, um ein Ansteuersignal 204 zum Ansteuern der zumindest zwei piezoelektrischen Aktuatoren 106_1 bis 106_n bereitzustellen.

Ferner kann das MEMS 100 bei Ausführungsbeispielen einen Positionssensor 140, z.B. eine piezoelektrischen oder kapazitiven Positionssensor, aufweisen, der ausgebildet ist, um ein von der Auslenkung der Membran 102 abhängiges Sensorsignal 141 bereitzustellen. Die Ansteuereinrichtung kann dabei ausgebildet sein, um die zumindest zwei piezoelektrischen Aktuatoren 106_1 bis 106_n des MEMS 100 basierend auf dem Sensorsignal 141 geregelt anzusteuern.

Weitere Ausführungsbeispiele der vorliegenden Erfindung schaffen einen miniaturisierten Hubaktuator mit einem flächenreduziertem starren Hubkörper (der z.B. weniger als 40 % (oder 30% oder 20%) der aktiven Fläche einnimmt); mindestens zwei piezoelektrischen Antrieben (die z.B. mindestens 40 % (oder 50 %, 60 %, 70 % oder 80 %) der aktiven Fläche einnehmen), die neben dem Hubkörper angeordnet sind und den Hubkörper aus der Ebene nach oben oder unten bewegen; mit Verbindungselementen, über die die piezoelektrischen Antriebe mit dem Hubkörper verbunden sind; und mit einer an dem Hubkörper fixierten Membran, die eine, insbesondere fluidische, Trennung von Vorderseite und Rückseite gewährleistet. Dabei kann der miniaturisierte Hubaktuator in Siliziumtechnologie hergestellt sein.

Bei Ausführungsbeispielen kann der miniaturisierte Hubaktuator zur Schall- oder Ultraschallerzeugung (in einem Bereich von 20 Hz bis 1 MHz, in einem Bereich von 20 Hz bis 20 kHz, in einem Bereich von 20 kHz bis 100 kHz oder in einem Bereich von 100 kHz bis 1 MHz), zur Verdrängung von Flüssigkeiten oder zur Verdrängung von Gasen verwendet werden. Ferner kann der miniaturisierte Hubaktuator auch zur Erzeugung von Tröpfchen, z.B. für Tintenstrahldrucker, verwendet werden.

Bei Ausführungsbeispielen kann der miniaturisierte Hubaktuator eine Hubkörpergeometrie mit einer Rahmenstruktur, Balken und/oder einer Platte aufweisen.

Bei Ausführungsbeispielen kann der miniaturisierte Hubaktuator einem erweiterten Hubkörper mit großer Fläche zur Erhöhung des verdrängten Fluidvolumens aufweisen.

Bei Ausführungsbeispielen kann der miniaturisierte Hubaktuator Sensorelemente zur Positionserfassung und -regelung aufweisen (vgl. Fig. 7a und 7b).

Bei Ausführungsbeispielen können mehrere miniaturisierte Hubaktuatoren im Array angeordnet werden.

Mit Ausführungsbeispielen der vorliegenden Erfindung lassen sich im resonanten und nichtresonanten Betrieb sehr große Kräfte bei ebenfalls hoher Auslenkung erzeugen. Die Gründe hierfür liegen in der Verwendung von (1) flächenreduzierten Hubkörpern, welche eine hohe Flächenausnutzung hinsichtlich der Aktuatoren ermöglichen, (2) flächenreduzierten Hubkörpern, welche aufgrund ihrer Geometrie eine Kraftübertragung möglichst weit entfernt vom Schwerpunkt des Hubkörpers zulassen, (3) Aktuatoranordnungen, bei denen die verfügbare aktive Fläche besonders effizient genutzt wird, (4) vorzugsweise breiten Biegeaktuatoren mit einseitiger Einspannung, welche aufgrund der ausgeprägten Querverwölbung im aktuierten Zustand hohe Kräfte generieren können, und (5) geeigneten Federelementen, welche möglichst flächeneffizient ausgeführt sind und die Übertragung hoher Kräfte erlauben ohne die Auslenkung des Hubkörpers zu stark zu behindern.

Darüber hinaus ergeben sich folgende Vorteile. Erstens, durch die Parallelschaltung mehrerer Aktuatoren erhöht sich die effektive Federsteifigkeit, sodass sich vergleichsweise hohe Resonanzfrequenzen bei gleichzeitig hohen Auslenkungen realisieren lassen. Zweitens, durch die Flächenreduzierung, weisen die Hubkörper eine verhältnismäßig geringe Masse auf, sodass sich vergleichsweise hohe Resonanzfrequenzen bei gleichzeitig hohen Auslenkungen realisieren lassen. Drittens, durch die Verwendung von einem leichtem Material, vorzugsweise Silizium, für den Hubkörper, lassen sich hohe Resonanzfrequenzen bei gleichzeitig hohen Auslenkungen realisieren. Viertens, durch Aufbringen von plattenförmigen oder anders geformten Gebilden lassen sich erweiterte Hubkörper realisieren, deren Fläche größer als die aktive Fläche sind. Bei der Herstellung in Siliziumtechnologie lassen sich so die Herstellungskosten reduzieren, da die Chipfläche primär durch die Aktuatoren bestimmt wird und kleiner als die notwendige Hubfläche sein kann. Fünftens, mithilfe der integrierten Sensorik lässt sich die tatsächliche Position des Hubkörpers im Betrieb kontinuierlich bestimmen. Dies bildet die Grundlage für eine geregelte Anregung (Closed-Loop), über die sich äußere Einflüsse und Alterungseffekte elektronisch kompensieren lassen. Sechstens, die Verwendung von piezoelektrischen Antrieben erlaubt eine Reduzierung des Energiebedarfs gegenüber Hubaktuatoren mit elektrodynamischem Antrieb.

Im Folgenden werden beispielhafte technische Anwendungsgebiete des MEMS 100 aufgeführt.

Die oben beschriebenen Aktuator-Strukturen eigenen sich für Anwendungen, bei denen mittels piezoelektrischer Antriebe hohe Kräfte und Hübe erzeugt werden sollen. Dies trifft beispielsweise auf Anwendungsgebiete zu, bei denen Fluide verdrängt werden, wie z.B. Ventile und Pumpen. Ferner trifft dies auf MEMS-Lautsprecher zu. MEMS-Lautsprecher (z.B. chip-basierte intelligente Mikrolautsprecher) können in mobilen Kommunikationsgeräten verwendet werden, wie z.B. in erster Linie in Mobiltelefonen, darüber hinaus aber auch in Tablets, Laptops, Kopfhörern und Hörgeräten.

Gemäß einem ersten Aspekt kann ein MEMS 100 eine Membran 102; eine Hubstruktur 104, die mit der Membran 102 gekoppelt ist; und zumindest zwei piezoelektrische Aktuatoren 106_1:106_n aufweisen, die über eine Mehrzahl von voneinander beabstandeten Verbindungselementen 108_1:108_m mit einer Mehrzahl von voneinander beabstandeten Kontaktpunkten 110_1:110_m der Hubstruktur 104 verbunden sein können, wobei die zumindest zwei piezoelektrischen Aktuatoren 106_1:106_n ausgebildet sein können, um eine Hubbewegung der Hubstruktur 104 hervorzurufen, um die Membran 102 auszulenken.

Gemäß einem zweiten Aspekt unter Bezugnahme auf den ersten Aspekt können die Mehrzahl von voneinander beabstandeten Verbindungselementen 108_1:108_m mit einer Mehrzahl von voneinander beabstandeten Kontaktpunkten 112_1:112_m der zumindest zwei piezoelektrischen Aktuatoren 106_1:106_n verbunden sein.

Gemäß einem dritten Aspekt unter Bezugnahme auf zumindest einen des ersten bis zweiten Aspekts kann jeder der zumindest zwei piezoelektrischen Aktuatoren 106_1:106_n über zumindest zwei voneinander beabstandeten Verbindungselemente 108_1:108_m mit zumindest zwei voneinander beabstandeten Kontaktpunkten 110_1:110_m der Hubstruktur 104 verbunden sein.

Gemäß einem vierten Aspekt unter Bezugnahme auf zumindest einen des ersten bis dritten Aspekts kann die Hubstruktur 104 mit der Membran 102 über eine Mehrzahl von Bereichen gekoppelt sein, die entlang von zumindest zwei zumindest teilweise voneinander beabstandeten Geraden oder Kurven mit der Membran 102 angeordnet sind.

Gemäß einem fünften Aspekt unter Bezugnahme auf zumindest einen des ersten bis vierten Aspekts kann die Hubstruktur 104 senkrecht zu einer Richtung 114 der Hubbewegung eine Fläche aufspannt sein, die zumindest 30 % einer Fläche der Membran 102 entspricht.

Gemäß einem sechsten Aspekt unter Bezugnahme auf zumindest einen des ersten bis fünften Aspekts kann die Hubstruktur 104 mit der Membran 102 über eine Mehrzahl von verteilt angeordneten Bereichen 104a;104b;104c gekoppelt sein.

Gemäß einem siebten Aspekt unter Bezugnahme auf zumindest einen des ersten bis sechsten Aspekts kann die Hubstruktur 104 in einer Schnittebene, die senkrecht zu einer Richtung 114 der Hubbewegung verläuft, eine I-Struktur, eine L-Struktur, eine H-Struktur, eine X-Struktur, eine O-Struktur oder eine kreuzförmige Struktur aufweisen.

Gemäß einem achten Aspekt unter Bezugnahme auf zumindest einen des ersten bis siebten Aspekts kann ein Hebelarm zwischen einem der Kraftangriffspunkte der Hubstruktur 104 auf die Membran 102 und einem nächstliegenden Aufnahmepunkt einer Membranaufhängung 118 höchstens halb so groß sein wie ein Hebelarm der zumindest zwei piezoelektrischen Aktuatoren 106_1:106_n.

Gemäß einem neunten Aspekt unter Bezugnahme auf zumindest einen des ersten bis achten Aspekts kann eine Querschnittsfläche der Hubstruktur 104 senkrecht zu einer Richtung 114 der Hubbewegung der Hubstruktur 104 kleiner sein als eine Summe von piezoelektrisch aktiven Aktuatorflächen der zumindest zwei piezoelektrischen Aktuatoren 106_1:106_n.

Gemäß einem zehnten Aspekt unter Bezugnahme auf zumindest einen des ersten bis neunten Aspekts kann die Hubstruktur 104 eine Mehrzahl von miteinander verbundenen Balken 104a;104b;104c aufweisen, die jeweils zumindest teilweise an einer Stirnseite mit der Membran 102 gekoppelt sind.

Gemäß einem elften Aspekt unter Bezugnahme auf zumindest einen des ersten bis zehnten Aspekts können die zumindest zwei piezoelektrischen Aktuatoren 106_1:106_n als Biegebalken ausgebildet sein.

Gemäß einem zwölften Aspekt unter Bezugnahme auf zumindest einen des ersten bis elften Aspekts kann die Hubstruktur 104 symmetrisch sein, und die zumindest zwei piezoelektrischen Aktuatoren 106_1:106_n können symmetrisch zu einem Schwerpunkt 120 der Hubstruktur 104 angeordnet sein.

Gemäß einem dreizehnten Aspekt unter Bezugnahme auf den zwölften Aspekt können die Mehrzahl von voneinander beabstandeten Kontaktpunkten 110_1:110_m der Hubstruktur 104 symmetrisch zu dem Schwerpunkt 120 der Hubstruktur 104 angeordnet sein.

Gemäß einem vierzehnten Aspekt unter Bezugnahme auf zumindest einen des ersten bis dreizehnten Aspekts können die zumindest zwei piezoelektrischen Aktuatoren 106_1:106_n in einer Ruheposition in einer Ebene angeordnet sein, und die zumindest zwei piezoelektrischen Aktuatoren 106_1:106_n können ausgebildet sein, um eine Hubbewegung der Hubstruktur 104 derart hervorzurufen, dass eine Richtung 114 der Hubbewegung senkrecht zu der Ebene der piezoelektrischen Aktuatoren 106_1:106_n verläuft.

Gemäß einem fünfzehnten Aspekt unter Bezugnahme auf zumindest einen des ersten bis vierzehnten Aspekts können die Mehrzahl von voneinander beabstandeten Verbindungselementen 108_1:108_m Federelemente aufweisen.

Gemäß einem sechzehnten Aspekt unter Bezugnahme auf den fünfzehnten Aspekt kann jedes der Federelemente 108_1:108_m zumindest ein Biegefederelement 108B, zumindest ein Torsionsfederelement 108T oder eine Kombination aus zumindest einem Biegefederelement 108B und zumindest einem Torsionsfederelement 108T umfassen.

Gemäß einem siebzehnten Aspekt unter Bezugnahme auf zumindest einen des ersten bis sechzehnten Aspekts kann die Membran 102 parallel zu einer ersten Oberfläche 122 und einer zweiten Oberfläche 124 des MEMS 100 verlaufen, wobei die Membran 102 ausgebildet sein kann, um bei einer bestimmungsgemäßen Verwendung des MEMS 100 die erste Oberfläche 122 und die zweite Oberfläche 124 des MEMS 100 fluidisch oder gasförmig voneinander zu trennen.

Gemäß einem achtzehnten Aspekt unter Bezugnahme auf zumindest einen des ersten bis siebzehnten Aspekts kann die Membran 102 einen starren Bereich 150 und einen flexiblen Bereich 152 aufweisen, wobei die Hubstruktur 104 mit dem starren Bereich 150 der Membran 102 gekoppelt sein kann.

Gemäß einem neunzehnten Aspekt unter Bezugnahme auf den achtzehnten Aspekt kann der starre Bereich 150 der Membran 102 durch eine erweiterte Hubstruktur 104 gebildet werden.

Gemäß einem zwanzigsten Aspekt unter Bezugnahme auf zumindest einen des ersten bis neunzehnten Aspekts kann das MEMS 100 zumindest einen piezoelektrischen Positionssensor 140 aufweisen, der ausgebildet sein kann, um ein von der Auslenkung der Membran 102 abhängiges Sensorsignal bereitzustellen.

Gemäß einem einundzwanzigsten Aspekt unter Bezugnahme auf den zwanzigsten Aspekt kann das MEMS 100 zumindest vier piezoelektrische Aktuatoren 106_1:106_n aufweisen, wobei zwei der zumindest vier piezoelektrischen Aktuatoren 106_1:106_n als piezoelektrische Positionssensoren ausgebildet sein können, wobei die zumindest vier piezoelektrische Aktuatoren 106_1:106_n derart symmetrisch zu einem Schwerpunkt angeordnet sein können, dass die zwei als piezoelektrische Positionssensoren ausgebildeten piezoelektrischen Aktuatoren 106_1:106_n und die übrigen piezoelektrischen Aktuatoren 106_1:106_n jeweils symmetrisch zu dem Schwerpunkt der Hubstruktur 104 angeordnet sind.

Gemäß einem zweiundzwanzigsten Aspekt unter Bezugnahme auf den zwanzigsten Aspekt kann das MEMS 100 zumindest einen Stapel von zwei voneinander isolierten piezoelektrischen Schichten aufweisen, wobei eine der zwei Schichten 140 den zumindest einen piezoelektrischen Sensor bilden kann, und wobei eine andere der zwei Schichten 142 einen der zumindest zwei piezoelektrischen Aktuatoren 106_1:106_n bilden kann.

Gemäß einem dreiundzwanzigsten Aspekt unter Bezugnahme auf den zweiundzwanzigsten Aspekt können die zwei voneinander isolierten piezoelektrischen Schichten unterschiedliche Materialien aufweisen.

Gemäß einem vierundzwanzigsten Aspekt unter Bezugnahme auf den zwanzigsten Aspekt können der piezoelektrische Positionssensor 140 und ein piezoelektrischer Aktuator der zumindest zwei piezoelektrischen Aktuatoren 106_1:106_n durch eine gemeinsame piezoelektrische Schicht gebildet sein.

Gemäß einem fünfundzwanzigsten Aspekt unter Bezugnahme auf zumindest einen des ersten bis vierundzwanzigsten Aspekts kann das MEMS 100 zumindest einen piezoresistiven oder einen kapazitiven Positionssensor aufweisen, der ausgebildet sein kann, um ein von der Auslenkung der Membran 102 abhängiges Sensorsignal bereitzustellen.

Gemäß einem sechsundzwanzigsten Aspekt unter Bezugnahme auf zumindest einen des ersten bis fünfundzwanzigsten Aspekts kann die Hubstruktur 104 Silizium aufweisen.

Gemäß einem siebenundzwanzigsten Aspekt unter Bezugnahme auf zumindest einen des ersten bis sechsundzwanzigsten Aspekts kann die Hubstruktur 104 zumindest drei Abschnitte 104a;104b;104c aufweisen, die angeordnet sind, um eine H-förmige Hubstruktur 104 zu bilden, so dass die Hubstruktur 104 in der Schnittebene, die senkrecht zu der Richtung 114 der Hubbewegung der Hubstruktur 104 verläuft, H-förmig ist.

Gemäß einem achtundzwanzigsten Aspekt unter Bezugnahme auf den siebenundzwanzigsten Aspekt kann ein erster piezoelektrischer Aktuator 106_1 der zumindest zwei piezoelektrischen Aktuatoren 106_1:106_n außerhalb der H-förmigen Hubstruktur 104 entlang eines ersten Abschnitts 104a der drei Abschnitte 104a;104b;104c der Hubstruktur 104 angeordnet sein, und ein zweiter piezoelektrischer Aktuator 106_2 der zumindest zwei piezoelektrischen Aktuatoren 106_1:106_n kann außerhalb der H-förmigen Hubstruktur 104 entlang eines zweiten Abschnitts 104b der drei Abschnitte 104a;104b;104c der Hubstruktur 104 angeordnet sein, wobei der erste Abschnitt 104a und der zweite Abschnitt 104b der Hubstruktur 104 parallel zueinander verlaufen.

Gemäß einem neunundzwanzigsten Aspekt unter Bezugnahme auf den achtundzwanzigsten Aspekt kann ein dritter piezoelektrischer Aktuator 106_3 der zumindest zwei piezoelektrischen Aktuatoren 106_1:106_n zumindest teilweise innerhalb der H-förmigen Hubstruktur 104 entlang einer ersten Seite eines dritten Abschnitts 104c der drei Abschnitte 104a;104b;104c der Hubstruktur 104 angeordnet sein, wobei ein vierter piezoelektrischer Aktuator 106_4 der zumindest zwei piezoelektrischen Aktuatoren 106_1:106_n zumindest teilweise innerhalb der H-förmigen Hubstruktur 104 entlang einer der ersten Seite gegenüberliegenden zweiten Seite des dritten Abschnitts 104c der Hubstruktur 104 angeordnet sein kann, wobei der dritte Abschnitt 104c senkrecht zu dem ersten Abschnitt 104a und dem zweiten Abschnitt 104b verläuft.

Gemäß einem dreißigsten Aspekt unter Bezugnahme auf den achtundzwanzigsten oder neunundzwanzigsten Aspekt kann sich der erste piezoelektrische Aktuator 106_1 zumindest über den gesamten ersten Abschnitt 104a der Hubstruktur 104 erstrecken und über zumindest zwei der voneinander beabstandeten Verbindungselemente 108_1:108_m mit zumindest zwei der voneinander beabstandeten Kontaktpunkte 110_1:110_m des ersten Abschnitts 104a der Hubstruktur 104 verbunden sein, wobei sich der zweite piezoelektrische Aktuator 106_2 zumindest über den gesamten zweiten Abschnitt 104b der Hubstruktur 104 erstrecken kann und über zumindest zwei der voneinander beabstandeten Verbindungselemente 108_1:108_m mit zumindest zwei der voneinander beabstandeten Kontaktpunkte 110_1:110_m des zweiten Abschnitts 104b der Hubstruktur 104 verbunden sein kann.

Gemäß einem einunddreißigsten Aspekt unter Bezugnahme auf den achtundzwanzigsten oder neunundzwanzigsten Aspekt können der erste piezoelektrische Aktuator 106_1 und ein fünfter piezoelektrischer Aktuator 106_5 der zumindest zwei piezoelektrischen Aktuatoren 106_1:106_n außerhalb der Hubstruktur 104 entlang des ersten Abschnitts 104a der Hubstruktur 104 angeordnet sein, wobei der zweite piezoelektrische Aktuator 106_2 und ein sechster piezoelektrischer Aktuator 106_6 der zumindest zwei piezoelektrischen Aktuatoren 106_1:106_n außerhalb der Hubstruktur 104 entlang des zweiten Abschnitts 104b der Hubstruktur 104 angeordnet sein können; wobei der erste piezoelektrische Aktuator 106_1 und der fünfte piezoelektrische Aktuator 106_5 jeweils über zumindest eines der voneinander beabstandeten Verbindungselemente 108_1:108_m mit zumindest einem der voneinander beabstandeten Kontaktpunkte 110_1:110_m des ersten Abschnitts 104a der Hubstruktur 104 verbunden sein können, wobei der zweite piezoelektrische Aktuator 106_2 und der sechste piezoelektrische Aktuator 106_6 jeweils über zumindest eines der voneinander beabstandeten Verbindungselemente 108_1:108_m mit zumindest einem der voneinander beabstandeten Kontaktpunkte 110_1:110_m des zweiten Abschnitts 104b der Hubstruktur 104 verbunden sein können.

Gemäß einem zweiunddreißigsten Aspekt unter Bezugnahme auf den einunddreißigsten Aspekt kann der erste Abschnitt 104a in einen ersten Teilabschnitt 104a_1 und einen zweiten Teilabschnitt 104a_2 unterteilt sein, wobei der erste piezoelektrische Aktuator 106_1 entlang des ersten Teilabschnitts 104a_1 des ersten Abschnitts 104a angeordnet sein kann und mit dem ersten Teilabschnitt 104a_1 des ersten Abschnitts 104a über das jeweilige Verbindungselement verbunden sein kann, wobei der fünfte piezoelektrische Aktuator 106_5 entlang des zweiten Teilabschnitts 104a_2 des ersten Abschnitts 104a angeordnet sein kann und mit dem zweiten Teilabschnitt 104a_2 des ersten Abschnitts 104a über das jeweilige Verbindungselement verbunden sein kann; und
wobei der zweite Abschnitt 104b in einen ersten Teilabschnitt 104b_1 und einen zweiten Teilabschnitt 104b_2 unterteilt sein kann, wobei der zweite piezoelektrische Aktuator 106_2 entlang des ersten Teilabschnitts 104b_1 des zweiten Abschnitts 104b angeordnet sein kann und mit dem ersten Teilabschnitt 104b_1 des zweiten Abschnitts 104b über das jeweilige Verbindungselement verbunden sein kann, wobei der sechste piezoelektrische Aktuator 106_6 entlang des zweiten Teilabschnitts 104b_2 des zweiten Abschnitts 104b angeordnet sein kann und mit dem zweiten Teilabschnitt 104b_2 des zweiten Abschnitts 104b über das jeweilige Verbindungselement verbunden sein kann.

Gemäß einem dreiunddreißigsten Aspekt unter Bezugnahme auf den einunddreißigsten oder zweiunddreißigsten Aspekt können der dritte piezoelektrische Aktuator 106_3 und ein siebter piezoelektrischer Aktuator 106_7 der zumindest zwei piezoelektrischen Aktuatoren 106_1:106_n zumindest teilweise innerhalb der Hubstruktur 104 entlang der ersten Seite des dritten Abschnitts 104c der Hubstruktur 104 angeordnet sein, wobei der vierte piezoelektrische Aktuator 106_4 und ein achter piezoelektrische Aktuator 106_8 der zumindest zwei piezoelektrischen Aktuatoren 106_1:106_n zumindest teilweise innerhalb der Hubstruktur 104 entlang der zweiten Seite des dritten Abschnitts 104c der Hubstruktur 104 angeordnet sein können.

Gemäß einem vierunddreißigsten Aspekt unter Bezugnahme auf den dreiunddreißigsten Aspekt kann der dritte Abschnitt 104c in einen ersten Teilabschnitt 104c_1 und einen zweiten Teilabschnitt 104c_2 unterteilt sein, wobei der dritte piezoelektrische Aktuator 106_3 entlang einer ersten Seite des ersten Teilabschnitts 104c_1 des dritten Abschnitts 104c angeordnet sein kann, wobei der vierte piezoelektrische Aktuator 106_4 entlang einer der ersten Seite gegenüberliegenden zweiten Seite des ersten Teilabschnitts 104c_1 des dritten Abschnitts 104c angeordnet sein kann, wobei der siebte piezoelektrische Aktuator 106_7 entlang einer ersten Seite des zweiten Teilabschnitts 104c_2 des dritten Abschnitts 104c angeordnet sein kann, wobei der achte piezoelektrische Aktuator 106_8 entlang einer der ersten Seite gegenüberliegenden zweiten Seite des zweiten Teilabschnitts 104c_2 des dritten Abschnitts 104c angeordnet sein kann.

Gemäß einem fünfunddreißigsten Aspekt unter Bezugnahme auf zumindest einen des ersten bis vierunddreißigsten Aspekts kann wobei die Hubstruktur 104 eine Mehrzahl von Hubkörpern aufweisen.

Gemäß einem sechsunddreißigsten Aspekt unter Bezugnahme auf den fünfunddreißigsten Aspekt können zumindest zwei Hubkörper der Mehrzahl von Hubkörpern über einen erweiterten Hubkörper miteinander verbunden sein.

Gemäß einem siebenunddreißigsten Aspekt unter Bezugnahme auf zumindest einen des ersten bis sechsunddreißigsten Aspekts können die Mehrzahl von voneinander beabstandeten Verbindungselementen 108_1:108_m nicht über das Zentrum der Vertiefung verlaufen.

Gemäß einem achtunddreißigsten Aspekt kann ein System 200 folgende Merkmale aufweisen: ein MEMS 100 gemäß zumindest einem des ersten bis siebenunddreißigsten Aspekts; und eine Ansteuereinrichtung 202, die ausgebildet sein kann, um die zumindest zwei piezoelektrischen Aktuatoren 106_1:106_n des MEMS 100 des MEMS 100 anzusteuern; wobei das MEMS 100 zumindest einen piezoelektrischen Positionssensor 140 aufweisen kann, der ausgebildet sein kann, um ein von der Auslenkung der Membran 102 abhängiges Sensorsignal 141 bereitzustellen; und wobei die Ansteuereinrichtung 202 ausgebildet sein kann, um die zumindest zwei piezoelektrischen Aktuatoren 106_1:106_n des MEMS 100 basierend auf dem Sensorsignal 141 geregelt anzusteuern.

Gemäß einem neununddreißigsten Aspekt kann eine Verwendung des MEMS 100 gemäß zumindest einem des ersten bis sechsunddreißigsten Aspekts zur Schallerzeugung, zur Ultraschallerzeugung, zur Verdrängung von Flüssigkeiten, zur Verdrängung von Gasen oder zur Erzeugung von Flüssigkeitströpfchen dienen.

Gemäß einem vierzigsten Aspekt kann ein MEMS-Lautsprecher 100 zum Erzeugen von Schallwellen im hörbaren Wellenlängenspektrum eine Membran 102, eine Hubstruktur 104, die mit der Membran 102 gekoppelt ist, und zumindest zwei piezoelektrische Aktuatoren 106_1:106_n, mittels denen zum Auslenken der Membran 102 eine Hubbewegung der Hubstruktur 104 hervorrufbar ist, aufweisen, wobei der MEMS-Lautsprecher 100 dadurch gekennzeichnet sein kann, dass die piezoelektrischen Aktuatoren 106_1:106_n über eine Mehrzahl von voneinander beabstandeten flexiblen Verbindungselementen 108_1:108_m mit einer Mehrzahl von voneinander beabstandeten Kontaktpunkten 110_1:110_m der Hubstruktur 104 verbunden sind.

Gemäß einem einundvierzigsten Aspekt unter Bezugnahme auf den vierzigsten Aspekt kann der MEMS-Lautsprecher dadurch gekennzeichnet sein, dass die Membran 102 an einer Stirnseite der Hubstruktur 104 unmittelbar und/oder die piezoelektrischen Aktuatoren 106_1:106_n an zumindest einer Seitenfläche der Hubstruktur 104, insbesondere an zwei gegenüberliegenden Seitenflächen, über die Verbindungselemente 108_1:108_m mittelbar mit der Hubstruktur 104 verbunden sind.

Gemäß einem zweiundvierzigsten Aspekt unter Bezugnahme auf zumindest einen oder mehrere des vorherigen vierzigsten oder einundvierzigsten Aspekts kann der MEMS-Lautsprecher dadurch gekennzeichnet sein, dass die Mehrzahl von voneinander, insbesondere in Querrichtung des MEMS-Lautsprechers, beabstandeten Verbindungselementen 108_1:108_m mit einer Mehrzahl von voneinander beabstandeten Kontaktpunkten 112_1:112_m der zumindest zwei piezoelektrischen Aktuatoren 106_1:106_n verbunden sind.

Gemäß einem dreiundvierzigsten Aspekt unter Bezugnahme auf zumindest einen oder mehrere des vorherigen vierzigsten bis zweiundvierzigsten Aspekts kann der MEMS-Lautsprecher dadurch gekennzeichnet sein, dass jeder der zumindest zwei piezoelektrischen Aktuatoren 106_1:106_n über zumindest zwei voneinander beabstandete Verbindungselemente 108_1:108_m mit zumindest zwei voneinander beabstandeten Kontaktpunkten 110_1:110_m der Hubstruktur 104 verbunden sind.

Gemäß einem vierundvierzigsten Aspekt unter Bezugnahme auf zumindest einen oder mehrere des vorherigen vierzigsten bis dreiundvierzigsten Aspekts kann der MEMS-Lautsprecher dadurch gekennzeichnet sein, dass die Hubstruktur 104 mit der Membran 102 über eine Mehrzahl von Bereichen gekoppelt ist, die entlang von zumindest zwei zumindest teilweise voneinander beabstandeten Geraden oder Kurven mit der Membran 102 angeordnet sind.

Gemäß einem fünfundvierzigsten Aspekt unter Bezugnahme auf zumindest einen oder mehrere des vorherigen vierzigsten bis vierundvierzigsten Aspekts kann der MEMS-Lautsprecher dadurch gekennzeichnet sein, dass die Hubstruktur 104 mit der Membran 102 über eine Mehrzahl von verteilt angeordneten Bereichen 104a;104b;104c gekoppelt ist.

Gemäß einem sechsundvierzigsten Aspekt unter Bezugnahme auf zumindest einen oder mehrere des vorherigen vierzigsten bis fünfundvierzigsten Aspekts kann der MEMS-Lautsprecher dadurch gekennzeichnet sein, dass die Hubstruktur 104 eine Mehrzahl von miteinander verbundenen Balken 104a; 104b; 104c aufweist, die jeweils zumindest teilweise an einer Stirnseite mit der Membran 102 gekoppelt sind.

Gemäß einem siebenundvierzigsten Aspekt unter Bezugnahme auf zumindest einen oder mehrere des vorherigen vierzigsten bis sechsundvierzigsten Aspekts kann der MEMS-Lautsprecher dadurch gekennzeichnet sein, dass die zumindest zwei piezoelektrischen Aktuatoren 106_1:106_n als Biegebalken ausgebildet sind.

Gemäß einem achtundvierzigsten Aspekt unter Bezugnahme auf zumindest einen oder mehrere des vorherigen vierzigsten bis siebenundvierzigsten Aspekts kann der MEMS-Lautsprecher dadurch gekennzeichnet sein, dass die zumindest zwei piezoelektrischen Aktuatoren 106_1:106_n in einer Ruheposition in einer ersten Ebene angeordnet sind, dass die Membran 102 in einer zu diesen in Hubrichtung beabstandeten zweiten Ebene angeordnet ist und/oder dass sich die Hubstruktur 104 in Hubrichtung von der Membran 102 ausgehend in Richtung der zweiten Ebene, insbesondere bis zu dieser hin oder über diese hinaus, erstreckt.

Gemäß einem neunundvierzigsten Aspekt unter Bezugnahme auf zumindest einen oder mehrere des vorherigen vierzigsten bis achtundvierzigsten Aspekts kann der MEMS-Lautsprecher dadurch gekennzeichnet sein, dass zumindest eines der Verbindungselemente 108_1:108_m ein Federelemente aufweisen und/oder dass das Federelement 108_1:108_m, insbesondere jedes, zumindest ein Biegefederelement 108B und/oder zumindest ein Torsionsfederelement 108T umfasst.

Gemäß einem fünfzigsten Aspekt unter Bezugnahme auf zumindest einen oder mehrere des vorherigen vierzigsten bis neunundvierzigsten Aspekts kann der MEMS-Lautsprecher dadurch gekennzeichnet sein, dass die piezoelektrischen Aktuatoren 106_1:106_n in einer Querschnittsansicht des MEMS-Lautsprechers entlang ihrer Längsachse jeweils ein fest eingespanntes erstes Ende und ein bewegliches zweites Ende aufweisen und/oder dass sich das Biegefederelement 108B in Längsrichtung und/oder das Torsionsfederelement 108T in Querrichtung des piezoelektrischen Aktuators 106_1:106_n erstreckt.

Gemäß einem einundfünfzigsten Aspekt unter Bezugnahme auf zumindest einen oder mehrere des vorherigen vierzigsten bis fünfzigsten Aspekts kann der MEMS-Lautsprecher dadurch gekennzeichnet sein, dass das Biegefederelement 108B und das Torsionsfederelement 108T eines Verbindungselementes 108_1:108_m in einer Draufsicht des MEMS-Lautsprechers zueinander um 90° verdreht sind.

Gemäß einem zweiundfünfzigsten Aspekt unter Bezugnahme auf zumindest einen oder mehrere des vorherigen vierzigsten bis einundfünfzigsten Aspekts kann der MEMS-Lautsprecher dadurch gekennzeichnet sein, dass die Membran 102 einen starren Bereich 150 und einen flexiblen Bereich 152 aufweist, wobei die Hubstruktur 104 mit dem starren Bereich 150 der Membran 102 gekoppelt ist, wobei vorzugsweise der starre Bereich 150 der Membran 102 durch eine erweiterte Hubstruktur 104 gebildet ist.

Gemäß einem dreiundfünfzigsten Aspekt unter Bezugnahme auf zumindest einen oder mehrere des vorherigen vierzigsten bis zweiundfünfzigsten Aspekts kann der MEMS-Lautsprecher dadurch gekennzeichnet sein, dass der MEMS-Lautsprecher 100 zumindest vier symmetrisch zum Schwerpunkt der Hubstruktur 104 angeordnete piezoelektrische Aktuatoren 106_1:106_n aufweist.

Gemäß einem vierundfünfzigsten Aspekt unter Bezugnahme auf zumindest einen oder mehrere des vorherigen vierzigsten bis dreiundfünfzigsten Aspekts kann der MEMS-Lautsprecher dadurch gekennzeichnet sein, dass die Hubstruktur 104 mehrere Hubkörpern aufweist und/oder dass zumindest zwei Hubkörper über einen erweiterten Hubkörper miteinander verbunden sind.

Gemäß einem fünfundfünfzigsten Aspekt kann ein MEMS-Lautsprecher 100 zum Erzeugen von Schallwellen im hörbaren Wellenlängenspektrum eine Membran 102, eine Hubstruktur 104, die mit der Membran 102 gekoppelt ist, und zumindest einen piezoelektrischen Aktuator 106_1:106_n aufweisen, mittels dem zum Auslenken der Membran 102 eine Hubbewegung der Hubstruktur 104 hervorrufbar ist, und der MEMS-Lautsprecher 100 kann dadurch gekennzeichnet sein, dass er zumindest einen Positionssensor 140 aufweist, der ausgebildet ist, um ein von der Auslenkung der Membran 102 abhängiges Sensorsignal bereitzustellen.

Gemäß einem sechsundfünfzigsten Aspekt unter Bezugnahme auf den fünfundfünfzigsten Aspekt kann der MEMS-Lautsprecher dadurch gekennzeichnet sein, dass der Aktuator 106_1:106_n mittels einer dafür vorgesehenen Steuereinrichtung 202 in Abhängigkeit von dem Sensorsignal geregelt betreibbar ist.

Gemäß einem siebenundfünfzigsten Aspekt unter Bezugnahme auf einen oder mehreren des vorherigen fünfundfünfzigsten oder sechsundfünfzigsten Aspekts kann der MEMS-Lautsprecher dadurch gekennzeichnet sein, dass der MEMS-Lautsprecher 100 zumindest einen piezoelektrischen und/oder kapazitiven Positionssensor 140 aufweist.

Gemäß einem achtundfünfzigsten Aspekt unter Bezugnahme auf einen oder mehrere des vorherigen fünfundfünfzigsten bis siebenundfünfzigsten Aspekts kann der MEMS-Lautsprecher dadurch gekennzeichnet sein, dass der Positionssensor 140 in dem Aktuator 106_1:106_n integriert ist.

Gemäß einem neunundfünfzigsten Aspekt unter Bezugnahme auf einen oder mehrere des vorherigen fünfundfünfzigsten bis achtundfünfzigsten Aspekts kann der MEMS-Lautsprecher dadurch gekennzeichnet sein, dass die Sensorelektroden des integrierten Positionssensors 140 als flächige oder interdigitale Elektroden ausgebildet sind und/oder von den Aktuatorelektroden elektrisch isoliert sind.

Gemäß einem sechzigsten Aspekt unter Bezugnahme auf einen oder mehrere des vorherigen fünfundfünfzigsten bis neunundfünfzigsten Aspekts kann der MEMS-Lautsprecher dadurch gekennzeichnet sein, dass der piezoelektrische Positionssensor 140 und der piezoelektrische Aktuator 106_1:106_n durch eine gemeinsame piezoelektrische Schicht ausgebildet sind.

Gemäß einem einundsechzigsten Aspekt unter Bezugnahme auf einen oder mehrere des vorherigen fünfundfünfzigsten bis sechzigsten Aspekts kann der MEMS-Lautsprecher dadurch gekennzeichnet sein, dass die gemeinsamen piezoelektrische Schicht einen den Positionssensor 140 bildenden Sensorbereich und einen, insbesondere von diesem elektrisch isolierten, den Aktuator 106_1:106_n bildenden Aktuatorbereich aufweist, wobei vorzugsweise der Sensorbereich im Vergleich zum Aktuatorbereich eine kleinere Fläche einnimmt.

Gemäß einem zweiundsechzigsten Aspekt unter Bezugnahme auf einen oder mehrere des vorherigen fünfundfünfzigsten bis einundsechzigsten Aspekts kann der MEMS-Lautsprecher dadurch gekennzeichnet sein, dass der piezoelektrische Positionssensor 140 und der piezoelektrische Aktuator 106_1:106_n jeweils durch eine separate piezoelektrische Schicht ausgebildet sind, wobei der Aktuator 106_1:106_n vorzugsweise einen Stapel von zumindest zwei voneinander isolierten piezoelektrischen Schichten aufweist, von denen zumindest ein Teil der einen Schicht den zumindest einen piezoelektrischen Positionssensor 140 und zumindest ein Teil der anderen Schicht 142 den zumindest einen piezoelektrischen Aktuator 106_1:106_n ausbildet.

Gemäß einem dreiundsechzigsten Aspekt unter Bezugnahme auf einen oder mehrere des vorherigen fünfundfünfzigsten bis zweiundsechzigsten Aspekts kann der MEMS-Lautsprecher dadurch gekennzeichnet sein, dass der Stapel in Richtung der Hubachse orientiert ist, so dass die piezoelektrischen Schichten übereinander angeordnet sind, oder dass der Stapel quer zur Hubachse orientiert ist, so dass die piezoelektrischen Schichten nebeneinander angeordnet sind.

Gemäß einem vierundsechzigsten Aspekt unter Bezugnahme auf einen oder mehrere des vorherigen fünfundfünfzigsten bis dreiundsechzigsten Aspekts kann der MEMS-Lautsprecher dadurch gekennzeichnet sein, dass der Positionssensor 140 und der zumindest eine Aktuator 106_1:106_n voneinander separiert sind.

Gemäß einem fünfundsechzigsten Aspekt unter Bezugnahme auf einen oder mehrere des vorherigen fünfundfünfzigsten bis vierundsechzigsten Aspekts kann der MEMS-Lautsprecher dadurch gekennzeichnet sein, dass der MEMS-Lautsprecher 100 mehrere Aktuatoren aufweist 106_1:106_n, von denen zumindest einer als Positionssensor 140 verwendbar ist.

Gemäß einem sechsundsechzigsten Aspekt unter Bezugnahme auf einen oder mehrere des vorherigen fünfundfünfzigsten bis fünfundsechzigsten Aspekts kann der MEMS-Lautsprecher dadurch gekennzeichnet sein, dass mehrere Aktuatoren 106_1:106_n und/oder Positionssensoren 140 paarweise gegenüberliegend angeordnet sind,wobei der MEMS-Lautsprecher 100 vorzugsweise zumindest vier symmetrisch zum Schwerpunkt der Hubstruktur 104 angeordnete piezoelektrische Aktuatoren 106_1:106_n aufweist und/oder dass zwei der zumindest vier piezoelektrischen Aktuatoren 106_1:106_n als piezoelektrische Positionssensoren 140 ausgebildet sind.

Gemäß einem siebenundsechzigsten Aspekt unter Bezugnahme auf einen oder mehrere des vorherigen fünfundfünfzigsten bis sechsundsechzigsten Aspekts kann der MEMS-Lautsprecher dadurch gekennzeichnet sein, dass der zumindest eine Aktuator 106_1:106_n und/oder Positionssensor 140 über zumindest ein, insbesondere flexibles, Verbindungselement 108_1:108_m mit der Hubstruktur 104 verbunden ist.

Gemäß einem achtundsechzigsten Aspekt unter Bezugnahme auf einen oder mehrere des vorherigen fünfundfünfzigsten bis siebenundsechzigsten Aspekts kann der MEMS-Lautsprecher dadurch gekennzeichnet sein, dass die Membran 102 an einer Stirnseite der Hubstruktur 104 unmittelbar und/oder die piezoelektrischen Aktuatoren 106_1:106_n und/oder Positionssensoren 140 an zumindest einer Seitenfläche der Hubstruktur 104, insbesondere an zwei gegenüberliegenden Seitenflächen, über die Verbindungselemente 108_1:108_m mittelbar mit der Hubstruktur 104 verbunden sind.

Gemäß einem neunundsechzigsten Aspekt kann eine Regelungseinheit 200 zum geregelten Betreiben eines MEMS-Lautsprechers mit einem MEMS-Lautsprecher 100 gemäß einem oder mehreren des vorherigen fünfundfünfzigsten bis achtundsechzigsten Aspekts und einer Steuereinrichtung 202, die ausgebildet sein kann, um einen piezoelektrischen Aktuator 106_1:106_n des MEMS-Lautsprechers 100 anzusteuern, dadurch gekennzeichnet sein, dass der MEMS-Lautsprecher 100 zumindest einen piezoelektrischen Positionssensor 140 aufweist, der ausgebildet ist, um der Steuereinrichtung 202 ein von der Auslenkung einer Membran 102 des MEMS-Lautsprechers 100 abhängiges Sensorsignal 141 bereitzustellen, und dass die Ansteuereinrichtung 202 ausgebildet ist, um den zumindest einen piezoelektrischen Aktuator 106_1:106_n des MEMS-Lautsprechers 100 basierend auf dem Sensorsignal 141 geregelt anzusteuern.

Obwohl hierin anhand der Fig. 1 bis 18 im Allgemeinen Ausführungsbeispiele eines MEMS beschrieben wurden, sei darauf hingewiesen, dass diese genauso für einen MEMS-Lautsprecher anwendbar sind.

## Patentansprüche

1. MEMS (100), mit folgenden Merkmalen:
einer Membran (102);
einer Hubstruktur (104), die mit der Membran (102) gekoppelt ist; und
zumindest zwei piezoelektrischen Aktuatoren (106_1:106_n), die über eine Mehrzahl von voneinander beabstandeten Verbindungselementen (108_1:108_m) mit einer Mehrzahl von voneinander beabstandeten Kontaktpunkten (110_1:110_m) der Hubstruktur (104) verbunden sind;
wobei die zumindest zwei piezoelektrischen Aktuatoren (106_1:106_n) ausgebildet sind, um eine Hubbewegung der Hubstruktur (104) hervorzurufen, um die Membran (102) auszulenken; und
wobei jeder der zumindest zwei piezoelektrischen Aktuatoren (106_1:106_n) über zumindest zwei voneinander beabstandete Verbindungselemente (108_1:108_m) mit zumindest zwei voneinander beabstandeten Kontaktpunkten (110_1:110_m) der Hubstruktur (104) verbunden ist.

2. MEMS (100) nach dem vorhergehenden Anspruch, wobei die Mehrzahl von voneinander beabstandeten Verbindungselementen (108_1:108_m) mit einer Mehrzahl von voneinander beabstandeten Kontaktpunkten (112_1:112_m) der zumindest zwei piezoelektrischen Aktuatoren (106_1:106_n) verbunden sind.

3. MEMS (100) nach einem der vorhergehenden Ansprüche, wobei die Hubstruktur (104) senkrecht zu einer Richtung (114) der Hubbewegung eine Fläche aufspannt, die zumindest 30 % einer Fläche der Membran (102) entspricht.

4. MEMS (100) nach einem der vorhergehenden Ansprüche, wobei die Hubstruktur (104) mit der Membran (102) über eine Mehrzahl von verteilt angeordneten Bereichen (104a;104b;104c) gekoppelt ist.

5. MEMS (100) nach einem der vorhergehenden Ansprüche, wobei eine senkrecht zu einer Richtung (114) der Hubbewegung der Hubstruktur (104) projizierte Querschnittsfläche der Hubstruktur (104) kleiner ist als eine Summe von piezoelektrisch aktiven Aktuatorflächen der zumindest zwei piezoelektrischen Aktuatoren (106_1:106_n).

6. MEMS (100) nach einem der vorhergehenden Ansprüche, wobei die Hubstruktur (104) eine Mehrzahl von Hubkörpern aufweist.

7. System (200), mit folgenden Merkmalen:
einem MEMS (100) nach einem der Ansprüche 1 bis 6; und
einer Ansteuereinrichtung (202), die ausgebildet ist, um die zumindest zwei piezoelektrischen Aktuatoren (106_1:106_n) des MEMS (100) anzusteuern;
wobei das MEMS (100) zumindest einen piezoelektrischen Positionssensor (140) aufweist, der ausgebildet ist, um ein von der Auslenkung der Membran (102) abhängiges Sensorsignal (141) bereitzustellen; und
wobei die Ansteuereinrichtung (202) ausgebildet ist, um die zumindest zwei piezoelektrischen Aktuatoren (106_1:106_n) des MEMS (100) basierend auf dem Sensorsignal (141) geregelt anzusteuern.

8. Verwendung des MEMS (100) nach einem der Ansprüche 1 bis 6 zur Schallerzeugung, zur Ultraschallerzeugung, zur Verdrängung von Flüssigkeiten, zur Verdrängung von Gasen oder zur Erzeugung von Flüssigkeitströpfchen.

9. MEMS (100) nach Anspruch 1, wobei das MEMS (100) ein MEMS-Lautsprecher (100) zum Erzeugen von Schallwellen im hörbaren Wellenlängenspektrum ist.

10. MEMS nach Anspruch 9, wobei die Membran (102) an einer Stirnseite der Hubstruktur (104) unmittelbar und/oder die piezoelektrischen Aktuatoren (106_1:106_n) an zumindest einer Seitenfläche der Hubstruktur (104), insbesondere an zwei gegenüberliegenden Seitenflächen, über die Verbindungselemente (108_1:108_m) mittelbar mit der Hubstruktur (104) verbunden sind.

11. MEMS nach einem der vorherigen Ansprüche 9 oder 10, wobei die Mehrzahl von voneinander, insbesondere lotrecht zur Hubachse des MEMS-Lautsprechers, beabstandeten Verbindungselementen (108_1:108_m) mit einer Mehrzahl von voneinander beabstandeten Kontaktpunkten (112_1:112_m) der zumindest zwei piezoelektrischen Aktuatoren (106_1:106_n) verbunden sind.

12. MEMS nach einem der vorherigen Ansprüche 9 bis 11, wobei die Hubstruktur (104) mit der Membran (102) über eine Mehrzahl von Bereichen gekoppelt ist, die entlang von zumindest zwei zumindest teilweise voneinander beabstandeten Geraden oder Kurven angeordnet sind.

13. MEMS (100) nach Anspruch 1, wobei das MEMS (100) ein MEMS-Lautsprecher (100) zum Erzeugen von Schallwellen im hörbaren Wellenlängenspektrum ist wobei der MEMS-Lautsprecher (100) zumindest einen Positionssensor (140) aufweist, der ausgebildet ist, um ein von der Auslenkung der Membran (102) abhängiges Sensorsignal bereitzustellen.

14. MEMS nach dem vorherigen Anspruch 13, wobei der Aktuator (106_1:106_n) mittels einer dafür vorgesehenen Steuereinrichtung (202) in Abhängigkeit von dem Sensorsignal geregelt betreibbar ist;
oder dass der Positionssensor (140) in dem Aktuator (106_1:106_n) integriert ist; oder dass die Sensorelektroden des integrierten Positionssensors (140) als flächige oder interdigitale Elektroden ausgebildet sind und/oder von den Aktuatorelektroden elektrisch isoliert sind;
oder dass der piezoelektrische Positionssensor (140) und der piezoelektrische Aktuator (106_1:106_n) durch eine gemeinsame piezoelektrische Schicht ausgebildet sind.

15. Regelungseinheit (200) zum geregelten Betreiben eines MEMS-Lautsprechers, die Regelungseinheit umfassend
einen MEMS-Lautsprecher (100) nach einem oder mehreren der vorherigen Ansprüche 10 bis 14 und
feine Steuereinrichtung (202), die ausgebildet ist, um einen piezoelektrischen Aktuator (106_1:106_n) des MEMS-Lautsprechers (100) anzusteuern,
**dadurch gekennzeichnet,**
**dass** der MEMS-Lautsprecher (100) zumindest einen piezoelektrischen Positionssensor (140) aufweist, der ausgebildet ist, um der Steuereinrichtung (202) ein von der Auslenkung einer Membran (102) des MEMS-Lautsprechers (100) abhängiges Sensorsignal (141) bereitzustellen, und
**dass** die Ansteuereinrichtung (202) ausgebildet ist, um den zumindest einen piezoelektrischen Aktuator (106_1:106_n) des MEMS-Lautsprechers (100) basierend auf dem Sensorsignal (141) geregelt anzusteuern.

## Claims

1. MEMS (100) comprising:
a diaphragm (102);
a stroke structure (104) coupled to the diaphragm (102); and
at least two piezoelectric actuators (106_1:106_n) coupled to a plurality of mutually spaced-apart contact points (110_1:110_m) of the stroke structure (104) via a plurality of mutually spaced-apart connecting elements (108_1:108_m);
the at least two piezoelectric actuators (106_1:106_n) being configured to cause a stroke movement of the stroke structure (104) so as to deflect the diaphragm (102); and
wherein each of the at least two piezoelectric actuators (106_1:106_n) is connected to at least two mutually spaced-apart contact points (110_1:110_m) of the stroke structure (104) via at least two mutually spaced-apart connecting elements (108_1:108_m).

2. MEMS (100) as claimed in the previous claim, wherein the plurality of mutually spaced-apart connecting elements (108_1:108_m) are connected to a plurality of mutually spaced-apart contact points (112_1:112_m) of the at least two piezoelectric actuators (106_1:106_n).

3. MEMS (100) as claimed in any of the previous claims, wherein the stroke structure (104) spans, perpendicularly to a direction (114) of the stroke movement, an area which corresponds to at least 30 % of an area of the diaphragm (102).

4. MEMS (100) as claimed in any of the previous claims, wherein the stroke structure (104) is coupled to the diaphragm (102) via a plurality of regions (104a;104b;104c) arranged in a distributed manner.

5. MEMS (100) as claimed in any of the previous claims, wherein a cross-sectional area of the stroke structure (104) that is perpendicular to a direction (114) of the stroke movement of the stroke structure (104) is smaller than a sum of piezoelectrically active actuator areas of the at least two piezoelectric actuators (106_1:106_n).

6. MEMS (100) as claimed in any of the previous claims, wherein the stroke structure (104) comprises a plurality of stroke bodies.

7. System (200) comprising:
a MEMS (100) as claimed in any of claims 1 to 6; and
a control means (202) configured to control the at least two piezoelectric actuators (106_1:106_n) of the MEMS (100);
the MEMS (100) comprising at least one piezoelectric position sensor (140) configured to provide a sensor signal (141) dependent on the deflection of the diaphragm (102); and
the control means (202) being configured to control the at least two piezoelectric actuators (106_1:106_n) of the MEMS (100) in a regulated manner on the basis of the sensor signal (141).

8. Utilization of the MEMS (100) as claimed in any of claims 1 to 6 for sound generation, for ultrasound generation, for displacing liquids, for displacing gasses, or for generating droplets of liquid.

9. MEMS (100) according to claim 1, wherein the MEMS (100) is an MEMS loudspeaker (100) for generating sound waves within the audible wavelength spectrum.

10. MEMS as claimed in claim 9, wherein the diaphragm (102) is connected to the stroke structure (104) at a front end of the stroke structure (104) in a direct manner, and/or the piezoelectric actuators (106_1:106_n) are connected to the stroke structure (104) on at least one side face of the stroke structure (104), in particular on two opposite side faces, in an indirect manner via the connecting elements (108_1:108_m).

11. MEMS as claimed in any of the previous claims 9 or 10, wherein the plurality of connecting elements (108_1:108_m) that are mutually spaced-apart in particular perpendicular to the stroke axis of the MEMS loudspeaker are connected to a plurality of mutually spaced-apart contact points (112_1:112_m) of the at least two piezoelectric actuators (106_1:106_n).

12. MEMS as claimed in any of the previous claims 9 to 11, wherein the stroke structure (104) is coupled to the diaphragm (102) via a plurality of regions arranged along at least two at least partly mutually spaced-apart straight lines or curves.

13. MEMS (100) as claimed in claim 1, wherein the MEMS (100) is an MEMS loudspeaker (100) for generating sound waves within the audible wavelength spectrum, wherein the MEMS loudspeaker (100) comprises at least one position sensor (140) configured to provide a sensor signal dependent on the deflection of the diaphragm (102).

14. MEMS as claimed in previous claim 13, wherein the actuator (106_1:106_n) is operable in a regulated manner as a function of the sensor signal by means of a control means (202) provided for this purpose;
or that the position sensor (140) is integrated in the actuator (106_1:106_n);
or that the sensor electrodes of the integrated position sensor (140) are configured as two-dimensional or interdigital electrodes and/or are electrically insulated from the actuator electrodes;
or that the piezoelectric position sensor (140) and the piezoelectric actuator (106_1;106_n) are configured by a common piezoelectric layer.

15. Regulating unit (200) for operating an MEMS loudspeaker in a regulated manner, the regulating unit comprising an MEMS loudspeaker (100) as claimed in any of the previous claims 10 to 14, and
a control means (202) configured to control a piezoelectric actuator (106_1:106_n) of the MEMS loudspeaker (100),
**characterized in that**
the MEMS loudspeaker (100) comprises at least one piezoelectric position sensor (140) configured to provide the control means (202) with a sensor signal (141) dependent on the deflection of a diaphragm (102) of the MEMS loudspeaker (100), and
the control means (202) is configured to control the at least one piezoelectric actuator (106_1:106_n) of the MEMS loudspeaker (100) in a regulated manner on the basis of the sensor signal (141).

## Revendications

1. MEMS (100), aux caractéristiques suivantes:
une membrane (102);
une structure de translation (104) qui est couplée à la membrane (102); et
au moins deux actionneurs piézoélectriques (106_1:106_n) qui sont connectés par une pluralité d'éléments de connexion distants l'un de l'autre (108_1:108_m) à une pluralité de points de contact distants l'un de l'autre (110_1:110_m) de la structure de translation (104);
dans lequel les au moins deux actionneurs piézoélectriques (106_1:106_n) sont conçus pour provoquer un mouvement de translation de la structure de translation (104) pour déplacer la membrane (102); et
dans lequel chacun des au moins deux actionneurs piézoélectriques (106_1:106_n) est connecté par l'intermédiaire d'au moins deux éléments de connexion distants l'un de l'autre (108_1:108_m) à au moins deux points de contact distants l'un de l'autre (110_1:110_m) de la structure de translation (104).

2. MEMS (100) selon la revendication précédente, dans lequel la pluralité d'éléments de connexion distants l'un de l'autre (108_1:108_m) sont connectés à une pluralité de points de contact distants l'un de l'autre (112_1:112_m) des au moins deux actionneurs piézoélectriques (106_1:106_n).

3. MEMS (100) selon l'une des revendications précédentes, dans lequel la structure de translation (104) couvre, perpendiculairement à une direction (114) du mouvement de translation, une surface qui correspond à au moins 30% d'une surface de la membrane (102).

4. MEMS (100) selon l'une des revendications précédentes, dans lequel la structure de translation (104) est couplée à la membrane (102) par l'intermédiaire d'une pluralité de zones (104a; 104b; 104c) disposées de manière répartie.

5. MEMS (100) selon l'une des revendications précédentes, dans lequel une surface de section de la structure de translation (104) projetée perpendiculairement à une direction (114) du mouvement de translation de la structure de translation (104) est plus petite qu'une somme de surfaces d'actionneur actives de manière piézoélectrique des au moins deux actionneurs piézoélectriques (106_1:106_n).

6. MEMS (100) selon l'une quelconque des revendications précédentes, dans lequel la structure de translation (104) présente une pluralité de corps de translation.

7. System (200), aux caractéristiques suivantes:
un MEMS (100) selon l'une des revendications 1 à 6; et
un dispositif d'activation (202) qui est conçu pour activer les au moins deux actionneurs piézoélectriques (106_1:106_n) du MEMS (100);
dans lequel le MEMS (100) présente au moins un capteur de position piézoélectrique (140) qui est conçu pour fournir un signal de capteur (141) dépendant du déplacement de la membrane (102); et
dans lequel le dispositif d'activation (202) est conçu pour activer les au moins deux actionneurs piézoélectriques (106_1:106_n) du MEMS (100) de manière régulée sur base du signal de capteur (141).

8. Utilisation du MEMS (100) selon l'une des revendications 1 à 6 pour générer des sons, pour générer des ultrasons, pour refouler des liquides, pour refouler des gaz ou pour générer des gouttelettes de liquide.

9. MEMS (100) selon la revendication 1, dans lequel le MEMS (100) est un haut-parleur MEMS (100) destiné à générer des ondes sonores dans le spectre de longueurs d'onde audibles.

10. MEMS selon la revendication 9, dans lequel la membrane (102) est connectée directement, à une face frontale de la structure de translation (104), et/ou les actionneurs piézoélectriques (106_1:106_n) sont connectés indirectement, à au moins une face latérale de la structure de translation (104), en particulier à deux faces latérales opposées, par l'intermédiaire des éléments de liaison (108_1:108_m) à la structure de translation (104).

11. MEMS selon l'une des revendications précédentes 9 ou 10, dans lequel la pluralité d'éléments de connexion (108_1: 108_m) distants l'un de l'autre, en particulier perpendiculairement à l'axe de translation du haut-parleur MEMS, sont connectés à une pluralité de points de contact distants l'un de l'autre (112_1:112_m) des au moins deux actionneurs piézoélectriques (106_1:106_n).

12. MEMS selon l'une des revendications précédentes 9 à 11, dans lequel la structure de translation (104) est couplée à la membrane (102) par l'intermédiaire d'une pluralité de zones qui sont disposées le long d'au moins deux droites ou courbes au moins partiellement distantes l'une de l'autre.

13. MEMS (100) selon la revendication 1, dans lequel le MEMS (100) est un haut-parleur MEMS (100) destiné à générer des ondes sonores dans le spectre de longueurs d'onde audibles, dans lequel le haut-parleur MEMS (100) présente au moins un capteur de position (140) qui est conçu pour fournir un signal de capteur dépendant du déplacement de la membrane (102).

14. MEMS selon la revendication précédente 13, dans lequel l'actionneur (106_1:106_n) peut être utilisé de manière régulée à l'aide d'un dispositif de commande prévu à cet effet (202) en fonction du signal de capteur;
ou le capteur de position (140) est intégré dans l'actionneur (106_1:106_n);
ou les électrodes de capteur du capteur de position intégré (140) sont réalisées comme électrodes plates ou interdigitées et/ou sont électriquement isolées des électrodes d'actionneur;
ou le capteur de position piézoélectrique (140) et l'actionneur piézoélectrique (106_1:106_n) sont réalisés par une couche piézoélectrique commune.

15. Unité de régulation (200) pour le fonctionnement régulé d'un haut-parleur MEMS, l'unité de régulation comprenant
un haut-parleur MEMS (100) selon une ou plusieurs des revendications précédentes 10 à 14, et
un dispositif de commande (202) qui est conçu pour actionner un actionneur piézoélectrique (106_1:106_n) du haut-parleur MEMS (100),
**caractérisé par le fait**
**que** le haut-parleur MEMS (100) présente au moins un capteur de position piézoélectrique (140) qui est conçu pour fournir au dispositif de commande (202) un signal de capteur (141) dépendant du déplacement d'une membrane (102) du haut-parleur MEMS (100), et
**que** le dispositif d'activation (202) est conçu pour actionner l'au moins un actionneur piézoélectrique (106_1:106_n) du haut-parleur MEMS (100) de manière régulée sur base du signal de capteur (141).
